# EUROPEAN PATENT APPLICATION

(11) **EP 4 835 578 A1**
(43) Date of publication of application: **04.11.2026**
(21) Application number: 24912980.0
(22) Date of filing: 26.12.2024
(51) Int. Cl.: G03F 7/11, C08F 299/00

(54) **RESIST UNDERLAYER FILM-FORMING COMPOSITION**

(30) Priority: 27.12.2023 JP 2023221211
(71) Applicant: Nissan Chemical Corporation, Tokyo 103-6119 (JP)
(72) Inventor: KATO, Yuki, Toyama-shi, Toyama 939-2792 (JP); IGATA, Kosuke, Toyama-shi, Toyama 939-2792 (JP)
(74) Representative: Hoffmann Eitle
(86) International application number: PCT/JP2024/046090
(87) International publication number: WO 2025/143094

(57) **Abstract**

A resist underlayer film-forming composition, containing: a polymer (A) having a partial structure represented by the following formula (A); a polymer (B) having a polymerizable multiple bond; and a solvent (C): 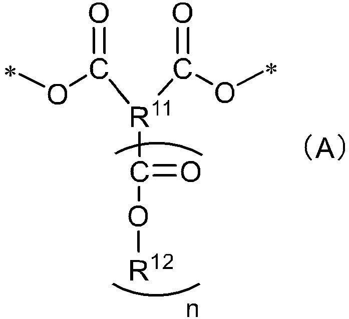 (In formula (A), R¹¹ represents an (n+2)-valent group having at least one of an aromatic hydrocarbon ring and an aliphatic hydrocarbon ring. R¹² represents a hydrogen atom or an optionally substituted alkyl group having 1 to 13 carbon atoms, n represents 1 or 2, and when n is 2, the two R¹² may be the same or different, and * represents a bonding site.)

## Description

### Technical Field

The present invention relates to a resist underlayer film-forming composition, a resist underlayer film, a laminate, a semiconductor element producing method, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, the degree of integration of a semiconductor device has been increased, and as an active ray to be used, EUV light (wavelength: 13.5 nm) or an electron beam (EB) has been studied to be put into practical use for the most advanced microfabrication, in addition to an i-line (wavelength: 365 nm), a KrF excimer laser (wavelength: 248 nm), and an ArF excimer laser (wavelength: 193 nm) which have conventionally been used. At the same time, defects in the formation of the resist pattern due to an influence of the semiconductor substrate and the like are a big problem. Therefore, in order to solve this problem, a method of providing a resist underlayer film between a resist and a semiconductor substrate has been widely studied.

As a resist underlayer film-forming composition, a resist underlayer film-forming composition containing a reaction product of a compound (A) represented by formula (1) (in formula (1), A represents an organic group having an aliphatic ring, an aromatic ring or a heterocycle) dissolved in a solvent, a compound (B) having two functional groups reactive with an epoxy group, and a compound (C) having one functional group reactive with an epoxy group has been proposed (see Patent Literature 1).

### Citation List

### Patent Literature

Patent Literature 1: WO 2022/075339 A

### Summary of Invention

### Technical Problem

Examples of the characteristics required for the resist underlayer film include that intermixing with the resist film formed on the upper layer does not occur (it is insoluble in a resist solvent), and that the adhesion of the resist pattern can be improved to form a fine resist pattern.

The present invention has been made in view of the above circumstances, and an object of the present invention is to provide a resist underlayer film-forming composition capable of forming a fine resist pattern, and a resist underlayer film, a laminate, a method for producing a semiconductor element, and a pattern forming method, each of which uses the resist underlayer film-forming composition.

### Solution to Problem

As a result of intensive studies to solve the above problem, the present inventors have found that the above problem can be solved and have completed the present invention having the following gist.

That is, the present invention includes the following aspects.
[1] A resist underlayer film-forming composition, containing: a polymer (A) having a partial structure represented by the following formula (A); a polymer (B) having a polymerizable multiple bond; and a solvent (C): 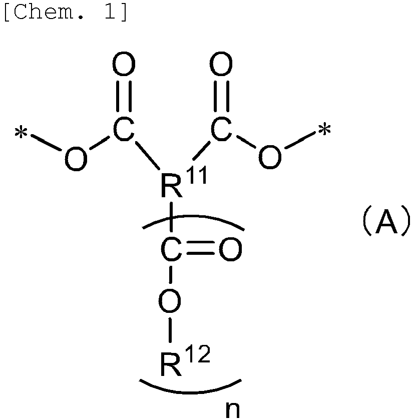 (In formula (A), R¹¹ represents an (n+2)-valent group having at least one of an aromatic hydrocarbon ring and an aliphatic hydrocarbon ring. R¹² represents a hydrogen atom, or an alkyl group having 1 to 13 carbon atoms which may be substituted with at least one group selected from the group consisting of an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms and an alkoxysulfonyl group having 1 to 13 carbon atoms. n represents 1 or 2. When n is 2, the two R¹² may be the same or different, and * represents a bonding site.)
[2] The resist underlayer film-forming composition according to [1], wherein the polymer (B) is a polymer (B-1) having a structural unit represented by the following formula (B-1) or a polymer (B-2) having a structural unit represented by the following formula (B-2): 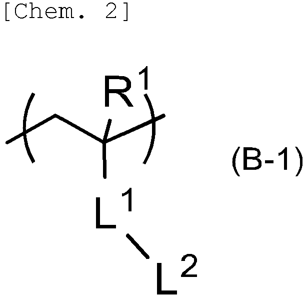 (In formula (B-1), R¹ represents a hydrogen atom or an alkyl group having 1 to 10 carbon atoms. L¹ represents a single bond or a linking group. L² represents a monovalent group having the polymerizable multiple bond.) 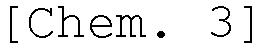 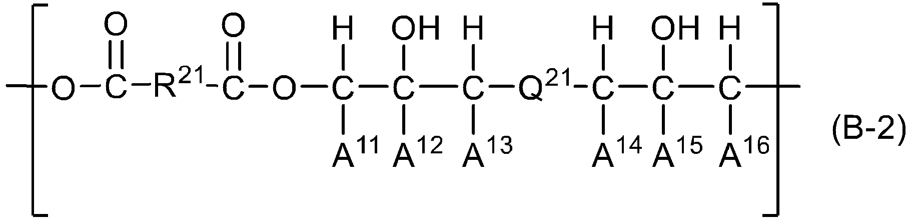 (In formula (B-2), A¹¹, A¹², A¹³, A¹⁴, A¹⁵ and A¹⁶ each independently represent a hydrogen atom, a methyl group or an ethyl group, Q²¹ is a divalent organic group. R²¹ represents a divalent group having the polymerizable multiple bond.)
[3] The resist underlayer film-forming composition according to [2], wherein L¹-L² in the structural unit represented by the formula (B-1) has a structure represented by the following formula (1a), (1b) or (1c): 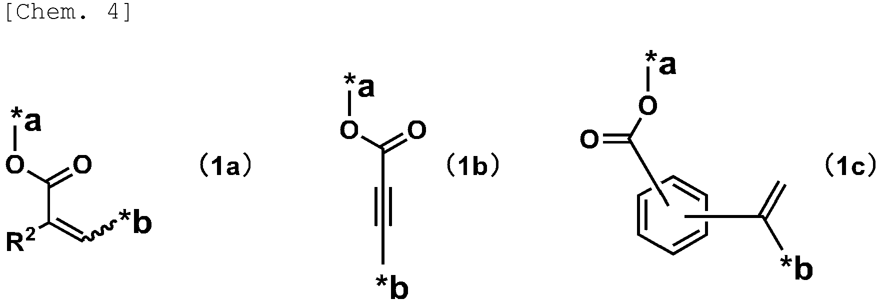 (In formulas (1a) to (1c), R² represents a hydrogen atom or an alkyl group having 1 to 10 carbon atoms. *a and *b represent a bonding site, *a is a main chain side of the polymer (B-1), and *b is a terminal side of a side chain of the polymer (B-1).)
[4] The resist underlayer film-forming composition according to any one of [1] to [3], wherein the polymer (A) has a structural unit represented by the following formula (A-11): 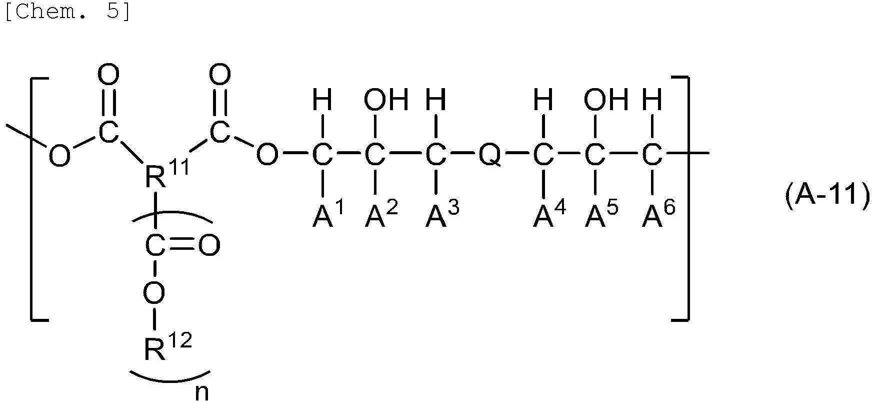 (In formula (A-11), A¹, A², A³, A⁴, A⁵, and A⁶ each independently represent a hydrogen atom, a methyl group or an ethyl group, Q represents a divalent organic group. R¹¹ represents an (n+2)-valent organic group having at least one of an aromatic hydrocarbon ring and an aliphatic hydrocarbon ring. R¹² represents a hydrogen atom, or an alkyl group having 1 to 13 carbon atoms which may be substituted with at least one group selected from the group consisting of an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms and an alkoxysulfonyl group having 1 to 13 carbon atoms. n represents 1 or 2. When n is 2, the two R¹² may be the same or different.)
[5] The resist underlayer film-forming composition according to [4], wherein Q in the formula (A-11) is represented by any one of the following formulas (A-21) and (A-22): 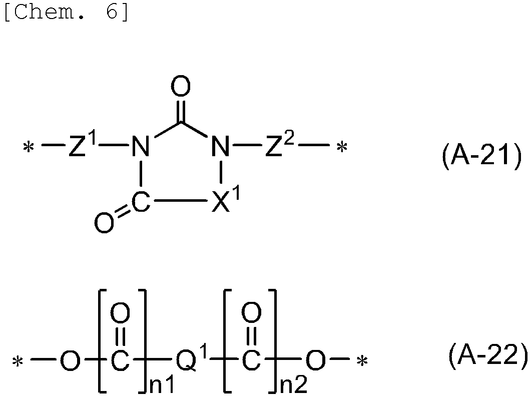
   (In formula (A-21), X¹ represents a divalent group represented by the following formula (A-21-1), the following formula (A-21-2) or the following formula (A-21-3). Z¹ and Z² each independently represent a single bond or a divalent group represented by the following formula (A-21-4). * represents a bonding site.
   In formula (A-22), Q¹ represents a divalent group having an aromatic hydrocarbon ring or an aliphatic hydrocarbon ring. n1 and n2 each independently represent 0 or 1. * represents a bonding site.) 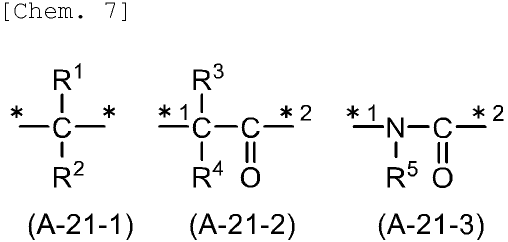
   (In formulas (A-21-1) to (A-21-3), R¹ to R⁵ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group and an alkylthio group having 1 to 6 carbon atoms. R¹ and R² may be bonded to each other to form a ring having 3 to 6 carbon atoms. R³ and R⁴ may be bonded to each other to form a ring having 3 to 6 carbon atoms. * represents a bonding site. *1 represents a bonding site bonded to a carbon atom. *2 represents a bonding site bonded to a nitrogen atom.) 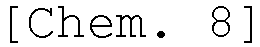 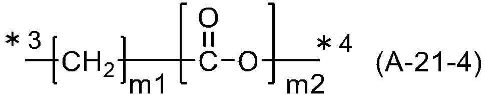
   (In formula (A-21-4), m1 is an integer of 1 to 4, m2 is 0 or 1. *3 represents a bonding site bonded to a nitrogen atom. *4 represents a bonding site bonded to a carbon atom.)
[6] The resist underlayer film-forming composition according to [5], wherein Q¹ in the formula (A-22) is represented by any one of the following formulas (A-22-1) to (A-22-4): 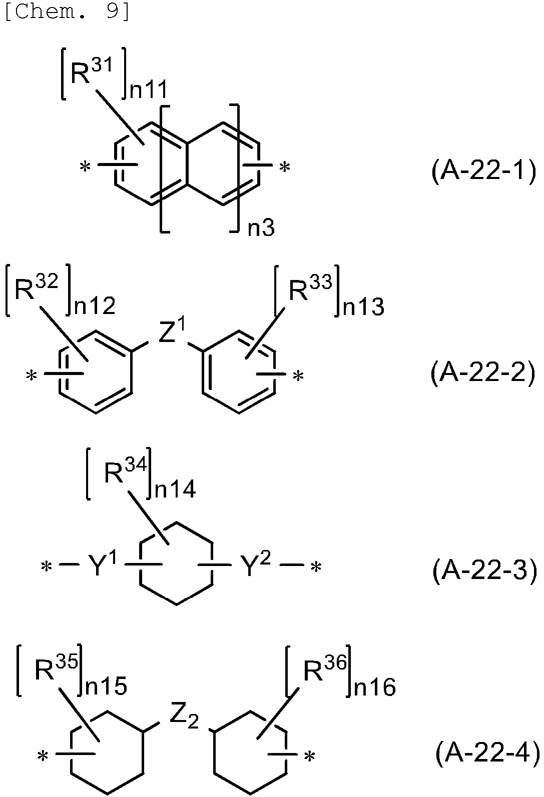
   (In formulas (A-22-1) to (A-22-4), R³¹ to R³⁶ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms or an aralkyl group having 7 to 13 carbon atoms. * represents a bonding site.
   In formula (A-22-1), n3 represents 0 or 1. When n3 is 0, n11 represents an integer of 0 to 4. When n3 is 1, n11 represents an integer of 0 to 6. When R³¹ is 2 or more, the two or more R³¹ may be the same or different.
   In formula (A-22-2), Z¹ represents a single bond, an oxygen atom, a sulfur atom, a carbonyl group, a sulfonyl group or an alkylene group having 1 to 6 carbon atoms. n12 and n13 each independently represent an integer of 0 to 4. When R³² is 2 or more, the two or more R³² may be the same or different. When R³³ is 2 or more, the two or more R³³ may be the same or different.
   In formula (A-22-3), Y¹ and Y² each independently represent a single bond or an alkylene group having 1 to 6 carbon atoms. n14 represents an integer of 0 to 4. When R³⁴ is 2 or more, the two or more R³⁴ may be the same or different.
   In formula (A-22-4), Z² represents a single bond, an oxygen atom, a sulfur atom, a carbonyl group, a sulfonyl group or an alkylene group having 1 to 6 carbon atoms. n15 and n16 each independently represent an integer of 0 to 4. When R³⁵ is 2 or more, the two or more R³⁵ may be the same or different. When R³⁶ is 2 or more, the two or more R³⁶ may be the same or different.
[7] The resist underlayer film-forming composition according to any one of [1] to [6], wherein a mass ratio between the polymer (A) and the polymer (B) (polymer (A) : polymer (B)) is 20 : 80 to 80 : 20.
[8] The resist underlayer film-forming composition according to any one of [1] to [7], wherein the solvent (C) contains at least one kind selected from a group consisting of an alkylene glycol monoalkyl ether and a monocarboxylic acid ester of an alkylene glycol monoalkyl ether.
[9] The resist underlayer film-forming composition according to any one of [1] to [8], further containing a crosslinking agent (D).
[10] The resist underlayer film-forming composition according to [9], wherein the crosslinking agent (D) is at least one kind selected from a group consisting of an aminoplast crosslinking agent and a phenoplast crosslinking agent.
[11] The resist underlayer film-forming composition according to any one of [1] to [10], further containing a curing catalyst (E).
[12] The resist underlayer film-forming composition according to any one of [1] to [11], which is used in EUV lithography.
[13] The resist underlayer film-forming composition according to any one of [1] to [12], wherein the composition is used for forming an underlayer film of a metal-containing resist.
[14] A resist underlayer film, which is a cured product of the resist underlayer film-forming composition according to any one of [1] to [13].
[15] A laminate including:
   a semiconductor substrate; and
   the resist underlayer film according to [14].
[16] A method for producing a semiconductor element, including:
   a step of forming a resist underlayer film on a semiconductor substrate using the resist underlayer film-forming composition described in any one of [1] to [13]; and
   a step of forming a resist film on the resist underlayer film.
[17] A pattern forming method including:
   a step of forming a resist underlayer film on a semiconductor substrate using the resist underlayer film-forming composition according to any one of [1] to [13];
   a step of forming a resist film on the resist underlayer film;
   a step of irradiating the resist film with light or an electron beam, and then developing the resist film to obtain a resist pattern; and
   a step of etching the resist underlayer film using the resist pattern as a mask.

### Advantageous Effects of Invention

According to the present invention, it is possible to provide a resist underlayer film-forming composition capable of forming a fine resist pattern, and a resist underlayer film, a laminate, a method for producing a semiconductor element, and a pattern forming method using the resist underlayer film-forming composition.

### Description of Embodiments

### (Resist Underlayer Film-Forming Composition)

The resist underlayer film-forming composition of the present invention contains a polymer (A), a polymer (B), and a solvent (C).

The resist underlayer film-forming composition may contain a crosslinking agent (D), a curing catalyst (E), and the like.

The polymer (A) has a partial structure represented by the following formula (A).

The polymer (B) has a polymerizable multiple bond.

When the resist underlayer film-forming composition contains the polymer (A) and the polymer (B), a fine resist pattern can be formed on the resist underlayer film formed from the composition for resist underlayer film.

Although the reason is not clear, the present inventors consider that the partial structure represented by formula (A) of the polymer (A) and the polymerizable multiple bond of the polymer (B) improve adhesion of the resist pattern to the resist underlayer film. The present inventors consider that as a result of the improvement in adhesion, even a thinner resist pattern is less likely to collapse, so that a fine resist pattern can be formed.

### <Polymer (A)>

The polymer (A) has a partial structure represented by the following formula (A). 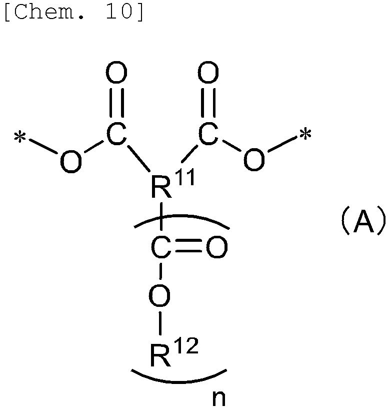 (In formula (A), R¹¹ represents an (n+2)-valent group having at least one of an aromatic hydrocarbon ring and an aliphatic hydrocarbon ring. R¹² represents a hydrogen atom, or an alkyl group having 1 to 13 carbon atoms which may be substituted with at least one group selected from the group consisting of an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms and an alkoxysulfonyl group having 1 to 13 carbon atoms. n represents 1 or 2. When n is 2, the two R¹² may be the same or different, and * represents a bonding site.)

The bonding site in formula (A) is preferably bonded to a carbon atom.

The polymer (A) preferably has a structural unit represented by the following formula (A-11). For example, the partial structure represented by formula (A) is a part of a structural unit represented by the following formula (A-11). 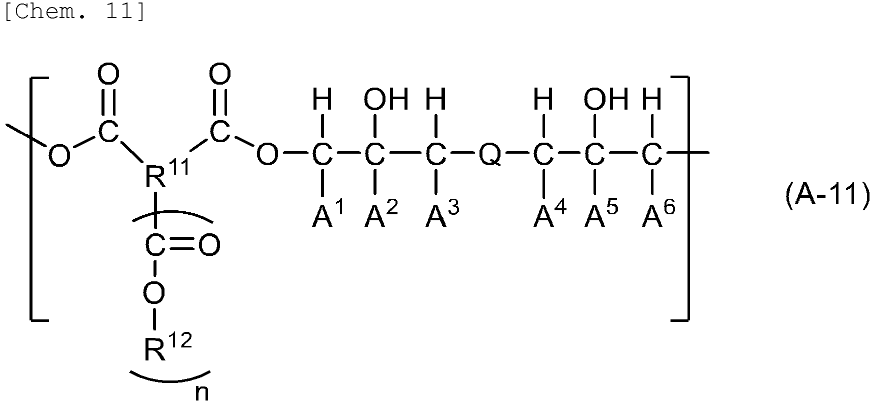 (In formula (A-11), A¹, A², A³, A⁴, A⁵, and A⁶ each independently represent a hydrogen atom, a methyl group or an ethyl group, Q represents a divalent organic group. R¹¹ represents an (n+2)-valent organic group having at least one of an aromatic hydrocarbon ring and an aliphatic hydrocarbon ring. R¹² represents a hydrogen atom, or an alkyl group having 1 to 13 carbon atoms which may be substituted with at least one group selected from the group consisting of an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms and an alkoxysulfonyl group having 1 to 13 carbon atoms. n represents 1 or 2. When n is 2, the two R¹² may be the same or different.)

### <<R¹¹>>

In formulas (A) and (A-11), R¹¹ represents an (n+2)-valent organic group having at least one of an aromatic hydrocarbon ring and an aliphatic hydrocarbon ring.

The number of carbon atoms of the (n+2)-valent organic group is not particularly limited, and is preferably 4 to 30, more preferably 4 to 20, and particularly preferably 4 to 15.

Examples of the aromatic hydrocarbon ring of the (n+2)-valent organic group include a benzene ring, a naphthalene ring, and an anthracene ring. Examples of the aliphatic hydrocarbon ring include a cyclobutane ring, a cyclopentane ring, and a cyclohexane ring.

The aliphatic hydrocarbon ring may have a polycyclic structure.

The aliphatic hydrocarbon ring may or may not have an unsaturated bond.

The aliphatic hydrocarbon ring may be an aliphatic hydrocarbon ring constituting a bridged polycyclic structure. The bridged polycyclic structure may have a hetero atom as an atom constituting the polycyclic structure. Examples of the heteroatom include an oxygen atom and a nitrogen atom. Examples of the bridged polycyclic structure include a norbornene ring.

Examples of R¹¹ include the following trivalent organic groups. The following trivalent organic group may be substituted with an alkyl group, an alkylcarbonyl group, a hydroxy group, an alkoxy group, an alkoxycarbonyl group, a halogen atom, a nitro group, a combination of two or more kinds thereof, or the like. In each formula below, * represents a bonding site.

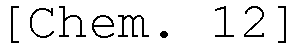

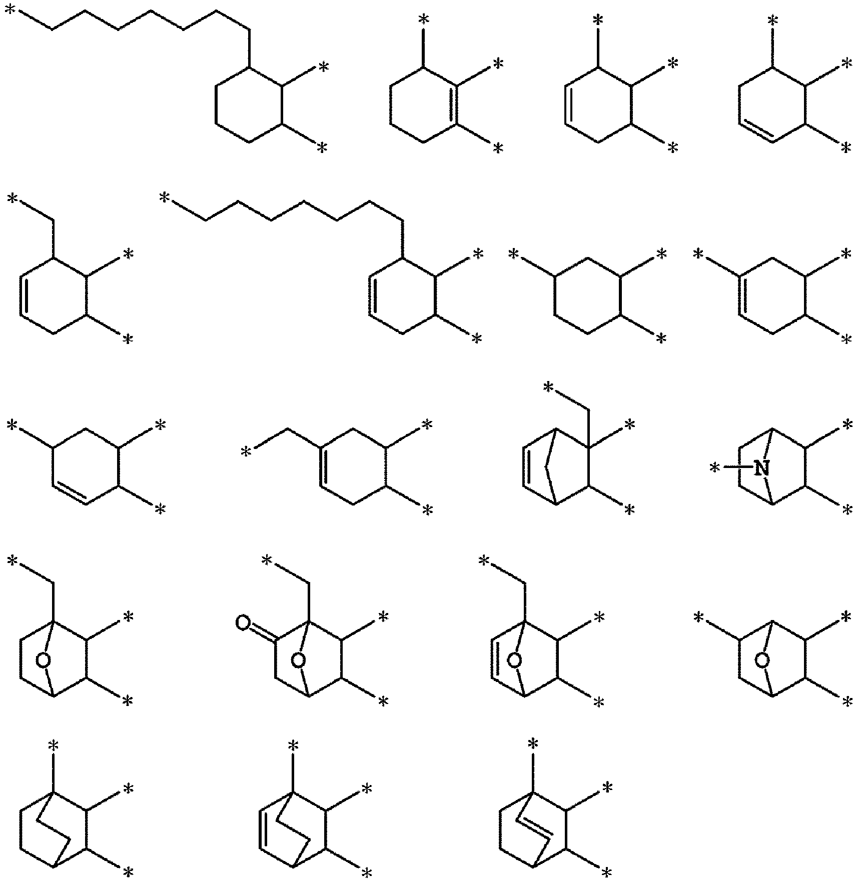

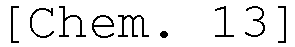

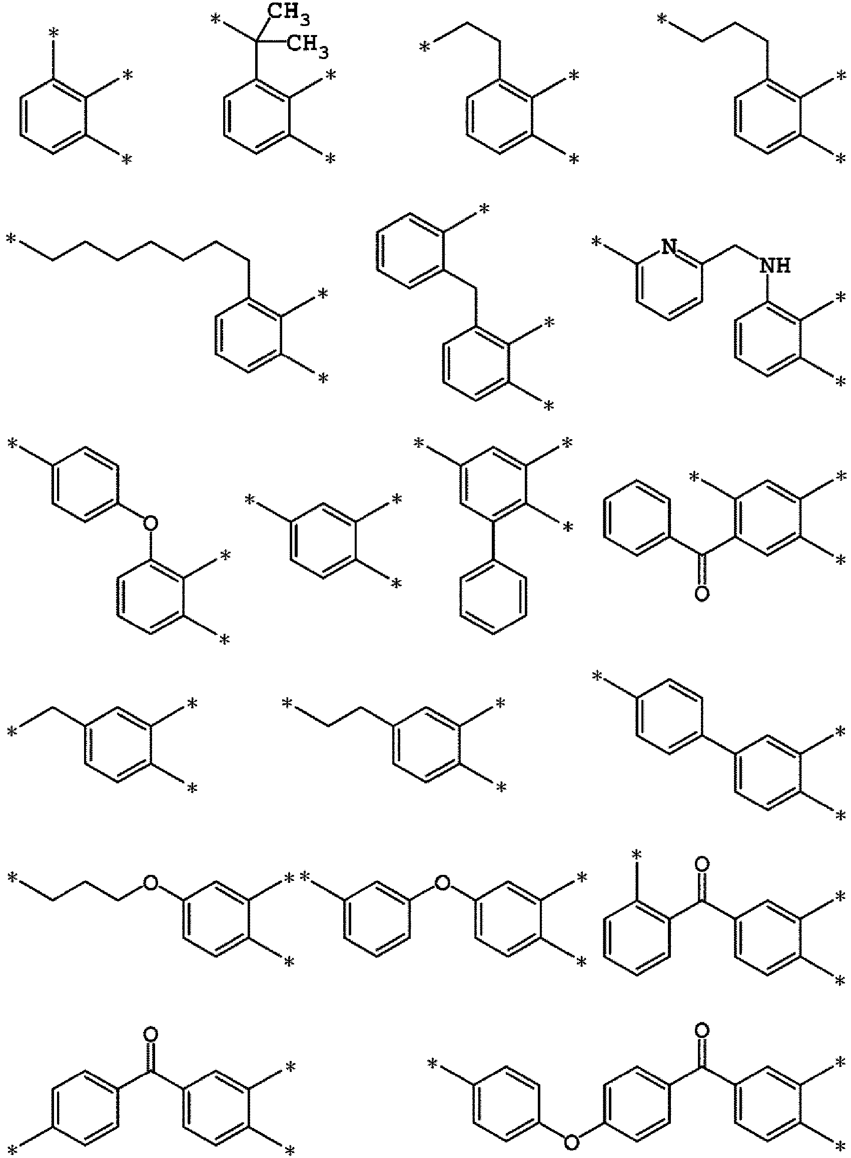

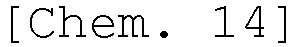

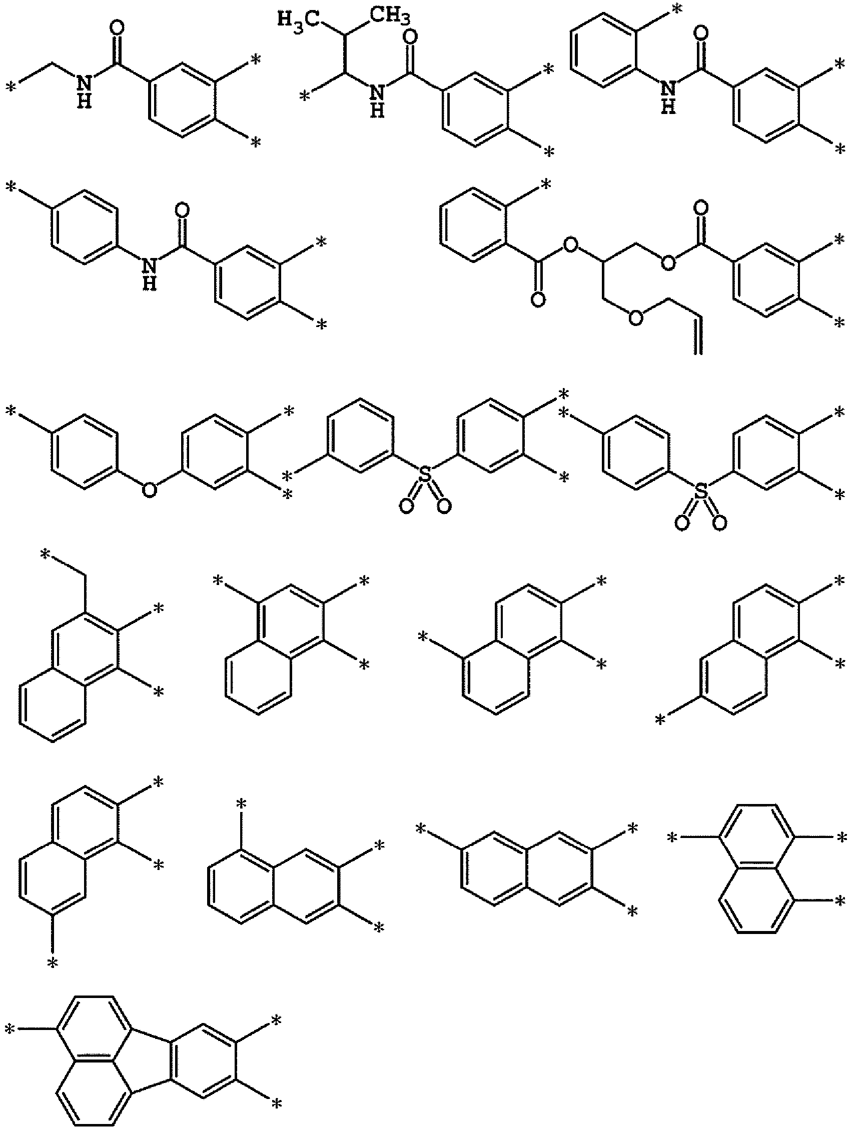

The trivalent organic group is preferably a trivalent organic group represented by the following formula. 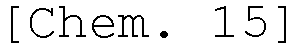 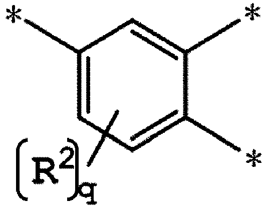 (In the formula, q represents an integer of 0 to 3, and R² represents an alkyl group having 1 to 6 carbon atoms or an alkoxy group having 1 to 6 carbon atoms. However, when q represents 2 or 3, R² may be the same or different. * represents a bonding site.)

Examples of R¹¹ include the following tetravalent organic groups. 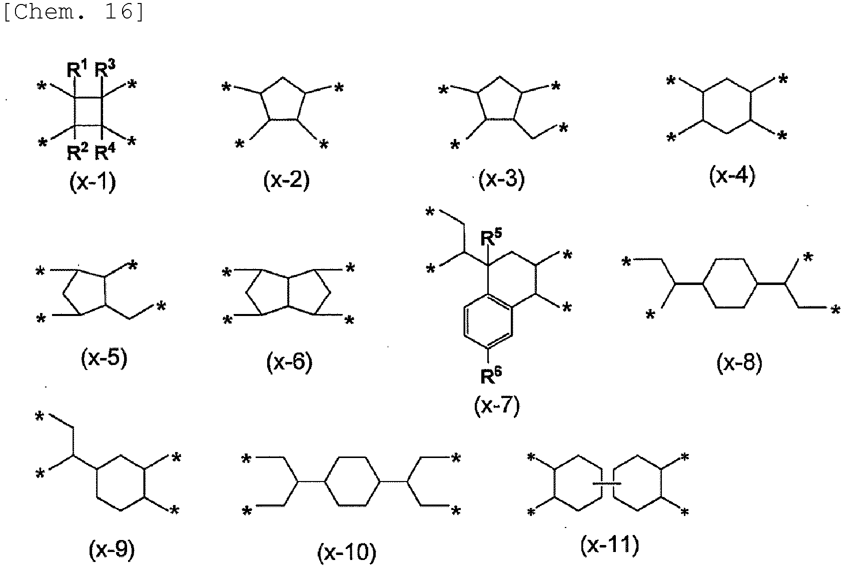 (In formulas (x-1) to (x-11), R¹ to R⁴ each independently represent a hydrogen atom, a halogen atom, an alkyl group having 1 to 6 carbon atoms, an alkenyl group having 2 to 6 carbon atoms, an alkynyl group having 2 to 6 carbon atoms, a monovalent organic group having 1 to 6 carbon atoms and having a fluorine atom, or a phenyl group. R⁵ and R⁶ each independently represent a hydrogen atom or a methyl group. * represents a bonding site.) 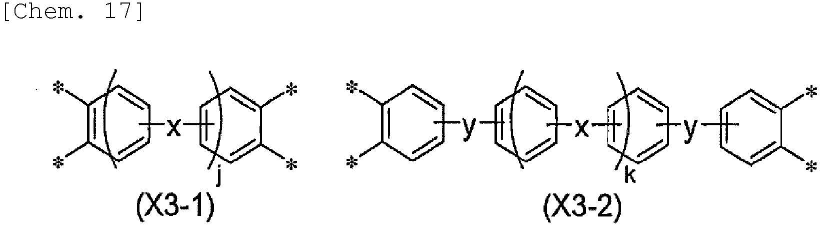 (In the formulas (X3-1) and (X3-2), x and y each independently represent a single bond, an ether bond, a carbonyl group, an ester bond, an alkanediyl group having 1 to 5 carbon atoms, 1,4-phenylene, a sulfonyl bond, or an amide group. j and k are integers of 0 or 1. * represents a bonding site.) 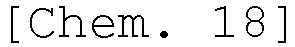 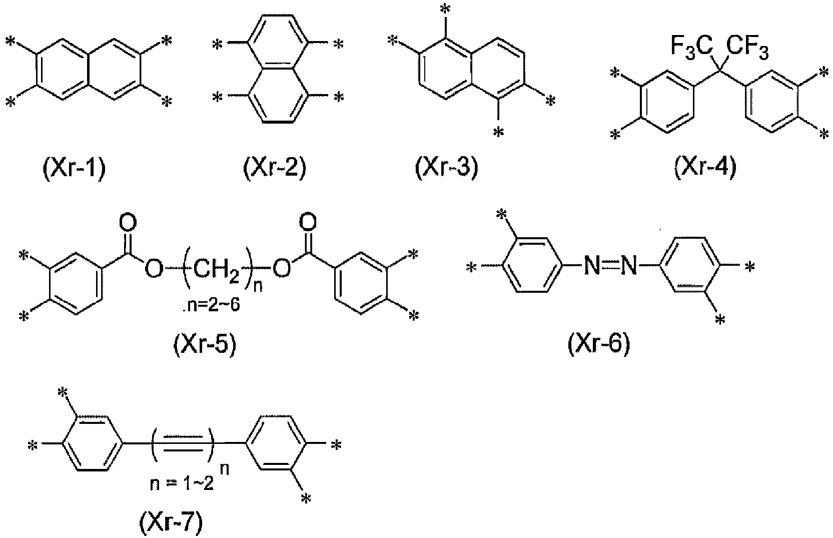 * represents a bonding site.

The tetravalent organic group represented by formula (X3-1) or (X3-2) may have a structure represented by any one of following formulas (X3-3) to (X3-19). 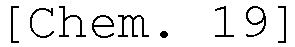 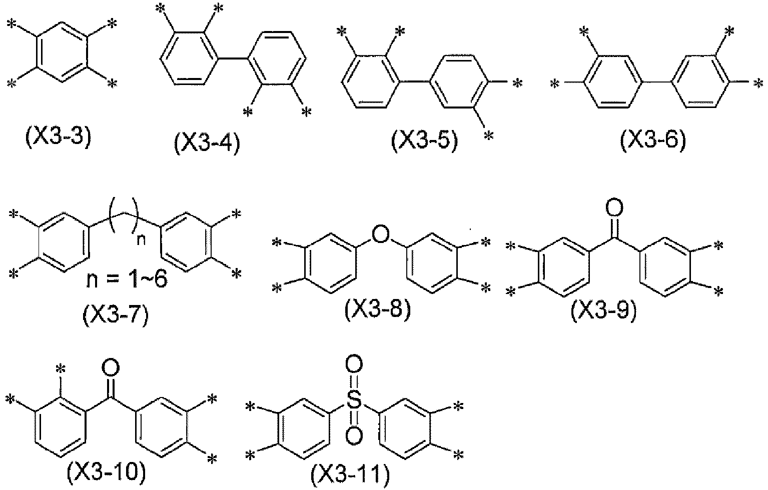 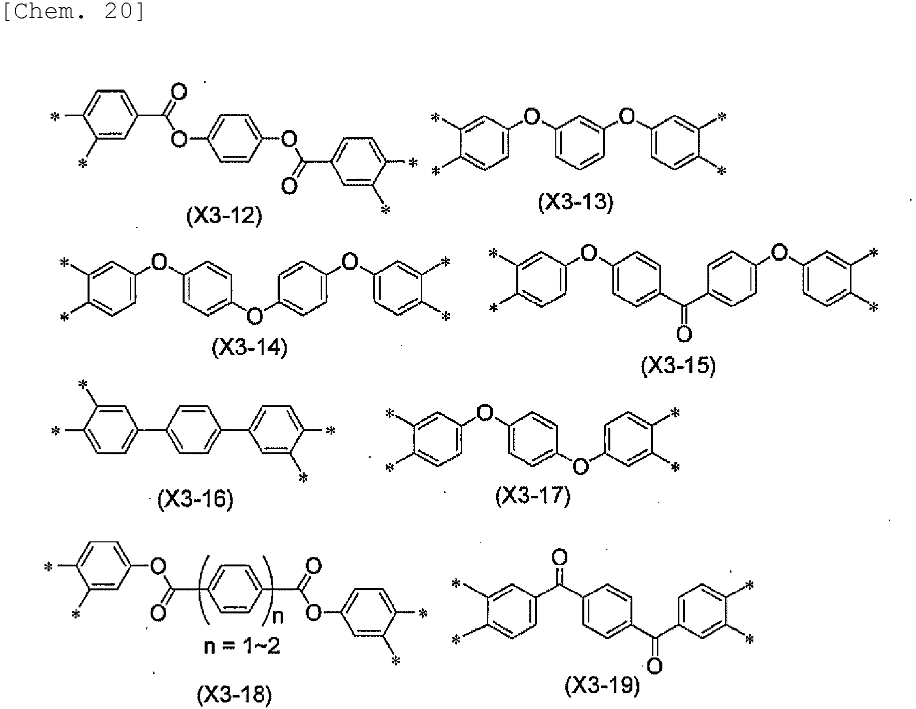 * represents a bonding site.

### <<R¹²>>

In the formulas (A) and (A-11), R¹² represents a hydrogen atom or an optionally substituted alkyl group having 1 to 13 carbon atoms.

The alkyl group having 1 to 13 carbon atoms may be substituted with at least one group selected from the group consisting of an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms, and an alkoxysulfonyl group having 1 to 13 carbon atoms.

The alkyl group having 1 to 13 carbon atoms is preferably an alkyl group having 1 to 8 carbon atoms, and more preferably an alkyl group having 1 to 6 carbon atoms.

The alkoxy group having 1 to 13 carbon atoms is preferably an alkoxy group having 1 to 8 carbon atoms, and more preferably an alkoxy group having 1 to 6 carbon atoms.

The alkylcarbonyloxy group having 2 to 13 carbon atoms is preferably an alkylcarbonyloxy group having 2 to 8 carbon atoms, and more preferably an alkylcarbonyloxy group having 2 to 6 carbon atoms.

The alkoxycarbonyl group having 2 to 13 carbon atoms is preferably an alkoxycarbonyl group having 2 to 8 carbon atoms, and more preferably an alkoxycarbonyl group having 2 to 6 carbon atoms.

The alkylthio group having 1 to 13 carbon atoms is preferably an alkylthio group having 1 to 8 carbon atoms, and more preferably an alkylthio group having 1 to 6 carbon atoms.

The alkylsulfonyloxy group having 1 to 13 carbon atoms is preferably an alkylsulfonyloxy group having 1 to 8 carbon atoms, and more preferably an alkylsulfonyloxy group having 1 to 6 carbon atoms.

The alkoxysulfonyl group having 1 to 13 carbon atoms is preferably an alkoxysulfonyl group having 1 to 8 carbon atoms, and more preferably an alkoxysulfonyl group having 1 to 6 carbon atoms.

In the present description, the alkyl group is not limited to a linear alkyl group, and may be branched or cyclic. Examples of the linear or branched alkyl group include a methyl group, an ethyl group, an isopropyl group, a tert-butyl group, and an n-hexyl group. Examples of the cyclic alkyl group (cycloalkyl group) include a cyclobutyl group, a cyclopentyl group, and a cyclohexyl group.

In the present description, examples of the alkoxy group include a methoxy group, an ethoxy group, an n-pentyloxy group, and an isopropoxy group.

In the present description, examples of the alkylcarbonyloxy group include a methylcarbonyloxy group and an ethylcarbonyloxy group.

In the present description, examples of the alkoxycarbonyl group include a methoxycarbonyl group, an ethoxycarbonyl group, and an isopropoxycarbonyl group.

In the present description, examples of the alkylthio group include a methylthio group, an ethylthio group, an n-pentylthio group, and an isopropylthio group.

In the present description, examples of the alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, and a 2-methyl-2-propenyl group.

In the present description, examples of the alkynyl group include groups in which a double bond of the alkenyl groups listed above as "alkenyl group" is replaced with a triple bond.

In the present description, examples of the halogen atom include a fluorine atom, a chlorine atom, a bromine atom, and an iodine atom.

R¹² is preferably an alkyl group having 1 to 13 carbon atoms or an alkyl group having 1 to 13 carbon atoms substituted with an alkoxy group having 1 to 13 carbon atoms from the viewpoint of suitably obtaining the effect of the present invention.

When n is 2, the two R¹² are preferably the same.

### <<Q>>

In formula (A-11), Q represents a divalent organic group. The divalent organic group is not particularly limited, but is preferably a divalent organic group having a hetero atom, and more preferably a divalent organic group having a nitrogen atom and an oxygen atom. Examples of the hetero atom include a nitrogen atom, an oxygen atom, and a sulfur atom.

The number of carbon atoms of the divalent organic group is not particularly limited, but the number of carbon atoms is preferably 3 to 30, and more preferably 3 to 20.

Q is preferably represented by any one of the following formulas (A-21) and (A-22) from the viewpoint of suitably obtaining the effect of the present invention. 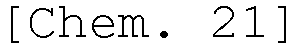 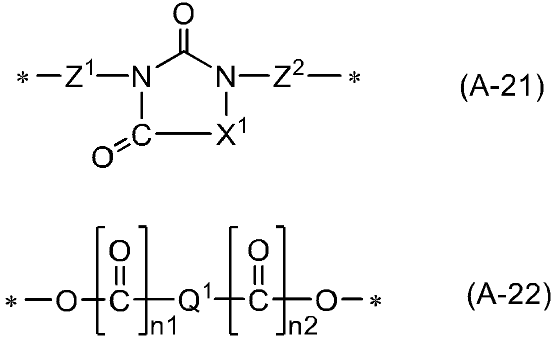
(In formula (A-21), X¹ represents a divalent group represented by the following formula (A-21-1), the following formula (A-21-2) or the following formula (A-21-3), Z¹ and Z² each independently represent a single bond or a divalent group represented by the following formula (A-21-4). * represents a bonding site.
In formula (A-22), Q¹ represents a divalent group having an aromatic hydrocarbon ring or an aliphatic hydrocarbon ring. n1 and n2 each independently represent 0 or 1. * represents a bonding site) 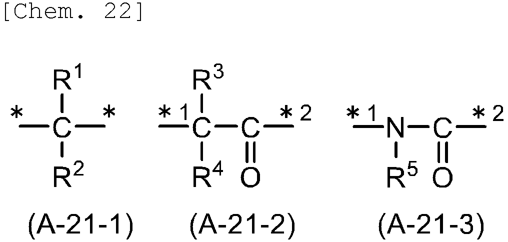
(In formulas (A-21-1) to (A-21-3), R¹ to R⁵ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group and an alkylthio group having 1 to 6 carbon atoms, R¹ and R² may be bonded to each other to form a ring having 3 to 6 carbon atoms. R³ and R⁴ may be bonded to each other to form a ring having 3 to 6 carbon atoms. * represents a bonding site. *1 represents a bonding site bonded to a carbon atom. *2 represents a bonding site bonded to a nitrogen atom.) 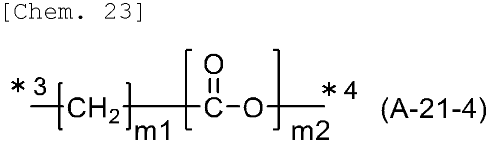
(In formula (A-21-4), m1 is an integer of 1 to 4, m2 is 0 or 1, *3 represents a bonding site bonded to a nitrogen atom. *4 represents a bonding site bonded to a carbon atom.)

Q¹ in formula (A-22) is preferably represented by any one of the following formulas (A-22-1) to (A-22-4). 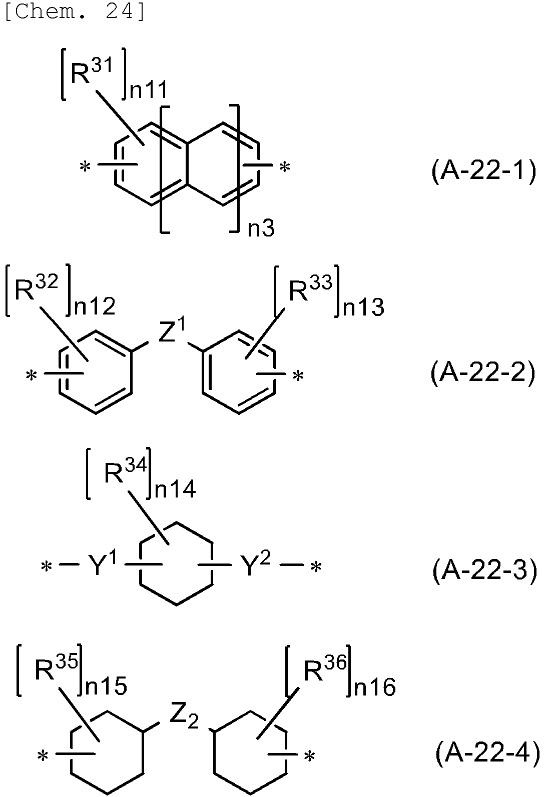 (In formulas (A-22-1) to (A-22-4), R³¹ to R³⁶ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms or an aralkyl group having 7 to 13 carbon atoms, and * represents a bonding site.

In formula (A-22-1), n3 represents 0 or 1. When n3 is 0, n11 represents an integer of 0 to 4. When n3 is 1, n11 represents an integer of 0 to 6. When R³¹ is 2 or more, the two or more R³¹ may be the same or different.

In formula (A-22-2), Z¹ represents a single bond, an oxygen atom, a sulfur atom, a carbonyl group, a sulfonyl group or an alkylene group having 1 to 6 carbon atoms. n12 and n13 each independently represent an integer of 0 to 4. When R³² is 2 or more, the two or more R³² may be the same or different. When R³³ is 2 or more, the two or more R³³ may be the same or different.

In formula (A-22-3), Y¹ and Y² each independently represent a single bond or an alkylene group having 1 to 6 carbon atoms. n14 represents an integer of 0 to 4. When R³⁴ is 2 or more, the two or more R³⁴ may be the same or different.

In formula (A-22-4), Z² represents a single bond, an oxygen atom, a sulfur atom, a carbonyl group, a sulfonyl group or an alkylene group having 1 to 6 carbon atoms. n15 and n16 each independently represent an integer of 0 to 4. When R³⁵ is 2 or more, the two or more R³⁵ may be the same or different. When R³⁶ is 2 or more, the two or more R³⁶ may be the same or different.

Examples of Q in formula (A-11) include the following structures. 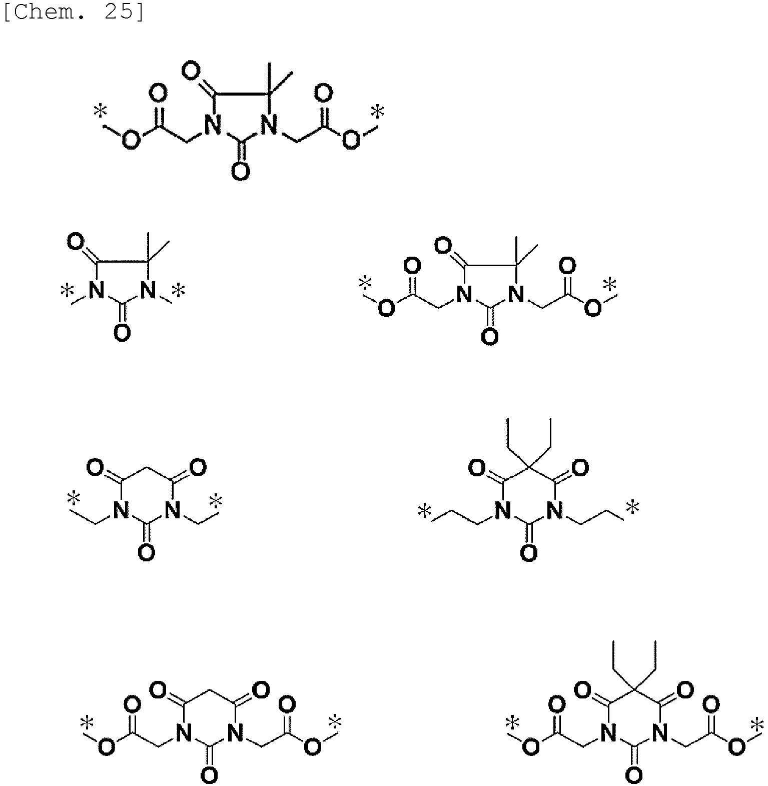 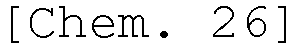 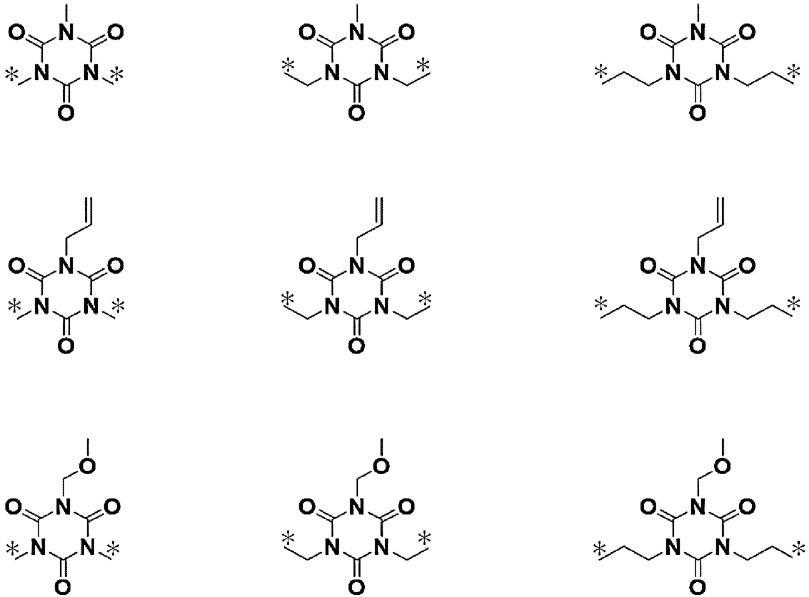 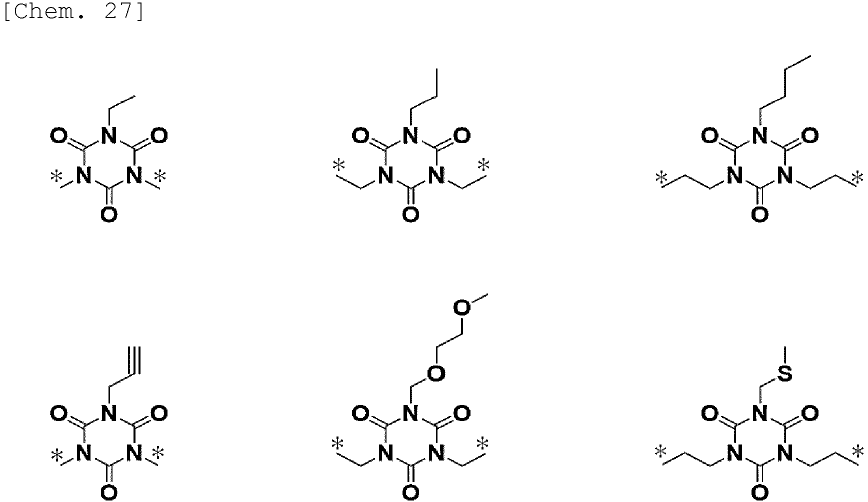 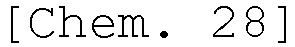 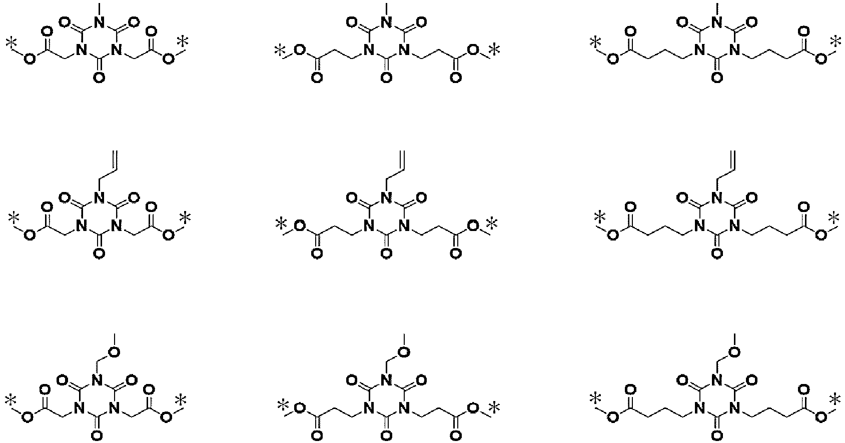 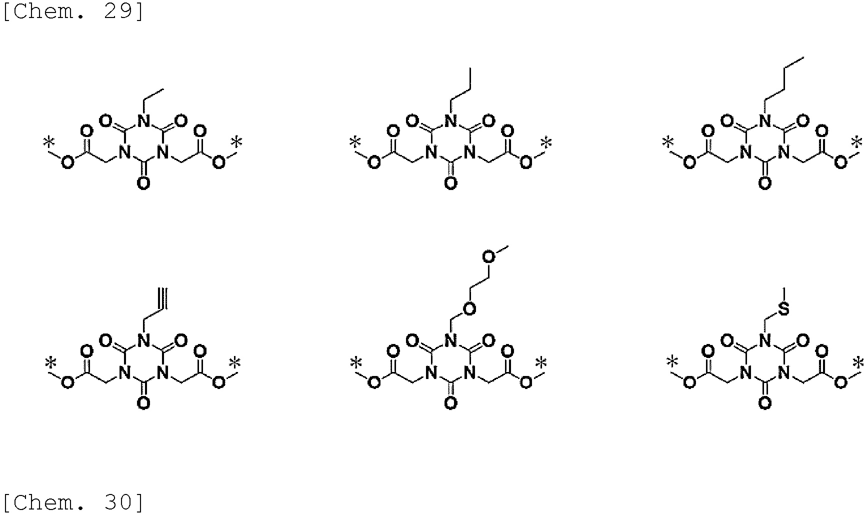 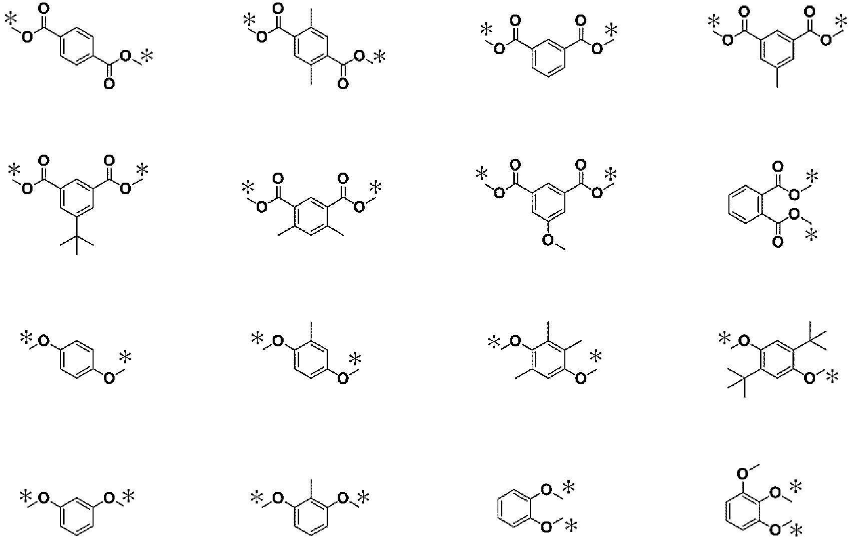 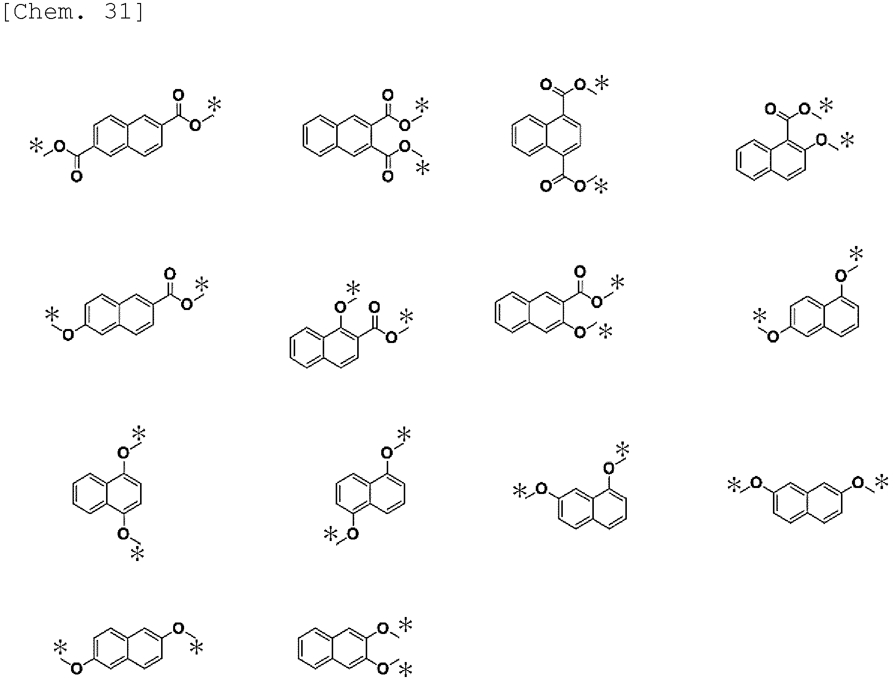 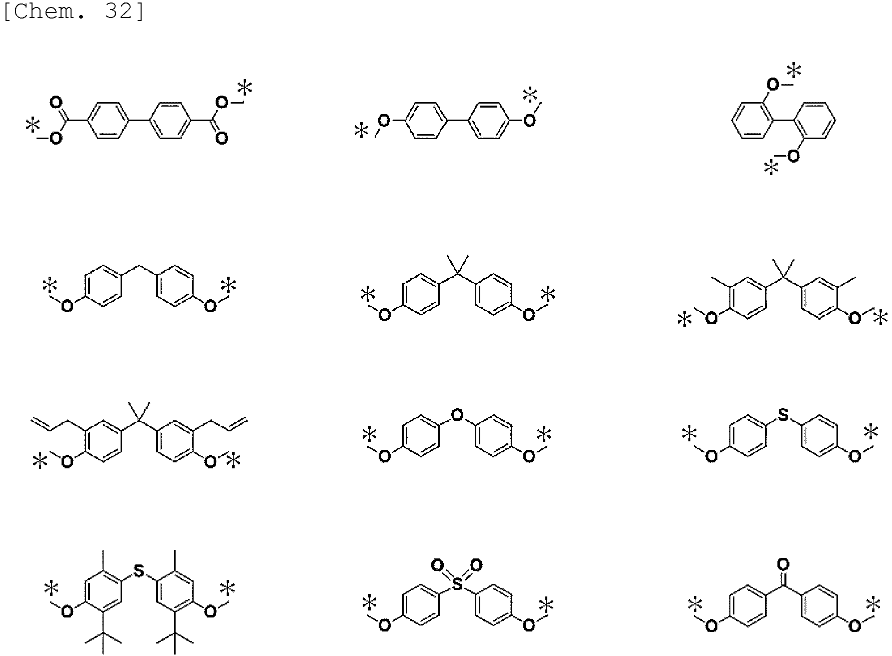 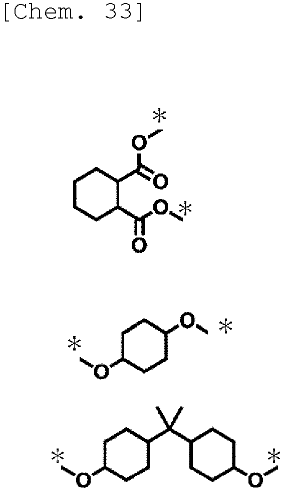 * represents a bonding site.

When the polymer (A) has the structural unit represented by formula (A-11), the mass ratio of the structural unit represented by formula (A-11) in the polymer (A) is not particularly limited, but is preferably 50% by mass to 100% by mass, more preferably 75% by mass to 100% by mass, and particularly preferably 90% by mass to 100% by mass.

The method for producing the polymer (A) is not particularly limited, and examples thereof include a method in which at least one of a tetracarboxylic acid dianhydride represented by the following formula (A1) and a tricarboxylic acid anhydride represented by the following formula (A2) is reacted with a diepoxy compound represented by the following formula (2A) and a compound represented by the following formula (C). In this case, a polymer (A) having a structural unit represented by formula (A-11) is obtained.

For example, at least one of a tetracarboxylic acid dianhydride represented by following formula (A1) and a tricarboxylic acid anhydride represented by following formula (A2), and a diepoxy compound represented by following formula (2A) at an appropriate molar ratio are dissolved in an organic solvent containing a large excess amount of a compound represented by following formula (C). Then, the polymer (A) is obtained by polymerization in the presence of a catalyst that activates an epoxy group.

When R¹² is a hydrogen atom, the compound represented by formula (C) is not used, and another inert organic solvent is used.

In the above reaction, a tetracarboxylic acid or a tricarboxylic acid may be used in place of the tetracarboxylic acid dianhydride represented by formula (A1) and the tricarboxylic acid anhydride represented by formula (A2).

Examples of the catalyst for activating an epoxy group include a quaternary phosphonium salt such as tetrabutylphosphonium bromide or ethyltriphenylphosphonium bromide, and a quaternary ammonium salt such as benzyltriethylammonium chloride. As the amount of the catalyst used, an appropriate amount can be selected and used from the range of 0.1 to 10% by mass with respect to the total mass of the polymer raw material used in the reaction. As the temperature and the time for the polymerization reaction, for example, optimum conditions can be selected from the ranges of 80 to 160°C and 2 to 50 hours. 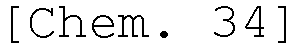 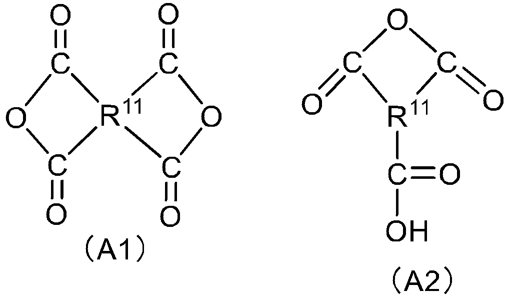 (In the formulas (A1) and (A2), R¹¹ has the same meaning as R¹¹ in formula (A-11).) 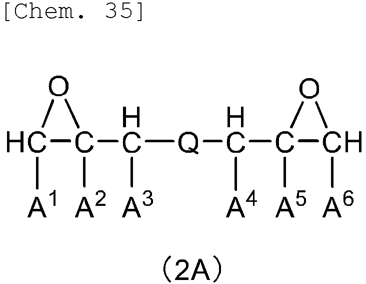 (In formula (2A), A¹, A², A³, A⁴, A⁵, A⁶ and Q have the same meanings as A¹, A², A³, A⁴, A⁵, A⁶ and Q in formula (A-11), respectively.)

[Chem. 36] HO-R¹² (C)

(In formula (C), R¹² has the same meaning as R¹² in formula (A-11).)

Examples of the compound represented by formula (C) include the following compounds.

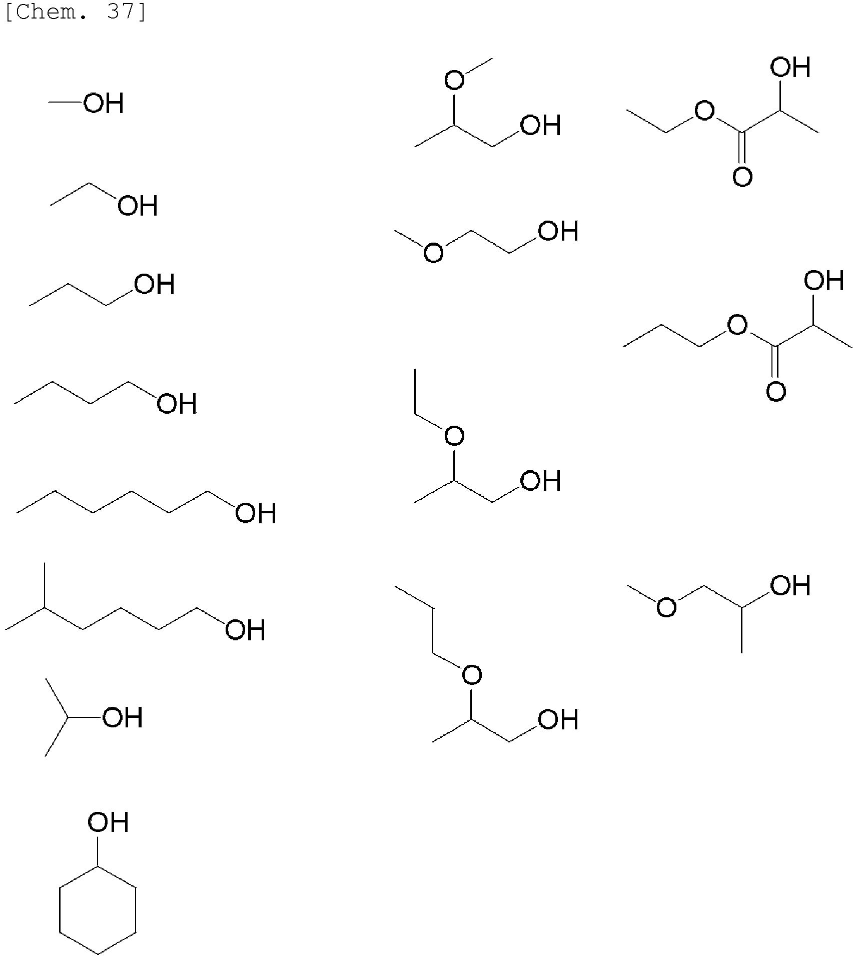

The molecular weight of the polymer (A) is not particularly limited.

The lower limit of the weight average molecular weight of the polymer (A) is, for example, 500, 1,000, 2,000, or 3,000.

The upper limit of the weight average molecular weight of the polymer (A) is, for example, 100,000, 75,000, or 50,000.

The content of the polymer (A) in the resist underlayer film-forming composition is not particularly limited, but is preferably 20% by mass to 50% by mass, and more preferably 25% by mass to 45% by mass with respect to the film constituent from the viewpoint of suitably obtaining the effect of the present invention.

In the present invention, the film constituent means a component other than the solvent contained in the composition.

### <Polymer (B)>

The polymer (B) has a polymerizable multiple bond.

The polymerizable multiple bond is, for example, one kind or two or more kinds of polymerizable multiple bonds selected from the group consisting of a carbon-carbon double bond, a carbon-carbon triple bond, a carbon-nitrogen double bond, and a carbon-nitrogen triple bond.

The polymer (B) may have, for example, a polymerizable multiple bond in the main chain or a polymerizable multiple bond in the side chain.

The polymer (B) is a polymer different from the polymer (A).

The polymer (B) is an organic polymer.

The polymer (B) may be a homopolymer or a copolymer.

The polymer (B) has, for example, a (meth)acryloyl group, a vinylaryl group (e.g. a styryl group), a vinyloxy group, or an allyl group as a group having a polymerizable multiple bond in a side chain.

The polymer (B) has, for example, a vinyl group (-CH=CH-) as the group having a polymerizable multiple bond in a main chain or a side chain.

From the viewpoint of suitably obtaining the effect of the present invention, the polymer (B) is preferably a polymer (B-1) having a structural unit represented by formula (B-1) described later.

From the viewpoint of suitably obtaining the effect of the present invention, the polymer (B) is preferably a polymer (B-2) having a structural unit represented by formula (B-2) described later.

### <<Polymer (B-1)>>

The polymer (B-1) is, for example, a polymer obtained by polymerizing a polymerizable unsaturated bond of a compound having a group having a polymerizable unsaturated bond. The polymer (B-1) may be a homopolymer or a copolymer.

Examples of the group having a polymerizable unsaturated bond include a (meth)acryloyl group, a vinylaryl group (for example, a styryl group), a vinyloxy group, and an allyl group.

For example, in the polymer (B-1), the polymerizable multiple bond is bonded to a main chain of the polymer (B-1) via a linking group having a structure formed by reacting an epoxy group with a nucleophilic functional group.

Examples of the nucleophilic functional group include one kind or two or more kinds selected from the group consisting of a carboxy group, a hydroxy group, an amino group, and a thiol group. The hydroxy group may be a phenolic hydroxy group, or need not be a phenolic hydroxy group.

When an epoxy group reacts with a carboxy group, the following reaction occurs to form the following structure (S1).

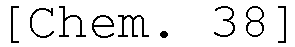

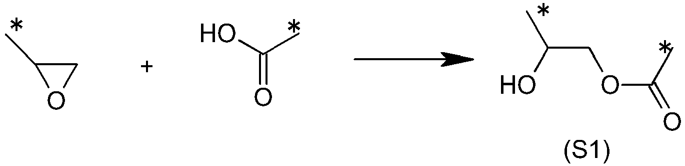

In the formula, * represents a bonding site.

Further, for example, in the polymer (B-1), the polymerizable multiple bond is bonded to the main chain of the polymer (B-1) via a linking group having a structure obtained by reacting an isocyanate group with a nucleophilic functional group. In this case, examples of the nucleophilic functional group include one kind or two or more kinds selected from the group consisting of a hydroxy group, an amino group, and a thiol group. The hydroxy group may be a phenolic hydroxy group, or need not be a phenolic hydroxy group.

The polymer (B-1) has a structural unit represented by the following formula (B-1). 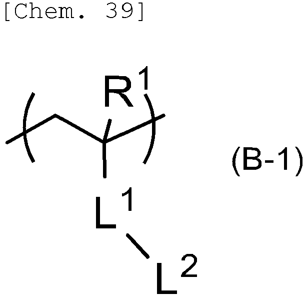 (In formula (B-1), R¹ represents a hydrogen atom or an alkyl group having 1 to 10 carbon atoms. L¹ represents a single bond or a linking group. L² represents a monovalent group having the polymerizable multiple bond.)

Examples of the alkyl group having 1 to 10 carbon atoms include a methyl group, an ethyl group, a n-propyl group, an i-propyl group, a cyclopropyl group, a n-butyl group, an i-butyl group, a s-butyl group, a t-butyl group, a cyclobutyl group, a 1-methyl-cyclopropyl group, a 2-methyl-cyclopropyl group, a n-pentyl group, a 1-methyl-n-butyl group, a 2-methyl-n-butyl group, a 3-methyl-n-butyl group, a 1,1-dimethyl-n-propyl group, 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, a n-heptyl group, a cycloheptyl group, a norbornyl group, a n-octyl group, a cyclooctyl group, a n-nonyl group, an isobornyl group, a tricyclononyl group, a n-decyl group, an adamantyl group, and a tricyclodecyl group. Among these groups, a methyl group is preferred.

When L¹ is a linking group, the number of carbon atoms of the linking group is not particularly limited. For example, the number of carbon atoms of the linking group is 1 to 10.

When L¹ is a linking group, examples of the linking group include a linking group having a structure formed by reacting an epoxy group with a nucleophilic functional group, and a linking group having a structure formed by reacting an isocyanate group with a nucleophilic functional group.

Examples of L¹ include the following linking groups (L1-1) to (L1-11): 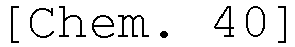 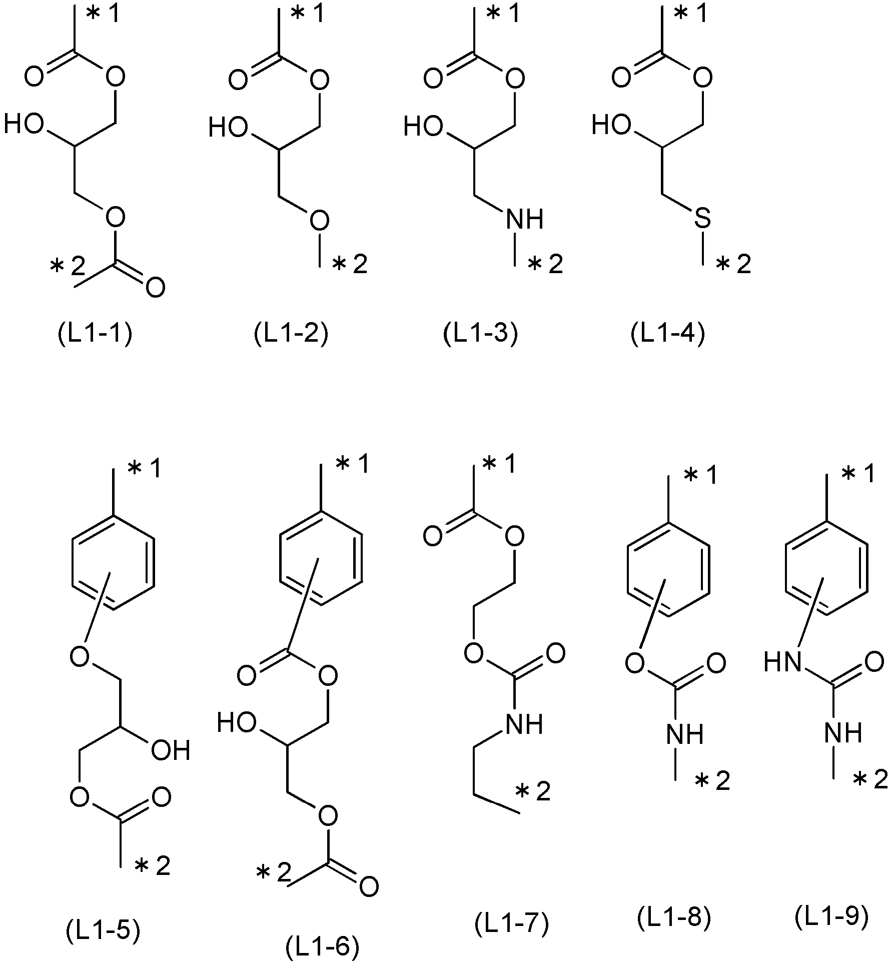 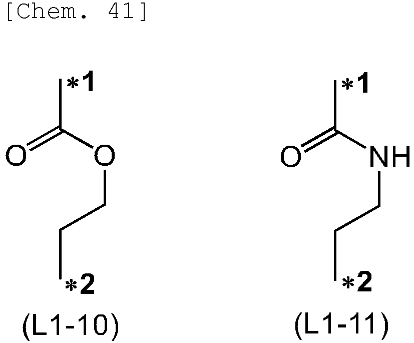 (In the formula, *1 represents a bonding site bonded to a carbon atom bonded to R¹ in formula (B-1). *2 represents a bonding site bonded to L² in formula (B-1). )
L² is a monovalent group having a polymerizable multiple bond. The monovalent group may be a polymerizable multiple bond itself.

The number of carbon atoms of the monovalent group is not particularly limited, and may be, for example, 1 to 20 or 1 to 10.

Examples of L² include the following monovalent groups (L2-1) to (L2-81): 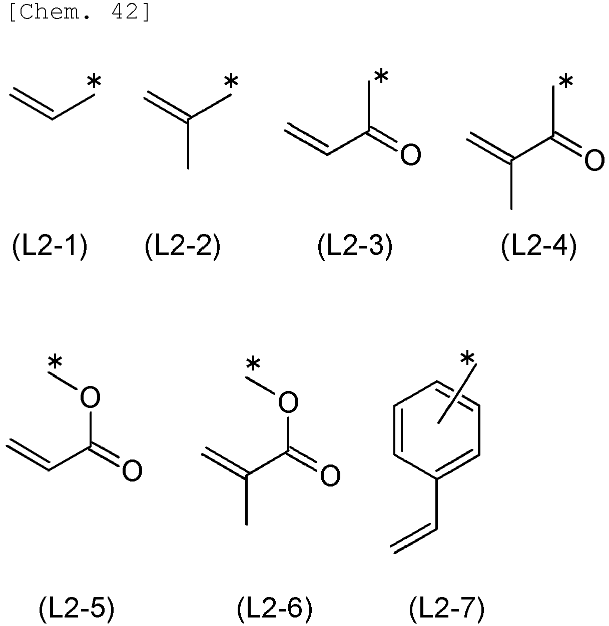 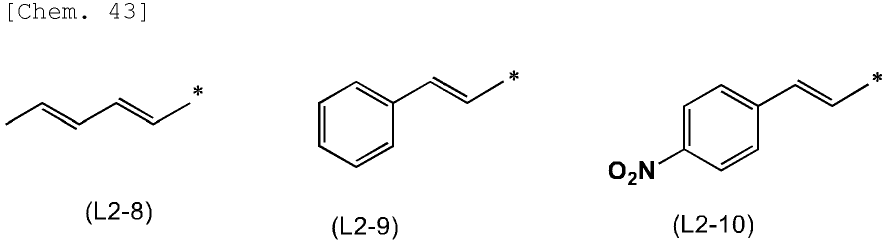 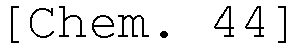 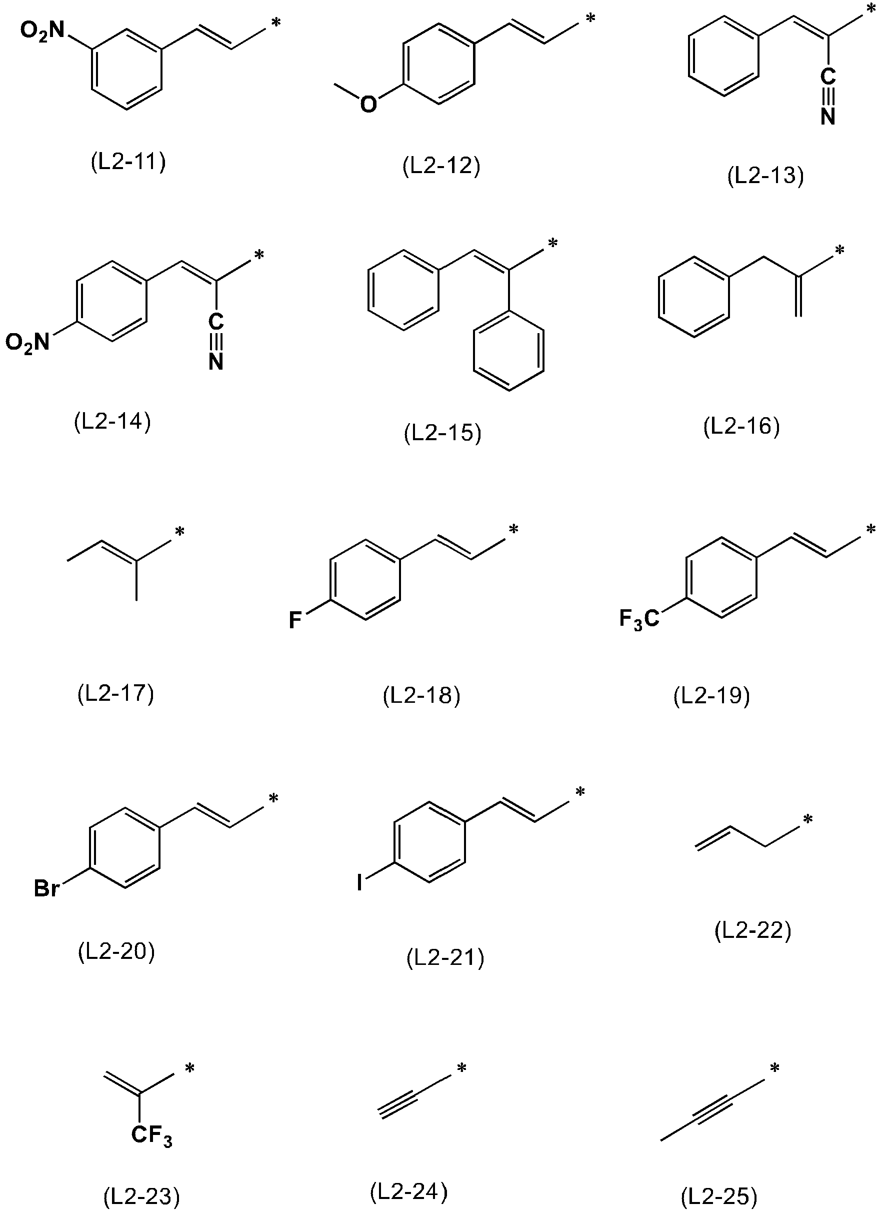 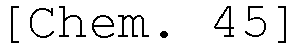 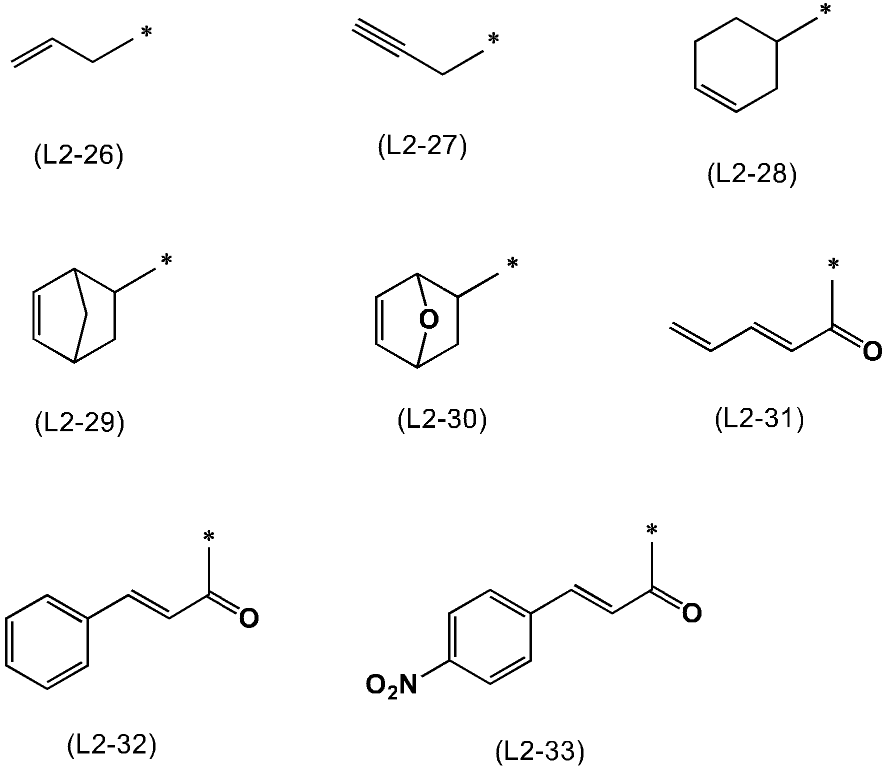 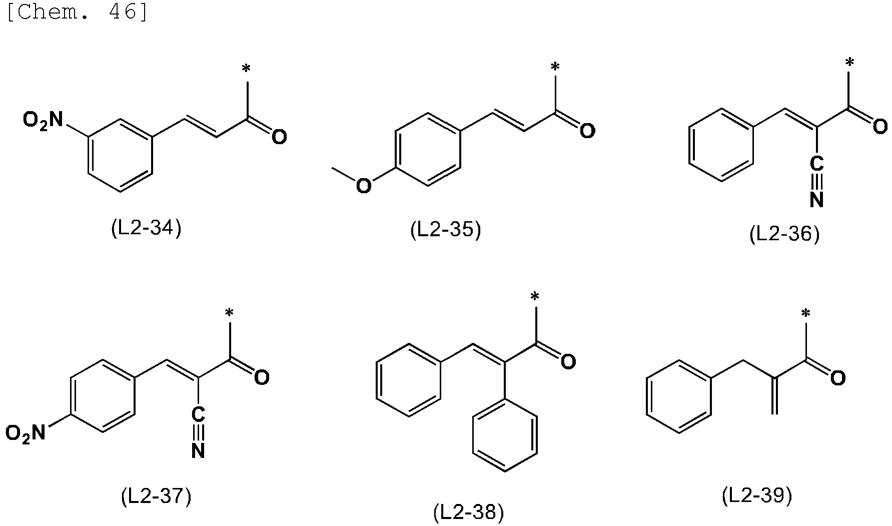 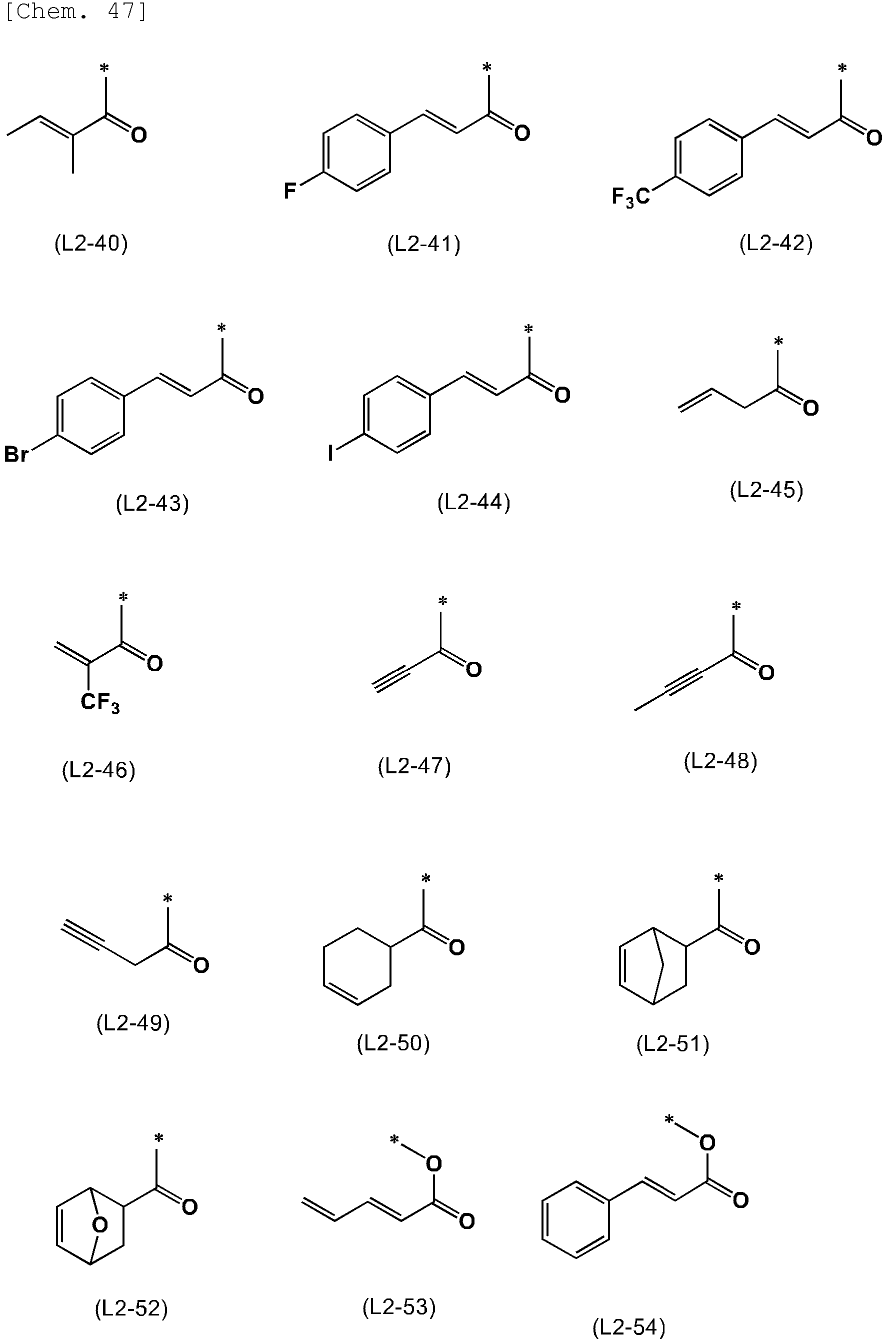 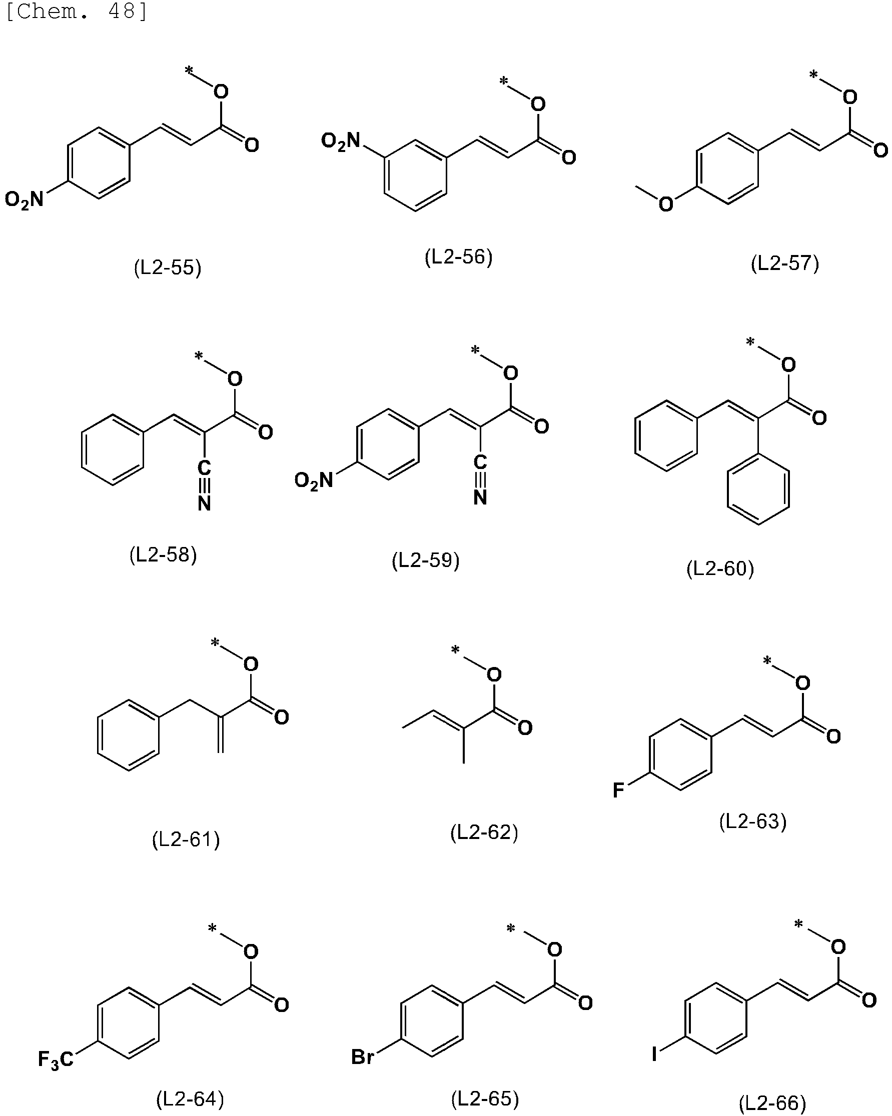 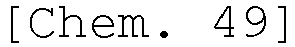 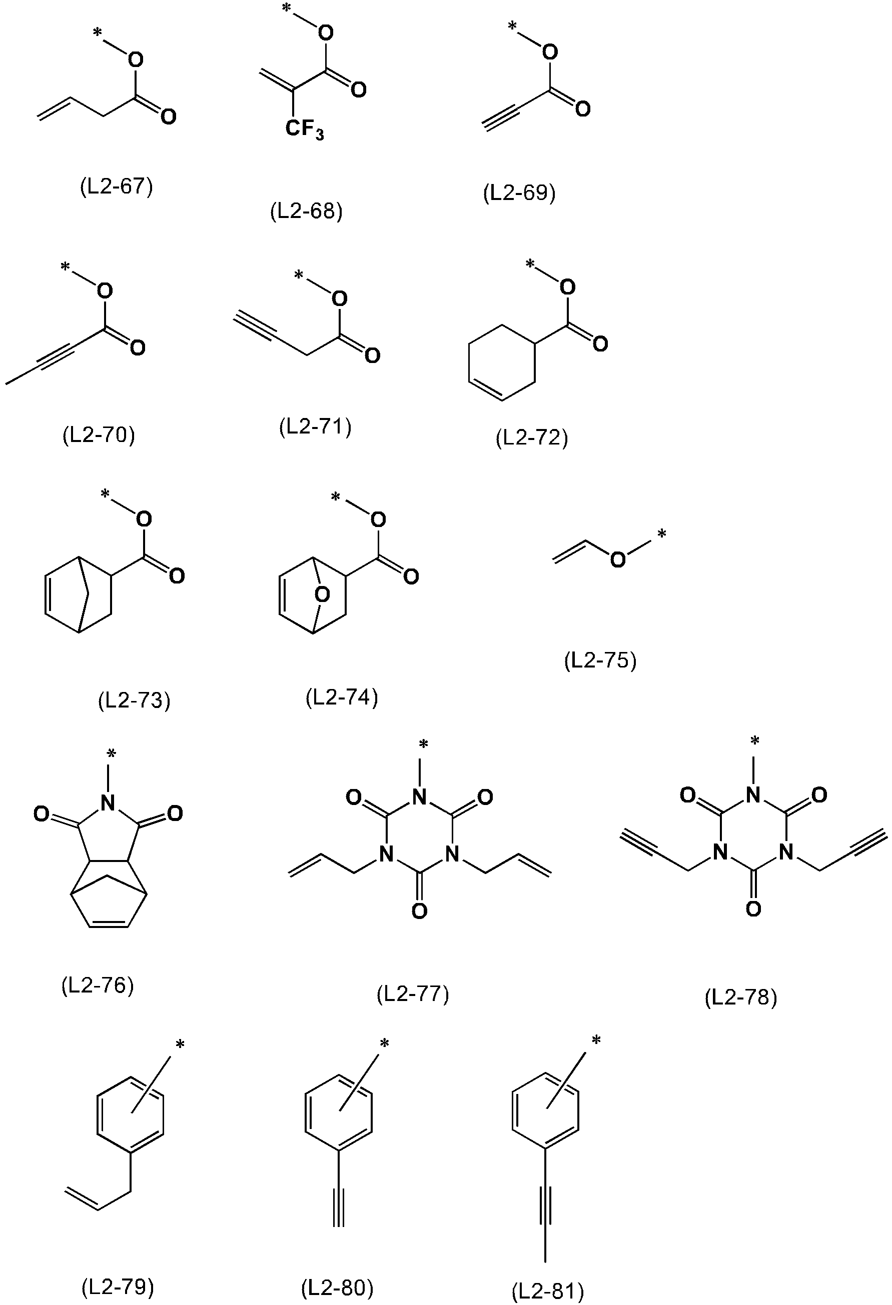 (where * represents a bonding site.)

Examples of the combination of the linking groups (L1-1) to (L1-9) and the monovalent groups (L2-1) to (L2-7) include the following combinations:
Combination of (L1-1) and (L2-1);
Combination of (L1-1) and (L2-2);
Combination of (L1-1) and (L2-7);
Combination of (L1-2) and (L2-3);
Combination of (L1-2) and (L2-4);
Combination of (L1-2) and (L2-7);
Combination of (L1-3) and (L2-3);
Combination of (L1-3) and (L2-4);
Combination of (L1-4) and (L2-7);
Combination of (L1-5) and (L2-1);
Combination of (L1-5) and (L2-2);
Combination of (L1-6) and (L2-1);
Combination of (L1-6) and (L2-2);
Combination of (L1-7) and (L2-5);
Combination of (L1-7) and (L2-6);
Combination of (L1-8) and (L2-7); and
Combination of (L1-9) and (L2-7).

The combination of (L1-1) and (L2-1) has the same meanings as the combination of (L1-2) and (L2-3). The combination of (L1-1) and (L2-2) has the same meanings as the combination of (L1-2) and (L2-4).

Further, L¹-L² in the structural unit represented by formula (B-1) preferably has a structure represented by the following formula (1a), (1b) or (1c). 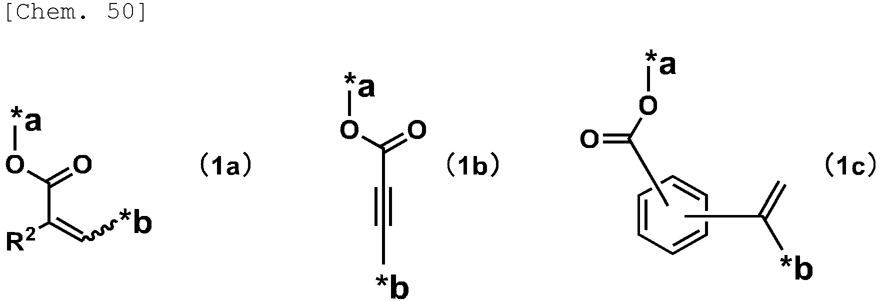 (In formulas (1a) to (1c), R² represents a hydrogen atom or an alkyl group having 1 to 10 carbon atoms. *a and *b represent a bonding site, *a is a main chain side of the polymer (B-1), and *b is a terminal side of a side chain of the polymer (B-1).)

Note that *b may be a bonding site with a hydrogen atom.

Examples of the structural unit represented by formula (B-1) include the following structural units.

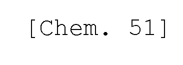

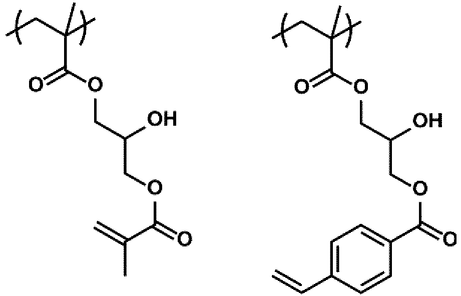

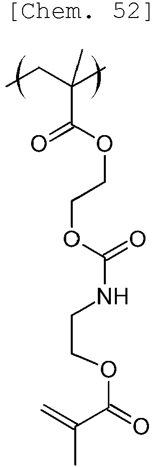

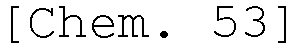

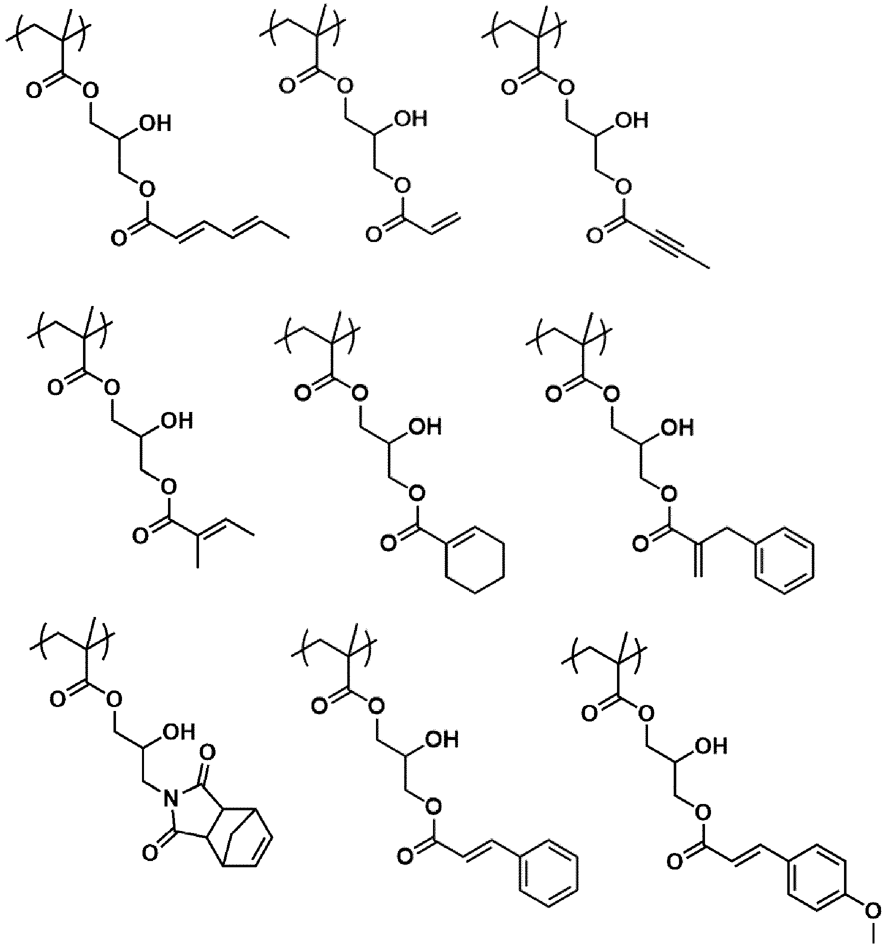

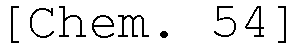

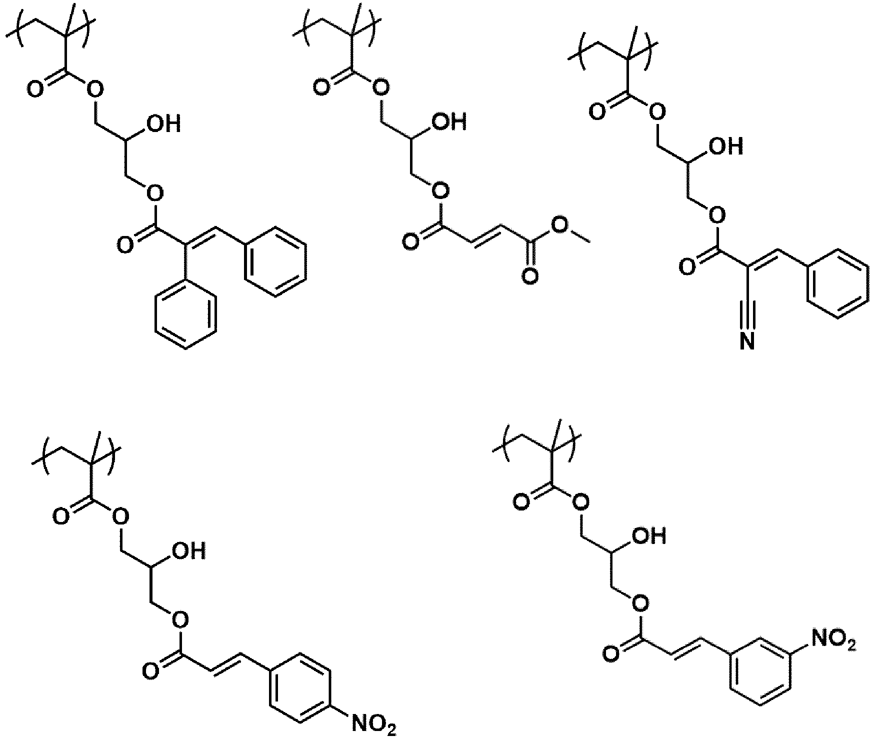

An example of the polymer (B-1) having a structural unit represented by formula (B-1) can be obtained, for example, by reacting a glycidyl (meth)acrylate-based polymer with a compound (C1) having a polymerizable multiple bond and a carboxy group as described below. The glycidyl (meth)acrylate-based polymer may be a homopolymer or a copolymer. Examples of the copolymer include a copolymer of glycidyl (meth)acrylate and 2-hydroxyethyl (meth)acrylate and a copolymer of glycidyl (meth)acrylate and 2-hydroxypropyl (meth)acrylate. 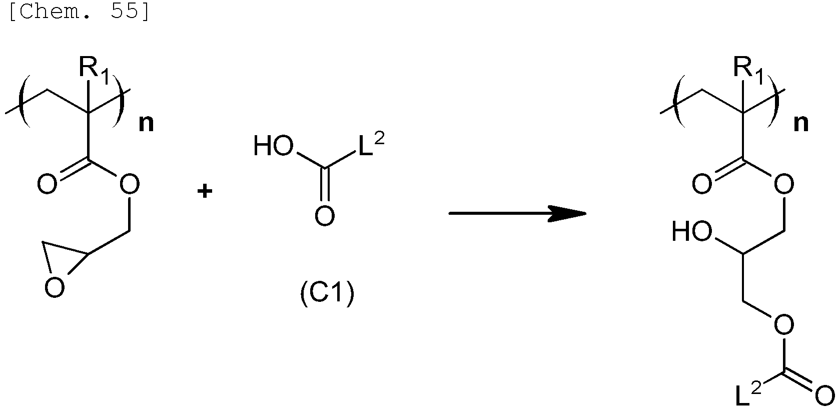 (In the formula, R¹ and L² have the same meanings as R¹ and L² in formula (B-1), respectively.)

The reaction can be performed, for example, in the presence of a catalyst such as tetrabutylphosphonium bromide.

Examples of the compound (C1) having a polymerizable multiple bond and a carboxy group include acrylic acid, methacrylic acid, 4-vinylbenzoic acid, sorbic acid, tetrolic acid, tiglic acid, 1-cyclohexene-1-carboxylic acid, 2-benzylacrylic acid, trans-cinnamic acid, trans-4-methoxycinnamic acid, α-phenylcinnamic acid, monomethyl fumarate, α-cyanocinnamic acid, 4-nitrocinnamic acid, and 3-nitrocinnamic acid.

Another example of the polymer (B-1) having a structural unit represented by formula (B-1) can be obtained by, for example, reacting a compound (C2) having a polymerizable multiple bond and an isocyanate group with a (meth)acrylatete-based polymer having a hydroxy group as described below. The (meth)acrylate-based polymer having a hydroxy group may be a homopolymer or a copolymer. 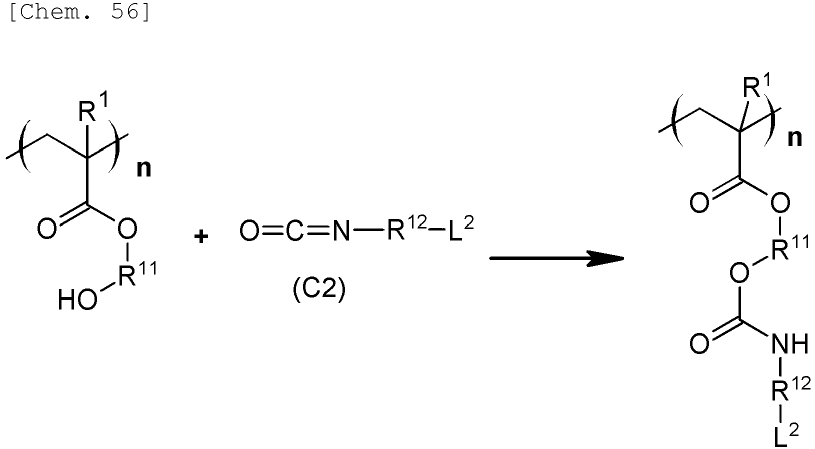
(In the formula, R¹ and L² have the same meanings as R¹ and L² in formula (B-1), respectively. R¹¹ represents a divalent organic group. R¹² represents a single bond or a divalent organic group.)
R¹¹ is, for example, an alkylene group having 1 to 4 carbon atoms.
R¹² is, for example, a single bond or an alkylene group having 1 to 4 carbon atoms.

Another example of the polymer (B-1) having a structural unit represented by formula (B-1) can be obtained by, for example, reacting a compound (C2) having a polymerizable multiple bond and an isocyanate group with a styrene-based polymer having a hydroxy group or an amino group as described below. The styrene-based polymer having a hydroxy group or an amino group may be a homopolymer or a copolymer. 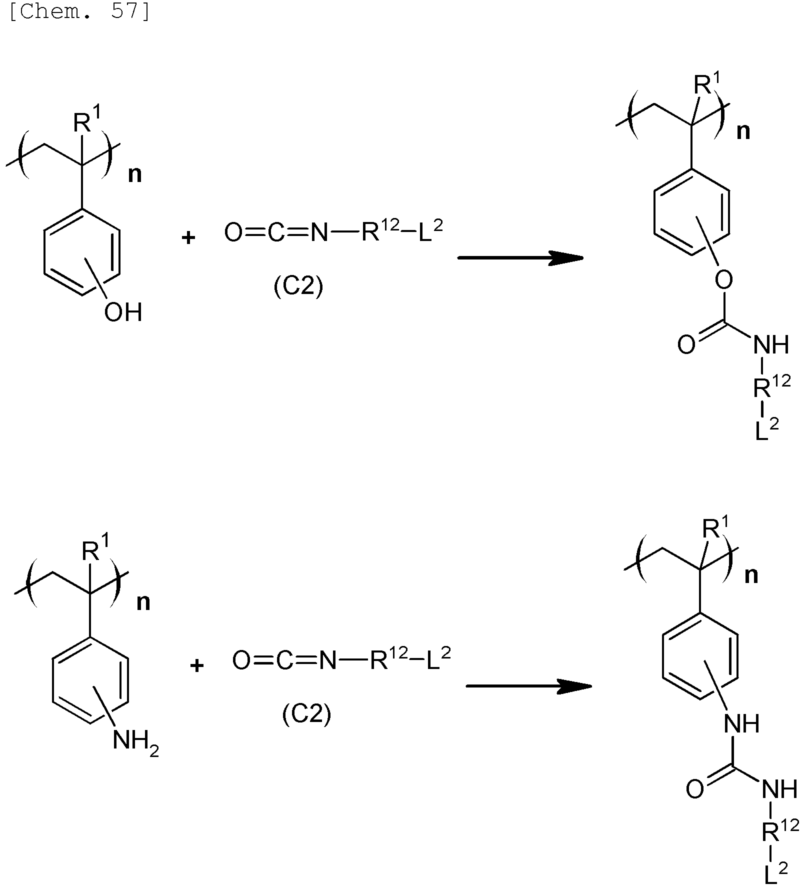
(In the formula, R¹ and L² have the same meanings as R¹ and L² in formula (B-1), respectively. R¹² represents a single bond or a divalent organic group.)
R¹² is, for example, a single bond or an alkylene group having 1 to 4 carbon atoms.

Examples of the compound (C2) having a polymerizable multiple bond and an isocyanate group include the following compounds:

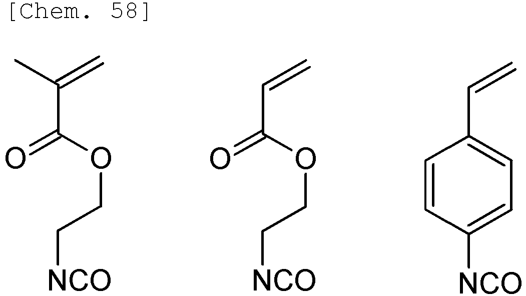

The polymer (B-1) may have a structural unit other than the structural unit represented by formula (B-1). Examples of such a structural unit include a structural unit represented by the following formula (B-12), a structural unit represented by the following formula (B-13), a structural unit represented by the following formula (B-14), and the like.

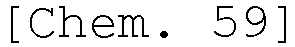

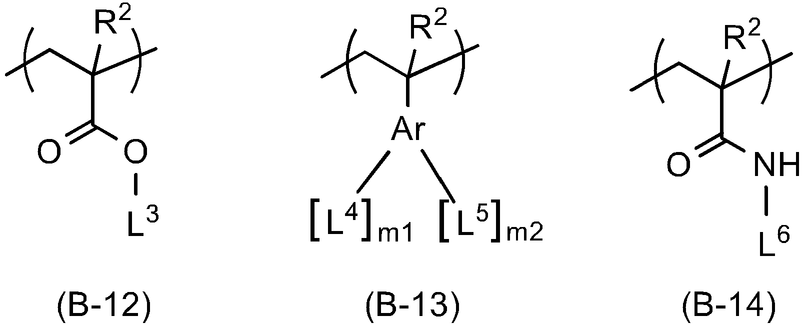

(In formula (B-12), R² represents a hydrogen atom or an alkyl group having 1 to 10 carbon atoms, and L³ represents a monovalent group having 1 to 20 carbon atoms.

In formula (B-13), R² represents a hydrogen atom or an alkyl group having 1 to 10 carbon atoms, Ar represents a benzene ring or a naphthalene ring, and L⁴ represents a hydroxy group, a cyano group, a nitro group, or an amino group (-NH₂). L⁵ represents a halogen atom, an alkyl group having 1 to 6 carbon atoms, or an alkoxy group having 1 to 6 carbon atoms. m1 represents an integer of 0 to 3; m2 represents an integer of 0 to 5; provided that the sum of m1 and m2 is 0 to 5; when m1 is 2 or 3, a plurality of L⁴s may be identical to or different from each other or one another; when m2 is 2 to 5, a plurality of L⁵s may be identical to or different from each other or one another.

In formula (B-14), R² represents a hydrogen atom or an alkyl group having 1 to 10 carbon atoms, L⁶ represents a monovalent organic group selected from an alkyl group having 1 to 10 carbon atoms and an aryl group having 6 to 40 carbon atoms, and at least one hydrogen atom of the alkyl group and the aryl group is optionally substituted with a hydroxy group or an alkoxy group having 1 to 6 carbon atoms.

The monovalent group having 1 to 20 carbon atoms of L³ in formula (B-12) represents, for example, a monovalent organic group selected from an alkyl group having 1 to 10 carbon atoms and an aryl group having 6 to 40 carbon atoms, and at least one hydrogen atom of the alkyl group and the aryl group is optionally substituted with a hydroxy group. In the alkyl group, an oxygen atom may be inserted between a carbon atom and a carbon atom.

Examples of the monovalent group having 1 to 20 carbon atoms in L³ include a group represented by the following formula (2-1): 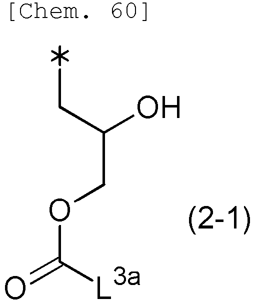 where in formula (2-1), L^{3a} represents an optionally substituted alkyl group having 1 to 6 carbon atoms or an optionally substituted aromatic hydrocarbon group.

Examples of the aromatic hydrocarbon group in L^{3a} include a phenyl group and a naphthyl group.

Examples of the substituent in the optionally substituted alkyl group having 1 to 6 carbon atoms in L^{3a} include a halogen atom and a hydroxy group. The number of substituents may be 1 or more. When a plurality of substituents is present, the plurality of substituents may be identical to or different from one another.

Examples of the substituent in the optionally substituted aromatic hydrocarbon group in L^{3a} include a halogen atom, a hydroxy group, and an alkyl group having 1 to 3 carbon atoms optionally substituted with a halogen atom. The number of substituents may be 1 or more. When a plurality of substituents is present, the plurality of substituents may be identical to or different from one another.

Specific examples of the alkyl group having 1 to 10 carbon atoms represented by R² and the alkyl group having 1 to 10 carbon atoms represented by L³ and L⁶ are as described above.

Examples of the halogen atom in L⁵ include a fluorine atom, a chlorine atom, a bromine atom, and an iodine atom.

Examples of the alkyl group having 1 to 6 carbon atoms in L⁵ include a methyl group, an ethyl group, a n-propyl group, an i-propyl group, a cyclopropyl group, a n-butyl group, and an i-butyl group.

Examples of the alkoxy group having 1 to 6 carbon atoms in L⁵ include a methoxy group, an ethoxy group, a propoxy group, and a butoxy group.
m1 represents an integer of 0 to 3, and may be 0, 1, 2, or 3.
m2 represents an integer of 0 to 5, and may be 0, 1, 2, 3, 4, or 5.

Examples of the aryl group having 6 to 40 carbon atoms represented by L³ and L⁶ include a phenyl group, an o-methylphenyl group, an m-methylphenyl group, a p-methylphenyl group, an o-chlorophenyl group, a m-chlorophenyl group, a p-chlorophenyl group, an o-fluorophenyl group, a p-fluorophenyl group, an o-methoxyphenyl group, a p-methoxyphenyl group, a p-nitrophenyl group, a p-cyanophenyl group, an α-naphthyl group, a β-naphthyl group, an o-biphenylyl group, a m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Examples of the alkoxy group having 1 to 6 carbon atoms in L⁶ include a methoxy group, an ethoxy group, a propoxy group, and a butoxy group.

Examples of the monomer used to derive formula (B-12) include the following compounds.

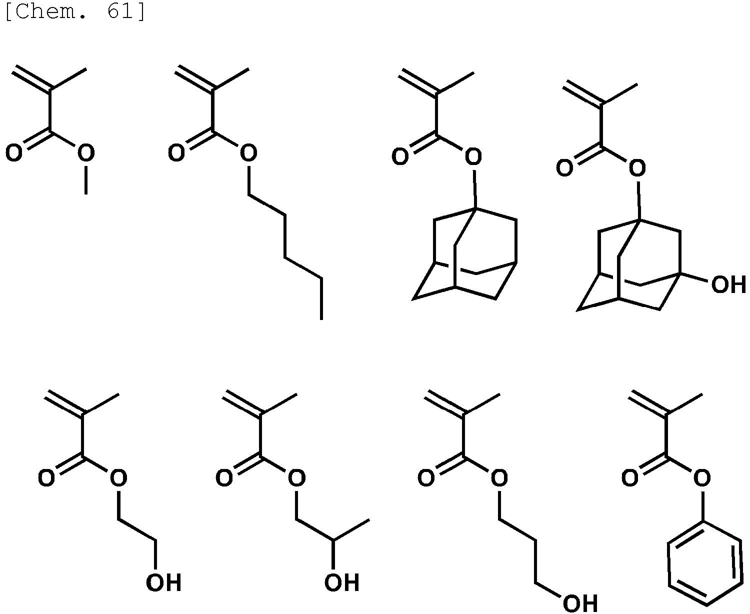

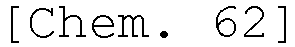

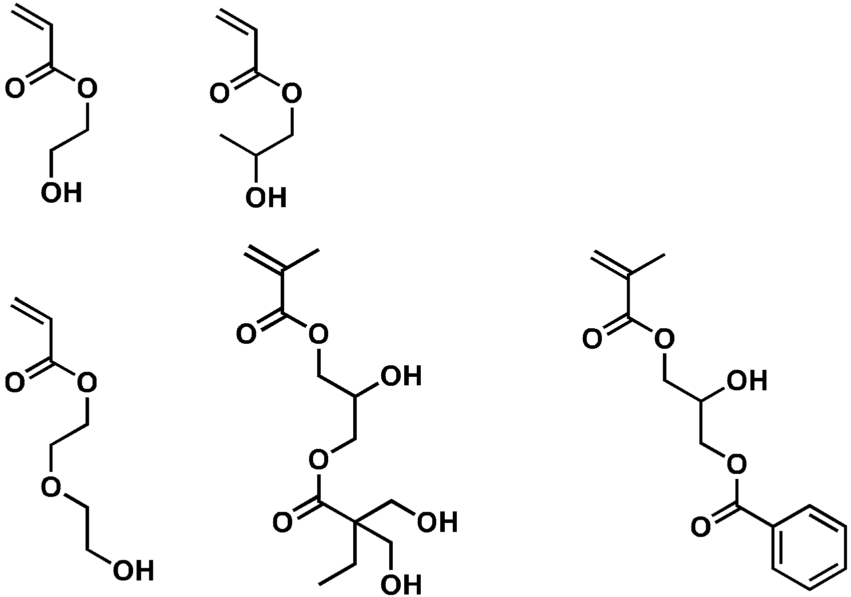

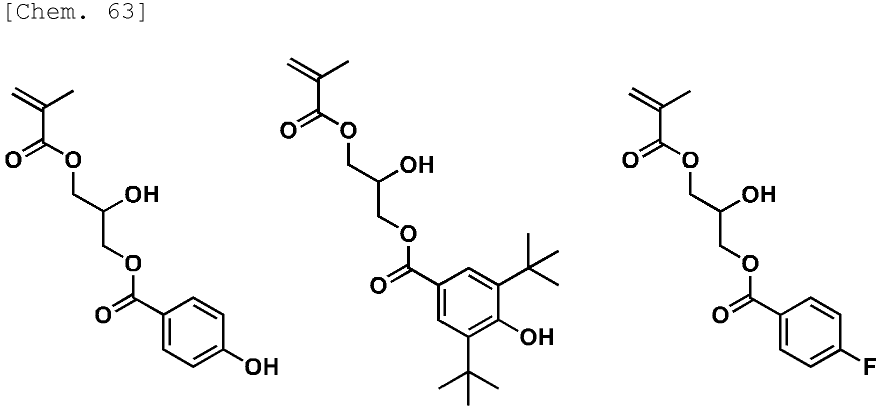

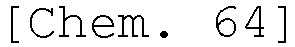

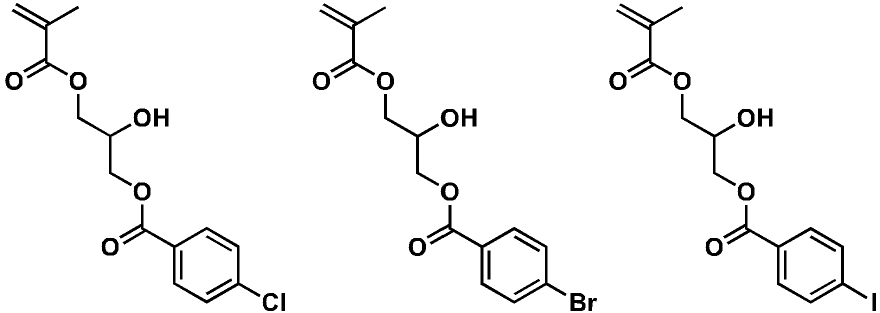

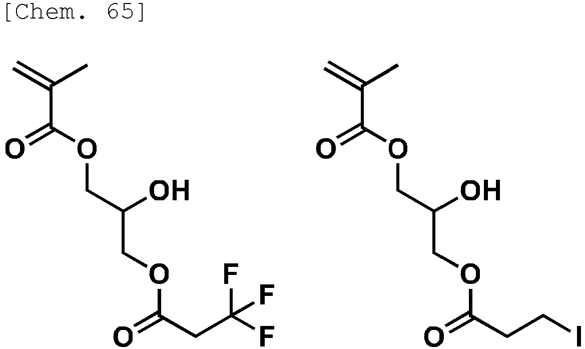

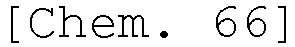

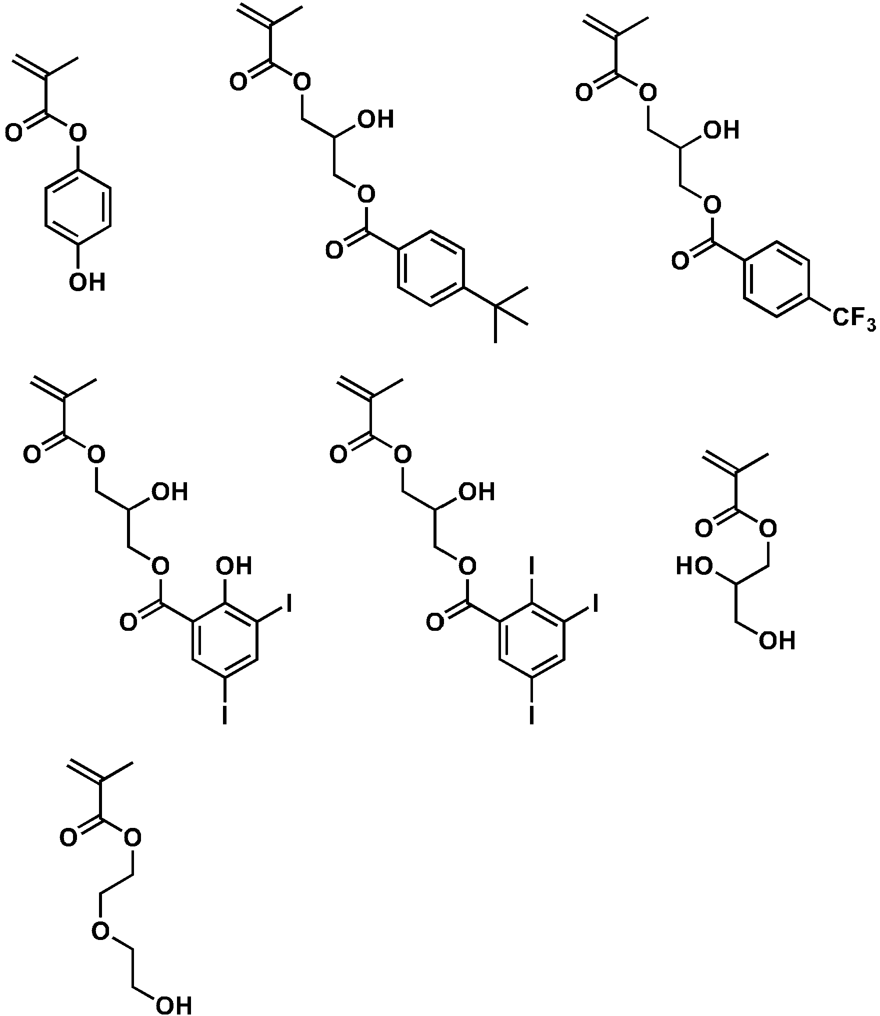

Examples of the monomer used to derive formula (B-13) include the following compounds. 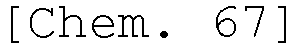 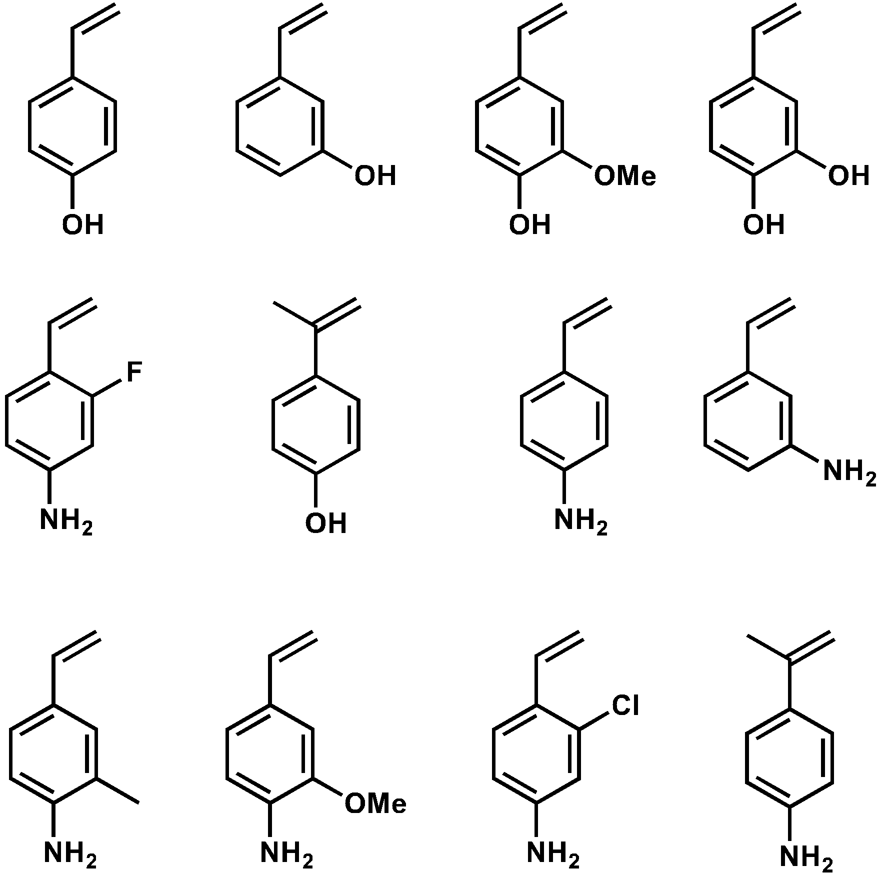 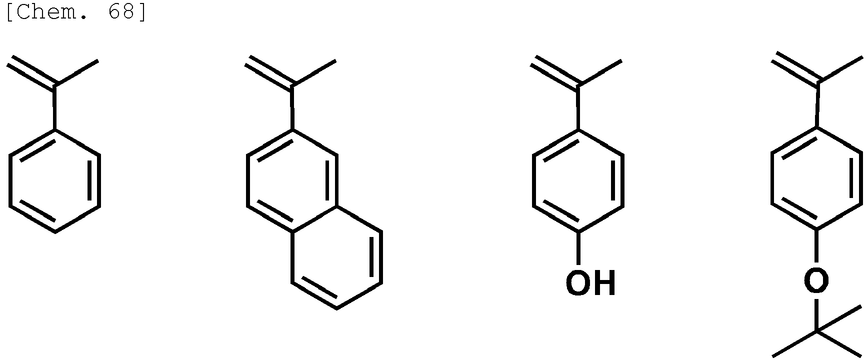 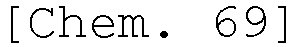 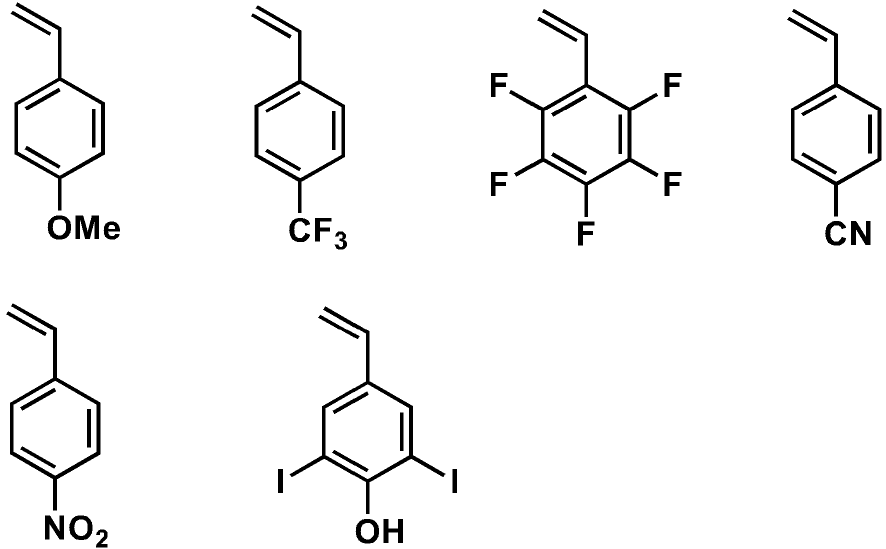 Me represents a methyl group.

Examples of the monomer used to derive formula (B-14) include the following compounds.

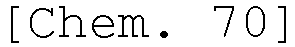

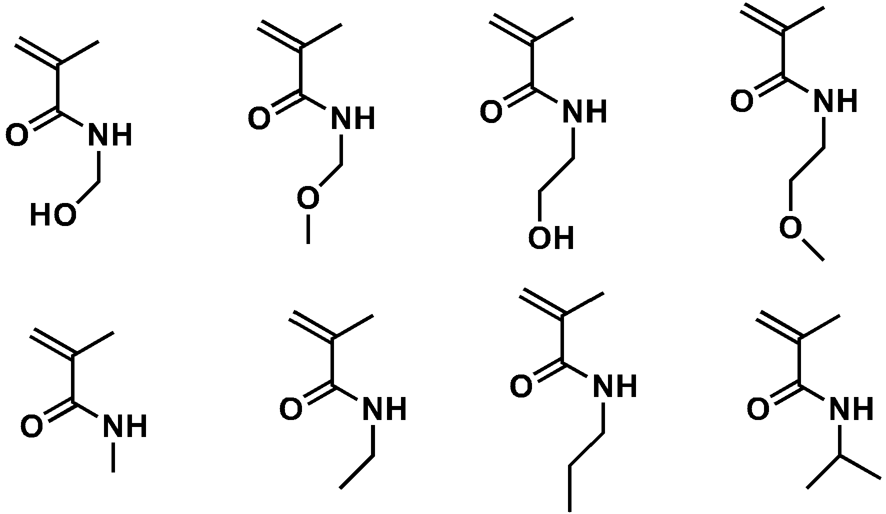

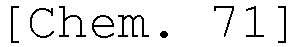

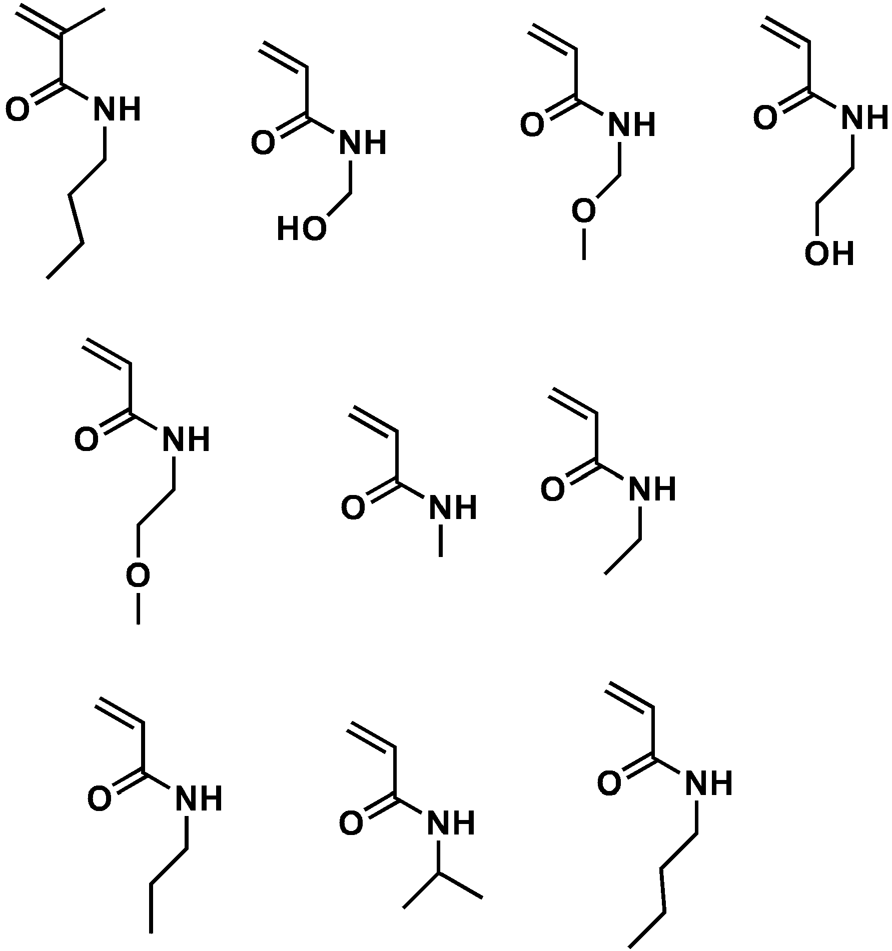

The ratio of the structural unit represented by formula (B-1) in polymer (B-1) is not particularly limited, but the molar ratio of the structural unit represented by formula (B-1) to the entire structural units of polymer (B-1) may be, for example, 20 mol% to 100 mol%, may be 40 mol% to 100 mol%, or may be 60 mol% to 100 mol%.

The ratio of the sum total (S) of the structural unit represented by formula (B-12), the structural unit represented by formula (B-13), and the structural unit represented by formula (B-14) in polymer (B-1) is not particularly limited, but the molar ratio of the sum total (S) to the total structural units of polymer (B-1) may be, for example, 0 mol% to 80 mol%, or may be more than 0 mol% and 60 mol% or less.

The polymer (B-1) may contain another structural unit other than the structural unit represented by formula (B-1), the structural unit represented by formula (B-12), the structural unit represented by formula (B-13), and the structural unit represented by formula (B-14). In that case, the molar ratio of the other structural units to the entire structural units of the polymer (B-1) is, for example, more than 0 mol% and 20 mol% or less.

### <<Polymer (B-2)>>

The polymer (B-2) has a structural unit represented by the following formula (B-2). 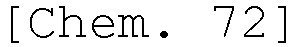 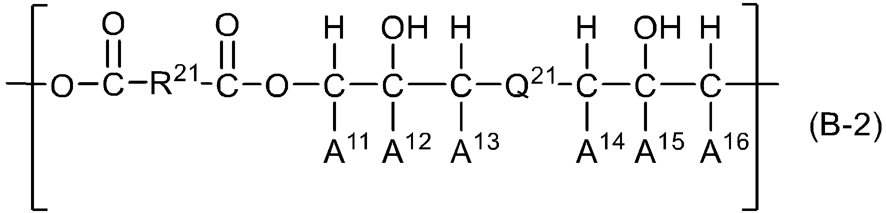 (In formula (B-2), A¹¹, A¹², A¹³, A¹⁴, A¹⁵ and A¹⁶ each independently represent a hydrogen atom, a methyl group or an ethyl group, Q²¹ is a divalent organic group. R²¹ represents a divalent group having the polymerizable multiple bond.)

Specific examples and preferable examples of Q²¹ include specific examples and preferable examples of Q in formula (A-11).

The polymerizable multiple bond of R²¹ is preferably a carbon-carbon double bond.

The number of carbon atoms of R²¹ is, for example, 2 to 10.

R²¹ may or may not have a heteroatom.

R²¹ may be a divalent hydrocarbon group.

Examples of R²¹ include the following structures. 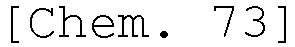 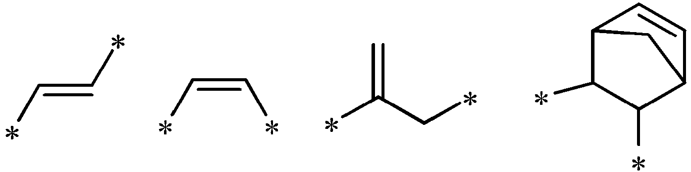 (* represents a bonding site.)

The mass ratio of the structural unit represented by formula (B-2) in the polymer (B-2) is not particularly limited, but is preferably 50% by mass to 100% by mass, more preferably 75% by mass to 100% by mass, and particularly preferably 90% by mass to 100% by mass.

The method for producing the polymer (B-2) is not particularly limited, and examples thereof include a method of reacting a dicarboxylic acid represented by the following formula (1B) with a diepoxy compound represented by the following formula (2B).

Examples of the catalyst for activating an epoxy group include a quaternary phosphonium salt such as tetrabutylphosphonium bromide or ethyltriphenylphosphonium bromide, and a quaternary ammonium salt such as benzyltriethylammonium chloride. As the amount of the catalyst used, an appropriate amount can be selected and used from the range of 0.1 to 10% by mass with respect to the total mass of the polymer raw material used in the reaction. As the temperature and the time for the polymerization reaction, for example, optimum conditions can be selected from the ranges of 80 to 160°C and 2 to 50 hours. 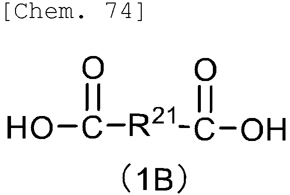 (In formula (1B), R²¹ has the same meaning as R²¹ in formula (B-2).) 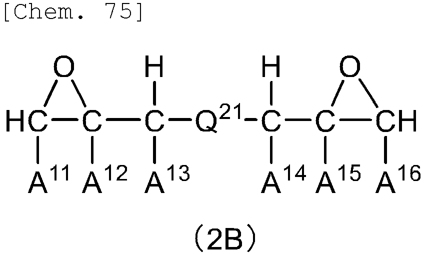 (In formula (2B), A¹¹, A¹², A¹³, A¹⁴, A¹⁵, A¹⁶ and Q²¹ have the same meanings as A¹¹, A¹², A¹³, A¹⁴, A¹⁵, A¹⁶ and Q²¹ in formula (B-2), respectively.)

The molecular weight of the polymer (B) is not particularly limited.

The lower limit of the weight average molecular weight of the polymer (B) is, for example, 500, 1,000, 2,000, or 3,000.

The upper limit of the weight average molecular weight of the polymer (B) is, for example, 100,000, 50,000, or 30,000.

The content of the polymer (B) in the resist underlayer film-forming composition is not particularly limited, but is preferably 20% by mass to 50% by mass, and more preferably 25% by mass to 45% by mass with respect to the film constituent from the viewpoint of suitably obtaining the effect of the present invention.

The mass ratio of the polymer (A) and the polymer (B) (polymer (A) : polymer (B)) is not particularly limited, but is preferably 20 : 80 to 80 : 20, more preferably 30 : 70 to 70 : 30, and particularly preferably 40 : 60 to 60 : 40 from the viewpoint of suitably obtaining the effect of the present invention.

The total content of the polymer (A) and the polymer (B) in the resist underlayer film-forming composition is not particularly limited, but from the viewpoint of suitably obtaining the effect of the present invention, it is preferably 40% by mass to 100% by mass, more preferably 50% by mass to 95% by mass, and particularly preferably 60% by mass to 90% by mass, with respect to the film constituent.

### <Solvent (C)>

The solvent (C) is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of the alkylene glycol monoalkyl ether include an alkylene group having 2 to 4 carbon atoms.

Examples of the alkyl group of the monocarboxylic acid ester of the alkylene glycol monoalkyl ether include an alkyl group having 1 to 4 carbon atoms.

Examples of the monocarboxylic acid of the monocarboxylic acid ester of the alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (C), an alkylene glycol monoalkyl ether and a monocarboxylic acid ester of an alkylene glycol monoalkyl ether are preferred.

These solvents (C) can be used singly or in combination of two or more kinds thereof.

The mass ratio of the organic solvent in the solvent (C) is not particularly limited, but is preferably 50% by mass to 100% by mass.

The content of the solvent (C) in the resist underlayer film-forming composition is not particularly limited, but is preferably 50% by mass to 99.99% by mass, more preferably 75% by mass to 99.95% by mass, and particularly preferably 90% by mass to 99.9% by mass.

### <Crosslinking agent (D)>

The crosslinking agent (D) is not particularly limited.

The crosslinking agent (D) has a structure different from those of the polymer (A) and the polymer (B).

As the crosslinking agent (D), an aminoplast crosslinking agent and a phenoplast crosslinking agent are preferable.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (D) include a compound having two or more structures shown below. 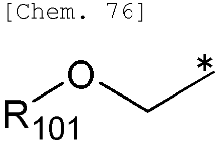 (In the structure, R₁₀₁ represents a hydrogen atom, an alkyl group having 1 to 4 carbon atoms, or an alkoxyalkyl group having 2 to 6 carbon atoms. * represents a bonding site.)

The bonding site is bonded to, for example, a nitrogen atom, a carbon atom constituting an aromatic hydrocarbon ring, or the like.

As R₁₀₁, a hydrogen atom, a methyl group, an ethyl group, or a group represented by the following structure is preferable. 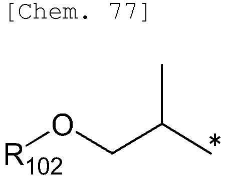 (In the structure, R₁₀₂ represents a hydrogen atom, a methyl group, or an ethyl group, and * represents a bonding site.)

The crosslinking agent (D) is preferably a melamine compound, a guanamine compound, a glycoluril compound, a urea compound, or a compound having a phenolic hydroxy group. These compounds can be used singly or in combination of two or more kinds thereof.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylolglycoluril, tetramethoxyglycoluril, tetramethoxymethylglycoluril, a compound in which 1 to 4 methylol groups of tetramethylolglycoluril are methoxymethylated or a mixture thereof, and a compound in which 1 to 4 methylol groups of tetramethylolglycoluril are acyloxymethylated or a mixture thereof.

The glycoluril compound may be, for example, a glycoluril derivative represented by following formula (1E) below. 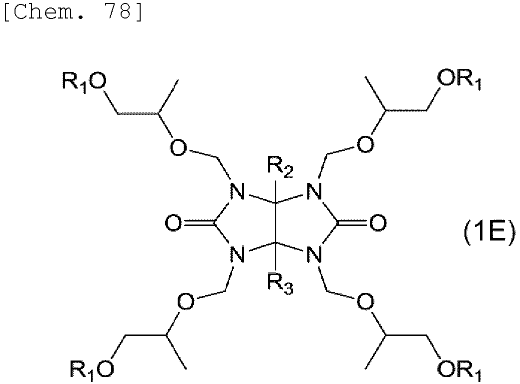 (In formula (1E), four R₁'s each independently represent a methyl group or an ethyl group, and R₂ and R₃ each independently represent a hydrogen atom, an alkyl group having 1 to 4 carbon atoms, or a phenyl group.)

Examples of the glycoluril derivative represented by the formula (1E) include compounds represented by the following formulas (1E-1) to (1E-6).

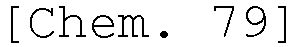

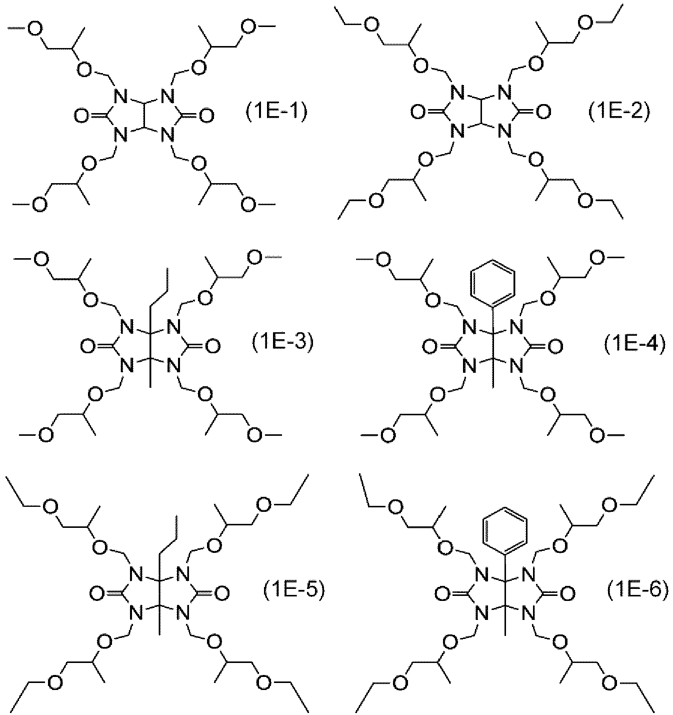

The glycoluril derivative represented by formula (1E) is obtained by, for example, reacting a glycoluril derivative represented by the following formula (2E) with at least one kind of compound represented by the following formula (3d). 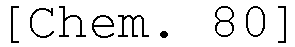 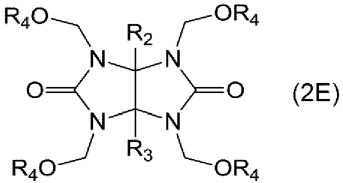 (In formula (2E), R₂ and R₃ each independently represent a hydrogen atom, an alkyl group having 1 to 4 carbon atoms, or a phenyl group, and R₄' s each independently represent an alkyl group having 1 to 4 carbon atoms.) 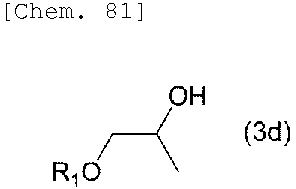 (In formula (3d), R₁ represents a methyl group or an ethyl group.)

Examples of the glycoluril derivative represented by the formula (2E) include compounds represented by the following formula (2E-1) to following formula (2E-4). Further, examples of the compound represented by the formula (3d) include compounds represented by the following formula (3d-1) and following formula (3d-2).

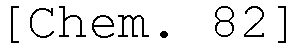

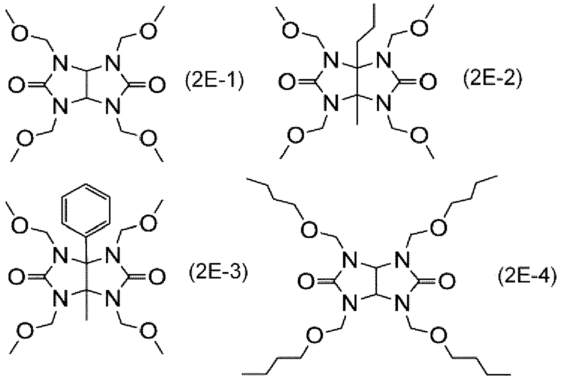

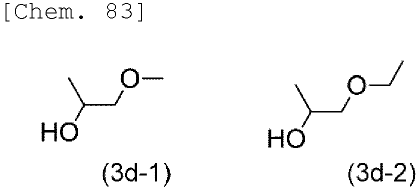

Examples of the urea compound include tetramethylolurea, tetramethoxymethylurea, a compound in which 1 to 4 methylol groups of tetramethylolurea are methoxymethylated or a mixture thereof, and tetramethoxyethylurea.

Examples of the compound having a phenolic hydroxy group include a compound represented by following formula(G-1) or (G-2) below.

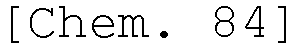

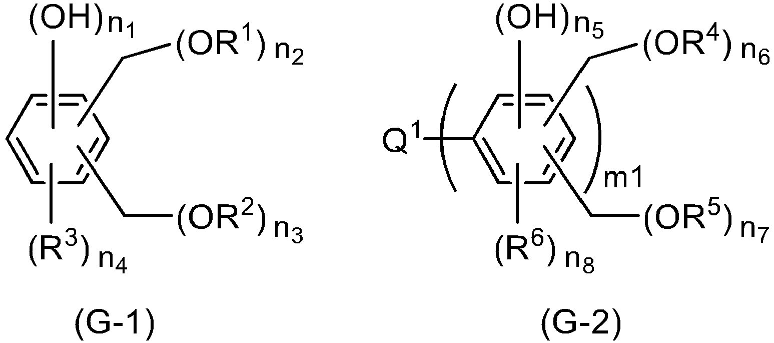

In formulas (G-1) and (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and (n₁ + n₂ + n₃ + n₄) represents an integer that meets 3 ≤ (n₁ + n₂ + n₃ + n₄) ≤ 6.

n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, n₈ represents an integer that meets 0 ≤ n₈ ≤ 3, and (n₅ + n₆ + n₇ + n₈) represents an integer that meets 2 ≤ (n₅ + n₆ + n₇ + n₈) ≤ 5.

m1 represents an integer of 2 to 10.

Examples of the compound having a phenolic hydroxy group include a compound represented by following formula(G-3) or (G-4) below.

The compound represented by formula (G-1) or formula (G-2) may be obtained by a reaction of a compound represented by following formula(G-3) or formula (G-4) below with a hydroxyl group-containing ether compound or an alcohol having 2 to 10 carbon atoms.

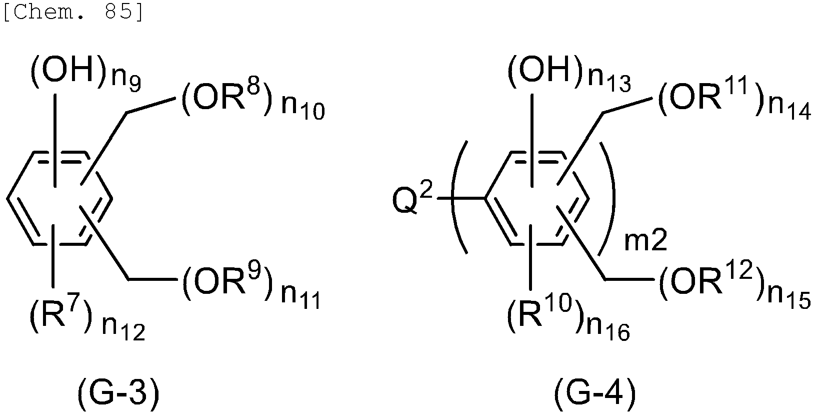

In formula (G-3) and formula (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that satisfies 1 ≤ n₉ ≤ 3, n₁₀ represents an integer that satisfies 2 ≤ n₁₀ ≤ 5, n₁₁ represents an integer that satisfies 0 ≤ n₁₁ ≤ 3, n₁₂ represents an integer that satisfies 0 ≤ n₁₂ ≤ 3, and (n₉ + n₁₀ + n₁₁ + n₁₂) represents an integer that satisfies 3 ≤ (ng + n₁₀ + n₁₁ + n₁₂) ≤ 6.

n₁₃ represents an integer that satisfies 1 ≤ n₁₃ ≤ 3, n₁₄ represents an integer that satisfies 1 ≤ n₁₄ ≤ 4, n₁₅ represents an integer that satisfies 0 ≤ n₁₅ ≤ 3, and n₁₆ represents an integer that satisfies 0 ≤ n₁₆ ≤ 3, and (n₁₃ + n₁₄ + n₁₅ + n₁₆) represents an integer that satisfies 2 ≤ (n₁₃ + n₁₄ + n₁₅ + n₁₆) ≤ 5.

m2 represents an integer of 2 to 10.)

Examples of the m2-valent organic group of Q² include an m2-valent organic group having 1 to 4 carbon atoms.

Examples of the compound represented by formula (G-1) or formula (G-2) include the following compounds.

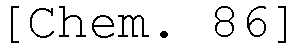

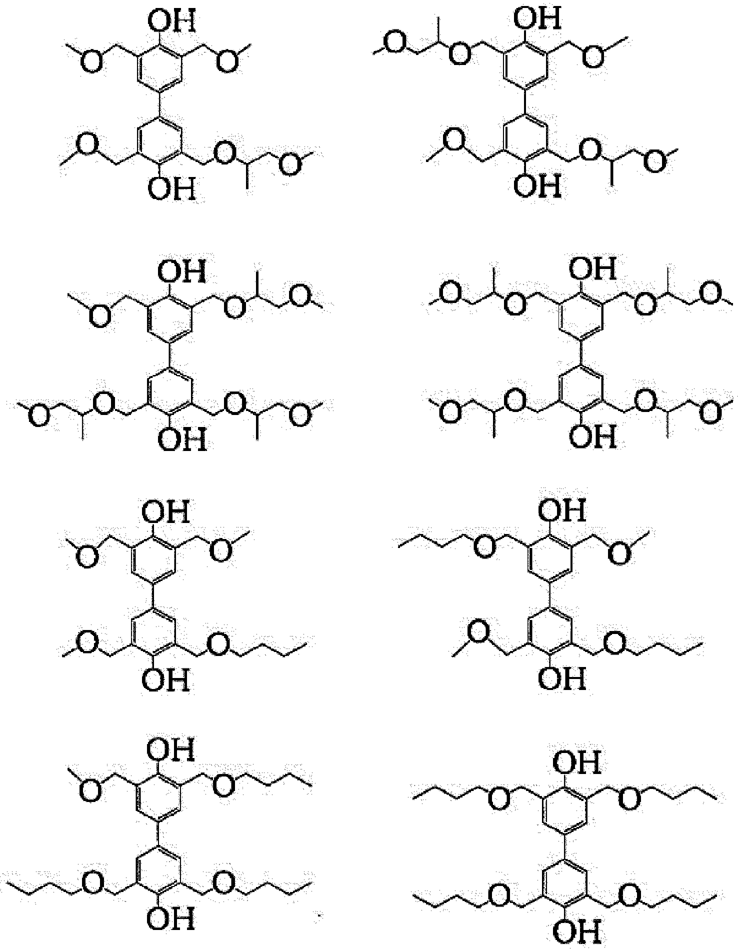

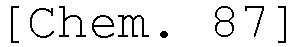

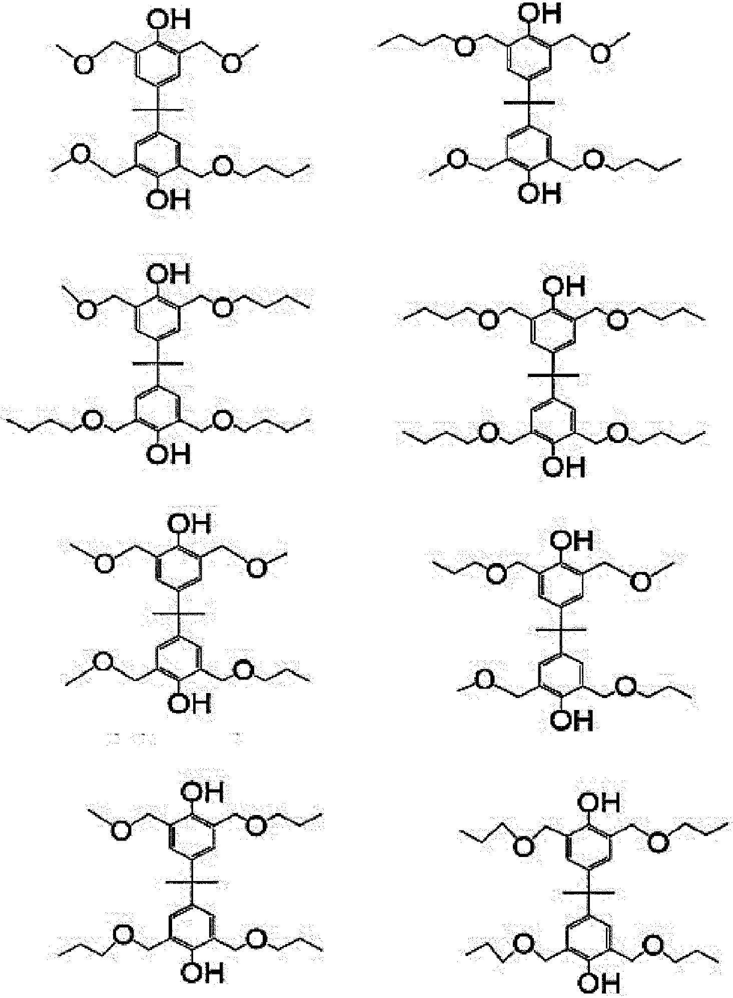

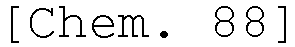

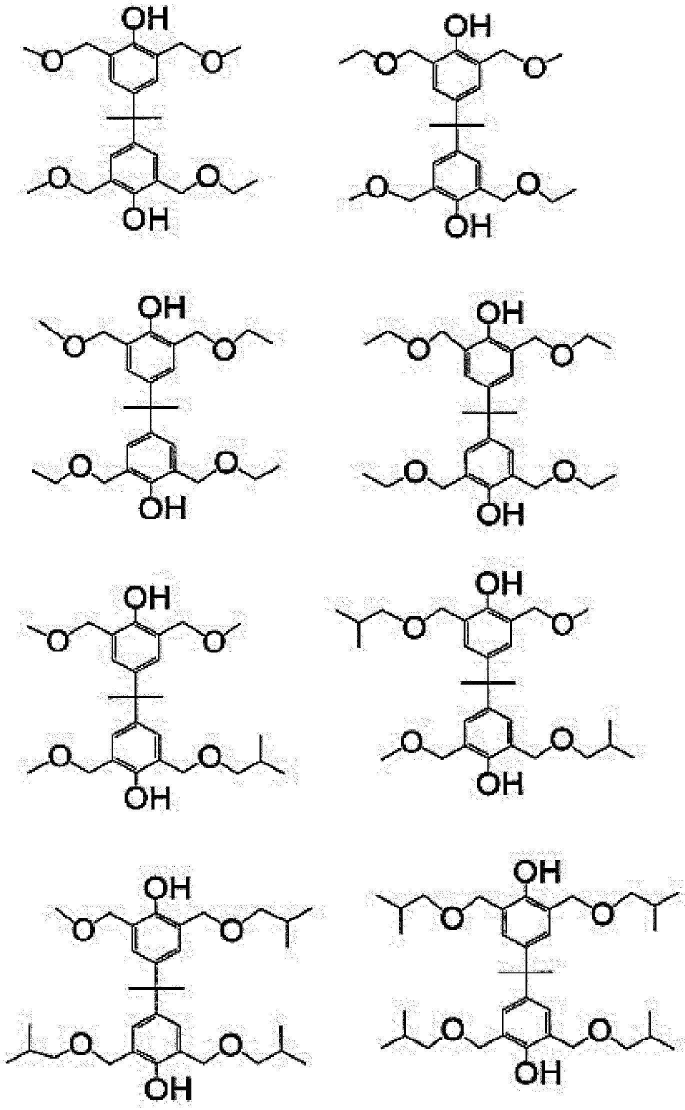

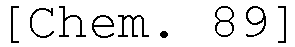

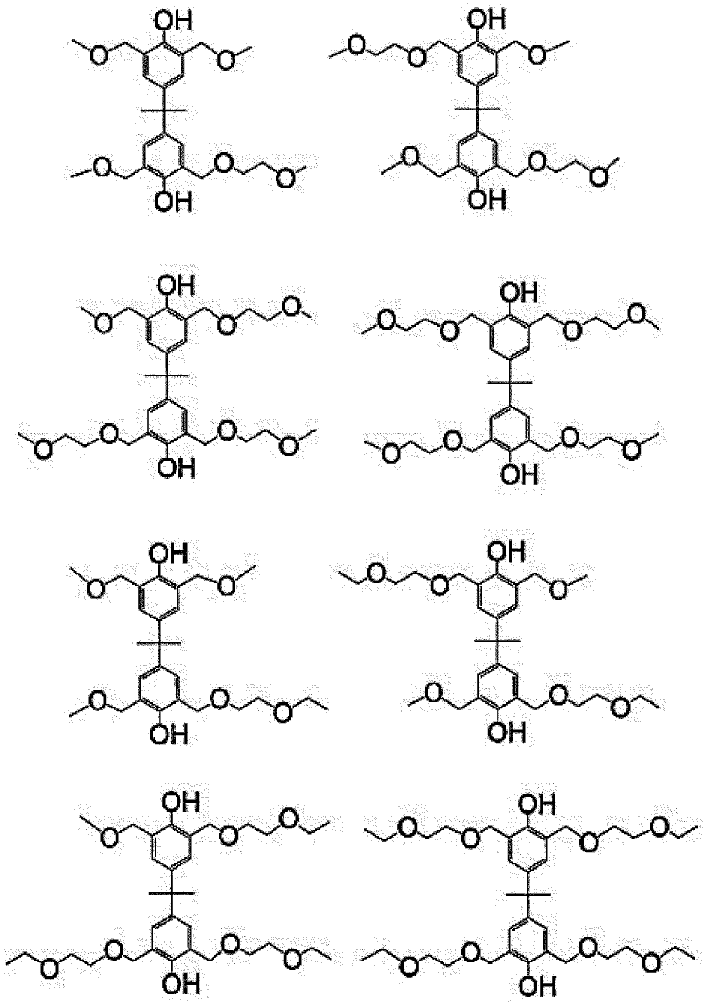

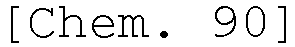

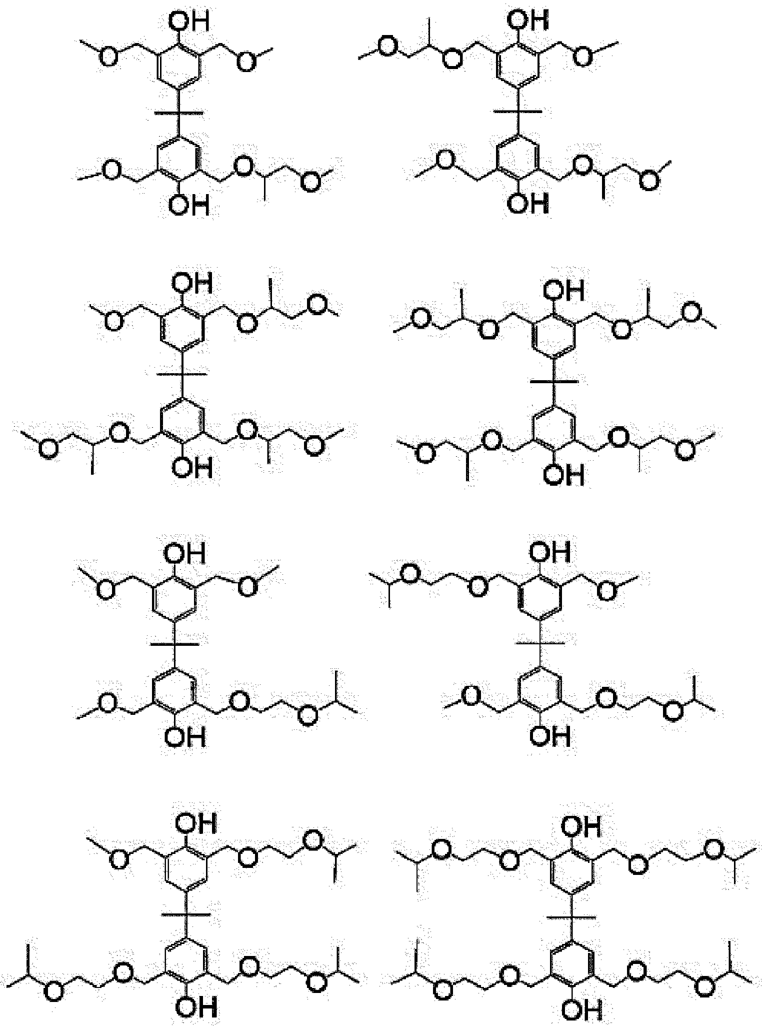

Examples of the compound represented by formula (G-3) or formula (G-4) include the following compounds.

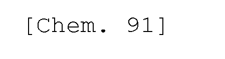

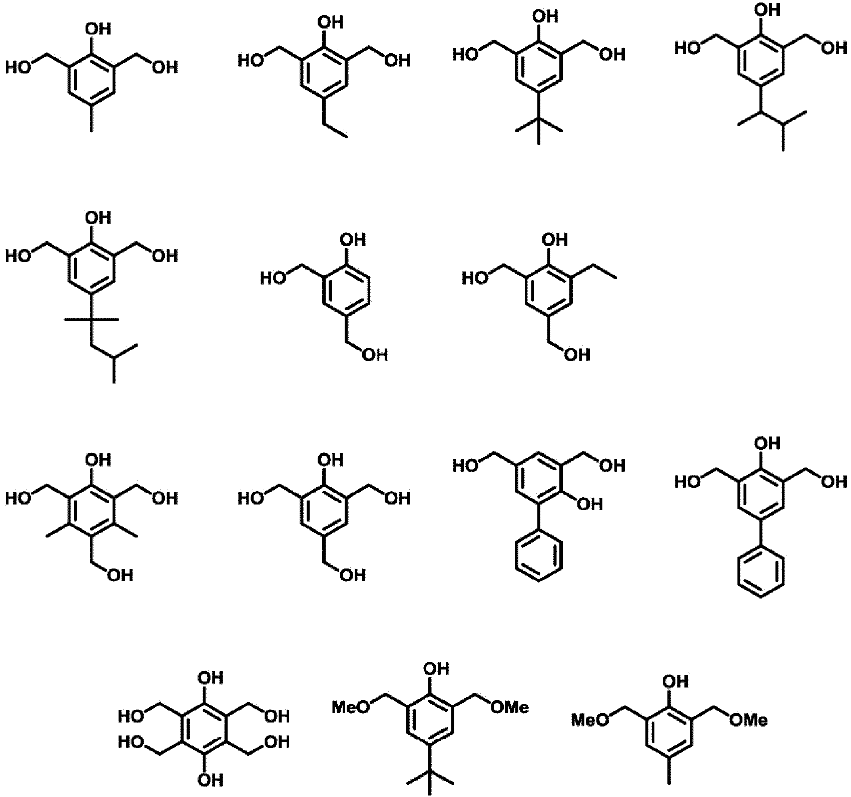

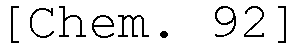

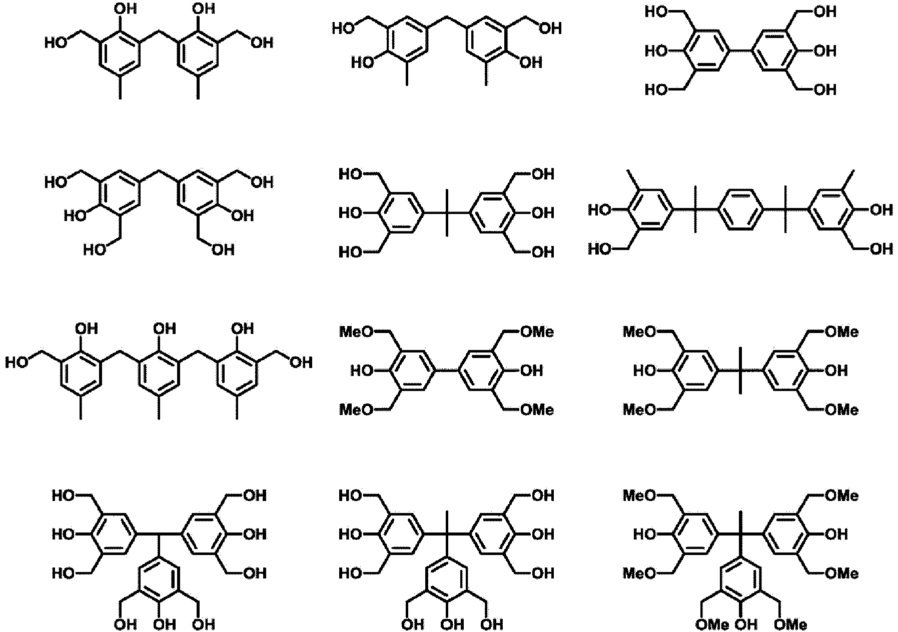

The compounds can be obtained as products of Asahi Organic Chemicals Industry Co., Ltd. and Honshu Chemical Industry Co., Ltd. Examples of the product include TMOM-BP (trade name) manufactured by Asahi Organic Chemicals Industry Co., Ltd.

Among the compounds, the glycoluril compound is preferred. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferred, and tetramethoxymethyl glycoluril is more preferred.

The molecular weight of the crosslinking agent (D) is not particularly limited, and is preferably 500 or less.

The content of the crosslinking agent (D) in the resist underlayer film-forming composition is not particularly limited, but is, for example, 1% by mass to 70% by mass, preferably 5% by mass to 60% by mass, with respect to the total of the polymer (A) and the polymer (B).

### <Curing catalyst (E)>

As the curing catalyst (E) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenolsulfonate, pyridinium p-hydroxybenzenesulfonate (p-phenolsulfonic acid pyridinium salt), pyridinium-trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine-p-toluenesulfonate, N-methylmorpholine-p-hydroxybenzenesulfonate, and N-methylmorpholine-5-sulfosalicylate.

Examples of the photoacid generator include an onium salt compound, a sulfonimide compound, and a disulfonyldiazomethane compound.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate, and the like.

Examples of the sulfonimide compound include N-(trifluoromethanesulfonyloxy)succinimide, N-(nonafluoro normal butane sulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, methylsulfonyl-p-toluenesulfonyl diazomethane, and the like.

As the curing catalyst (E), only one kind can be used, or two or more kinds can be used in combination.

When the curing catalyst (E) is used, the content ratio of the curing catalyst (E) is, for example, 0.1% by mass to 50% by mass, preferably 1% by mass to 30% by mass with respect to the crosslinking agent (D).

### <Other components>

To the resist underlayer film-forming composition, a surfactant can be further added in order to further improve the application property against surface unevenness without generating a pinhole, a striation, and the like.

Examples of the surfactant include linear or branched alkylbenzenesulfonic acids (such as dodecylbenzenesulfonic acid); polyoxyethylene alkyl ethers such as polyoxyethylene lauryl ether, polyoxyethylene stearyl ether, polyoxyethylene cetyl ether, and polyoxyethylene oleyl ether; polyoxyethylene alkyl aryl ethers such as polyoxyethylene octylphenol ether and polyoxyethylene nonylphenol ether; polyoxyethylene/polyoxypropylene block copolymers; sorbitan fatty acid esters such as sorbitan monolaurate, sorbitan monopalmitate, sorbitan monostearate, sorbitan monooleate, sorbitan trioleate, and sorbitan tristearate; nonionic surfactants of polyoxyethylene sorbitan fatty acid esters and the like such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate; fluorine-based surfactants such as EFTOP EF301, EF303, and EF352 (manufactured by TOHKEM PRODUCTS Corporation, trade names); MEGAFACE F171, F173, and R-30 (manufactured by DIC Corporation, trade names); Fluorad FC430 and FC431 (manufactured by Sumitomo 3M Limited, trade names); AsahiGuard AG710 and Surflon S-382, SC101, SC102, SC103, SC104, SC105, and SC106 (manufactured by AGC Corporation, trade names); and organosiloxane polymer KP341 (manufactured by Shin-Etsu Chemical Co., Ltd.).

The blending amount of such a surfactant is usually 2.0% by mass or less, and preferably 1.0% by mass or less with respect to the total solid content of the resist underlayer film-forming composition.

These surfactants may be added alone, or two or more kinds thereof can also be added in combination.

The resist underlayer film-forming composition may contain a polymerization inhibitor (radical trapping agent) as necessary. Examples of the polymerization inhibitor include 2,6-diisobutylphenol, 3,5-di-tert-butylphenol, 3,5-di-tert-butylcresol, hydroquinone, hydroquinone monomethyl ether, pyrogallol, tert-butylcatechol, and 4-methoxy-1-naphthol.

The content of the polymerization inhibitor in the resist underlayer film-forming composition is not particularly limited, but is preferably 1% by mass or less with respect to the solid content.

The amount of the solid content in the resist underlayer film-forming composition of the present invention, that is, the components excluding the solvent is, for example, 0.01% by mass to 10% by mass.

The resist underlayer film-forming composition is preferably used for EUV lithography.

The resist underlayer film-forming composition is preferably used for forming an underlayer film of a metal-containing resist.

### (Resist underlayer film)

The resist underlayer film of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

In the case of using the semiconductor substrate having a surface on which an inorganic film is formed, the inorganic film is formed by, for example, an atomic layer deposition (ALD) method, a chemical vapor deposition (CVD) method, a reactive sputtering method, an ion plating method, a vacuum deposition method, or a spin coating method (spin-on-glass, SOG). Examples of the inorganic film include a polysilicon film, a silicon oxide film, a silicon nitride film, a boro-phospho silicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate with an appropriate application method using a spinner, a coater, or the like. Thereafter, baking is performed using a heating unit such as a hot plate to form a resist underlayer film. The baking conditions are appropriately selected from a baking temperature of 100°C to 400°C and a baking time of 0.3 minutes to 60 minutes. Preferably, the baking temperature is 120°C to 350°C and the baking time is 0.5 minutes to 30 minutes. More preferably, the baking temperature is 150°C to 300°C and the baking time is 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring the film thickness of the resist underlayer film in the present description is as follows.
· Measurement device name: Ellipsometric film thickness measurement device RE-3100 (SCREEN Holdings Co., Ltd.)
· Single wavelength ellipsometer (SWE) mode
· Arithmetic average of measurements at 8 points (for example, measurement is made at 8 points at intervals of 1 cm in X direction of wafer)

### (Laminate)

A laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Semiconductor element producing method and pattern forming method)

The semiconductor element producing method of the present invention includes at least the following steps.
· a step of forming a resist underlayer film on a semiconductor substrate using the resist underlayer film-forming composition of the present invention, and
· a step of forming a resist film on the resist underlayer film

The pattern forming method of the present invention includes at least the following steps.
· a step of forming a resist underlayer film on a semiconductor substrate using the resist underlayer film-forming composition of the present invention,
· a step of forming a resist film on the resist underlayer film.
· a step of irradiating the resist film with light or an electron beam, and then developing the resist film to obtain a resist pattern, and
· a step of etching the resist underlayer film using the resist pattern as a mask

The resist film is usually formed on the resist underlayer film.

The film thickness of the resist film is, for example, 3,000 nm or less, 2,000 nm or less, 1,800 nm or less, 1,500 nm or less, or 1,000 nm or less. The lower limit is 100 nm, 80 nm, 50 nm, 30 nm, 20 nm, or 10 nm.

The resist film formed on the resist underlayer film by a known method (for example, application and baking of a resist composition) is not particularly limited as long as it responds to light or an electron beam (EB) used for irradiation. Both a negative photoresist and a positive photoresist can be used.

In the present description, a resist that responds to an EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

In addition, so-called resist compositions such as resist compositions described in WO2019/188595, WO2019/187881, WO2019/187803, WO2019/167737, WO2019/167725, WO2019/187445, WO2019/167419, WO2019/123842, WO2019/054282, WO2019/058945, WO2019/058890, WO2019/039290, WO2019/044259, WO2019/044231, WO2019/026549, WO2018/193954, WO2019/172054, WO2019/021975, WO2018/230334, WO2018/194123, JP 2018-180525 A, WO2018/190088, JP 2018-070596, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO2018/031896, JP 2019-113855 A, WO2017/156388, WO2017/066319, JP 2018-41099 A, WO2016/065120, WO2015/026482, JP 2016-29498 A, and JP 2011-253185 A, radiation-sensitive resin compositions, high-resolution patterning compositions based on organometallic solutions, and metal-containing resist compositions can be used, but are not limited to these.

Examples of the resist composition include the following compositions.

An actinic ray-sensitive or radiation-sensitive resin composition containing a resin A having a repeating unit having an acid-decomposable group in which a polar group is protected by a protecting group to be removed by an action of an acid, and a compound represented by general formula (121) below. 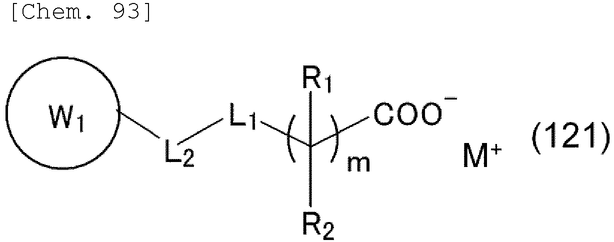 In general formula (121), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent, or a single bond.

W₁ represents a cyclic organic group which may have a substituent.

M⁺ represents a cation.

A metal-containing film-forming composition for extreme ultraviolet or electron beam lithography, containing a compound having a metal-oxygen covalent bond and a solvent, in which metal elements constituting the compound belong to periods 3 to 7 of groups 3 to 15 in the periodic table.

A radiation-sensitive resin composition that contains a polymer having a first structural unit represented by following formula (31) below and a second structural unit represented by following formula (32) below and having an acid-dissociable group, and that contains an acid generator. 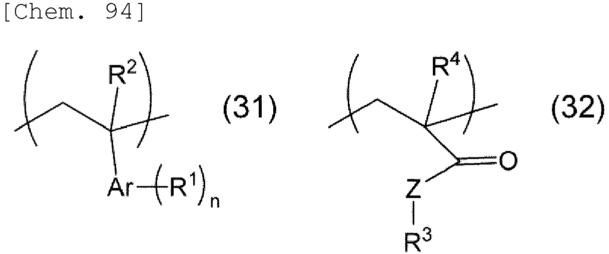 (In formula (31), Ar is a group obtained by removing (n + 1) hydrogen atoms from an arene having 6 to 20 carbon atoms. R¹ is a hydroxy group, a sulfanyl group, or a monovalent organic group having 1 to 20 carbon atoms. n is an integer of 0 to 11. when n is 2 or more, a plurality of R^{1'}s are identical or different. R² is a hydrogen atom, a fluorine atom, a methyl group, or a trifluoromethyl group. In formula (32), R³ is a monovalent group having 1 to 20 carbon atoms and having the acid-dissociable group. Z is a single bond, an oxygen atom, or a sulfur atom. R⁴ is a hydrogen atom, a fluorine atom, a methyl group, or a trifluoromethyl group.)

A resist composition that contains a resin (A1) having a structural unit having a cyclic carbonate structure, a structural unit represented by the following formula, and a structural unit having an acid-unstable group, and that contains an acid generator.

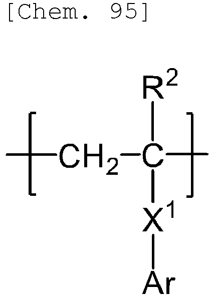

In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bonding site with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxy group.

Examples of the resist film include the following resist film.

A resist film containing a base resin having a repeating unit represented by the following formula (a1) and/or a repeating unit represented by the following formula (a2), and a repeating unit that generates an acid bonded to a polymer main chain by exposure. 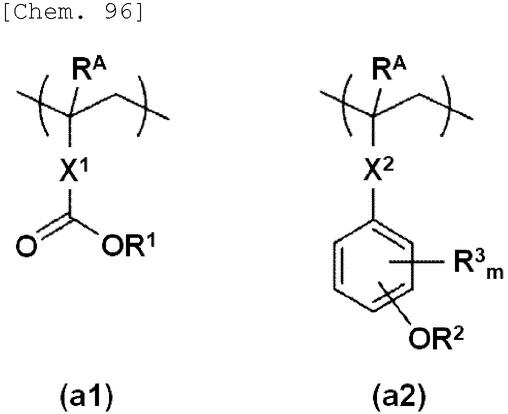 (In formula (a1) and formula (a2), R^{A}'s are each independently a hydrogen atom or a methyl group. R¹ and R² are each independently a tertiary alkyl group having 4 to 6 carbon atoms. R³'s are each independently a fluorine atom or a methyl group. m is an integer of 0 to 4. X¹ is a single bond, a phenylene group, a naphthylene group, or a linking group having 1 to 12 carbon atoms and containing at least one kind selected from an ester bond, a lactone ring, a phenylene group, and a naphthylene group. X² is a single bond, an ester bond, or an amide bond.)

Examples of the resist material include the following.

A resist material containing a polymer having a repeating unit represented by formula (b1) or following formula (b2). 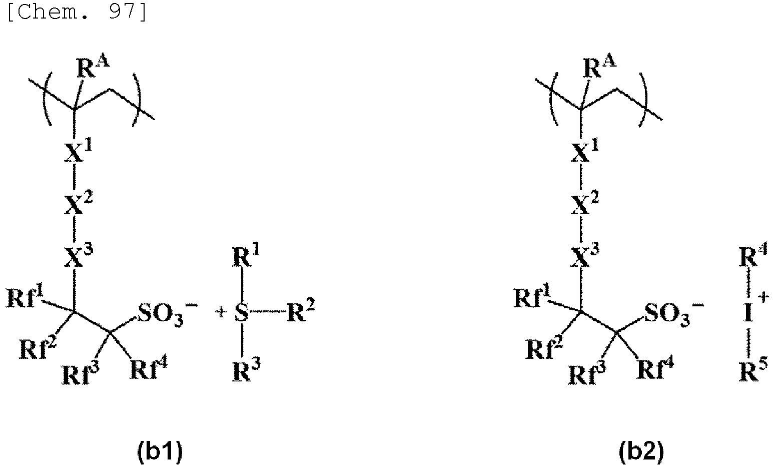 (In formula (b1) and formula (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups constituting the alkylene group may be substituted with an ether group, an ester group, or a lactone ring-containing group, and at least one hydrogen atom contained in X² is substituted with a bromine atom, X³ is a single bond, an ether group, an ester group, or a linear, branched, or cyclic alkylene group having 1 to 12 carbon atoms, and some of the methylene groups constituting the alkylene group are optionally substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxyl group, a halogen atom, an oxo group, a cyano group, an amide group, a nitro group, a sultone group, a sulfone group, or a sulfonium salt-containing group, and some of the methylene groups constituting these groups may be substituted with an ether group, an ester group, a carbonyl group, a carbonate group, or a sulfonic acid ester group. R¹ and R² may be bonded to form a ring together with a sulfur atom to which R¹ and R² are bonded.)

A resist material containing a base resin containing a polymer having a repeating unit represented by the following formula (a). 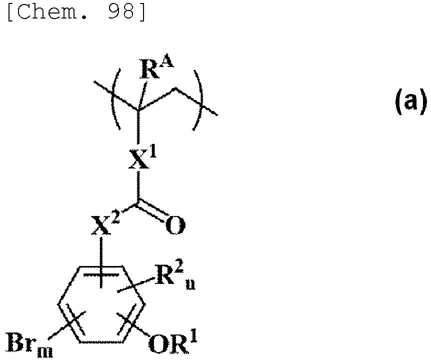 (In formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may have an ester group or a lactone ring, X² is -O-, -O-CH₂-, or -NH-, m is an integer of 1 to 4, and u is an integer of 0 to 3, provided that m + u is an integer of 1 to 4.)

A resist composition which generates an acid by exposure and of which solubility in a developer is changed by an action of the acid, the resist composition containing:
a base material component (A) of which solubility in a developer is changed by an action of an acid and a fluorine additive component (F) which exhibits decomposability in an alkaline developer, in which
the fluorine additive component (F) contains a fluororesin component (F1) having a constituent unit (f1) having a base dissociable group and a constituent unit (f2) having a group represented by the following general formula (f2-r-1). 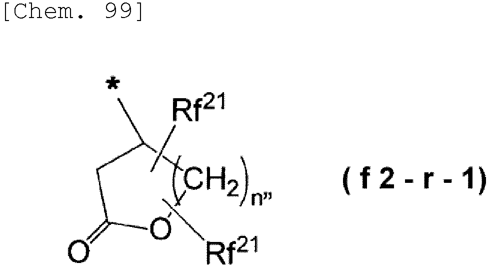
[in formula (f2-r-1), Rf²¹'s each independently are a hydrogen atom, an alkyl group, an alkoxy group, a hydroxy group, a hydroxyalkyl group, or a cyano group, n" is an integer of 0 to 2, and * is a bonding site.]

The constituent unit (f1) has a constituent unit represented by the following general formula (f1-1) or a constituent unit represented by the following general formula (f1-2). 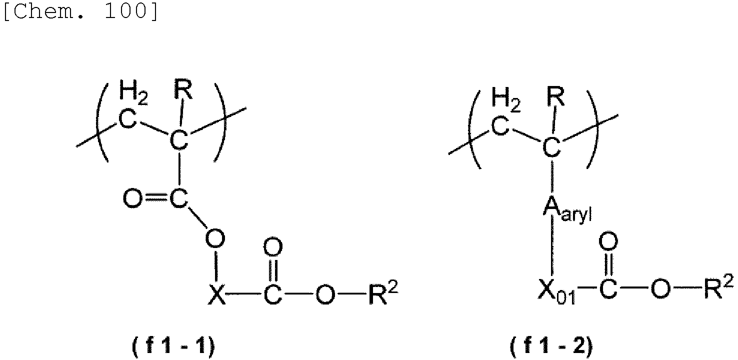 [In formulas (f1-1) and (f1-2), R's are each independently a hydrogen atom, an alkyl group having 1 to 5 carbon atoms, or a haloalkyl group having 1 to 5 carbon atoms, X is a divalent linking group not having an acid-dissociable site, A_{aryl} is a divalent aromatic ring group which may have a substituent, X₀₁ is a single bond or a divalent linking group, and R²'s each independently are an organic group having a fluorine atom.]

The resist composition may be a metal-containing resist.

The metal-containing resist is also called a metal oxide resist (metal oxide resist (MOR)), and typical examples thereof include a tin oxide-based resist.

The material of the metal oxide resist is, for example, a coating composition described in JP 2019-113855 A, containing a metal oxo-hydroxo network having an organic ligand through a metal carbon bond and/or a metal carboxylate bond.

In an example of the metal-containing resist, a peroxo ligand is used as a radiation-sensitive stabilizing ligand. Details of the peroxo based metal oxo-hydroxo compounds are described, for example, in paragraph[0011] of JP 2019-532489 A: Patent Literature. Examples of the Patent Literature include US 9,176,377 B2, US 2013/0224652 A1, US 9,310,684 B2, US 2016/0116839 A1, and US 15/291738 A.

A coating containing a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (where 0 < z ≤ 2 and 0 < (z + x) ≤ 4), the formula R'ₙSnX₄₋ₙ (where n = 1 or 2), or a mixture thereof, wherein R and R' are independently a hydrocarbyl group having 1 to 31 carbon atoms, and X is a ligand having a hydrolyzable bond to Sn or a combination thereof; and a hydrolyzable metal compound represented by the formula MX'ᵥ (wherein M is a metal selected from groups 2 to 16 in the element periodic table, "v" is a number satisfying v = 2 to 6, and X' is a ligand having a hydrolyzable M-X bond or a combination thereof).

A coating solution containing an organic solvent and a first organometallic compound represented by the formula RSnO_{(3/2-x/2)}(OH)ₓ (where 0 < x < 3), in which the solution contains from about 0.0025 M to about 1.5 M of tin, R is an alkyl group or a cycloalkyl group having 3 to 31 carbon atoms, and the alkyl group or cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Other examples of the metal-containing resist include compositions described in JP 2011-253185 A, WO 2015/026482 A, WO 2016/065120 A, WO 2017/066319 A, WO 2017/156388 A, WO 2018/031896 A, JP 2020-122959 A, JP 2020-122960 A, WO 2019/099981 A, WO 2019/199467 A, WO 2019/195522 A, WO 2019/195522 A, WO 2020/210660 A, WO 2021/011367 A, and WO 2021/016229 A.

These contents are incorporated herein to the same extent as all the contents are specified.

The method for forming the metal-containing resist film from the metal-containing resist is not particularly limited, and examples thereof include a method in which a coating-type resist material (metal-containing resist film-forming composition) as the metal-containing resist is applied and baked.

The metal-containing resist film may be formed by vapor deposition. The method for forming the metal-containing resist film by vapor deposition is, for example, a method described in JP 2017-116923 A. The contents of JP 2017-116923 A are incorporated herein to the same extent as all the contents are specified. In JP 2017-116923 A, the metal-containing resist film in the present invention is referred to as a metal oxide-containing film.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) or extreme ultraviolet (EUV: 13.5 nm) irradiation, and more preferably applied for extreme ultraviolet (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

For the development, for example, an alkaline developer or an organic solvent is used.

The developing temperature is, for example, 5°C to 50°C.

The developing time is, for example, 10 seconds to 300 seconds.

As the alkaline developer, for example, an aqueous solution of an alkali such as an inorganic alkali (for example, sodium hydroxide, potassium hydroxide, sodium carbonate, sodium silicate, sodium metasilicate, or ammonia water), a primary amine (for example, ethylamine or n-propylamine), a secondary amine (for example, diethylamine or di-n-butylamine), a tertiary amine (for example, triethylamine or methyldiethylamine), an alcoholamine (for example, dimethylethanolamine or triethanolamine), a quaternary ammonium salt (for example, tetramethylammonium hydroxide, tetraethylammonium hydroxide, or choline), or a cyclic amine (for example, pyrrole or piperidine) can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferable, and an aqueous solution of tetramethylammonium hydroxide and an aqueous solution of choline are more preferable. Furthermore, a surfactant or the like may be added to these developers. It is also possible to use a method in which development is performed with an organic solvent such as butyl acetate in place of the alkaline developer and a portion where the alkali dissolution rate of the photoresist is not improved is developed.

An organic solvent can be used as a developer of the metal-containing resist, and development is performed with the developer (solvent) after irradiation with light or an electron beam. As a result, for example, when a metal-containing negative resist film is used, the metal-containing resist film in an unexposed portion is removed, and a pattern of the metal-containing resist film is formed.

Examples of the developer (organic solvent) include methyl acetate, butyl acetate, ethyl acetate, isopropyl acetate, amyl acetate, isoamyl acetate, ethyl methoxyacetate, ethyl ethoxyacetate, propylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monopropyl ether acetate, diethylene glycol monoethyl ether acetate, diethylene glycol monophenyl ether acetate, diethylene glycol monobutyl ether acetate, diethylene glycol monoethyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, butyl formate, propyl formate, ethyl lactate, butyl lactate, propyl lactate, ethyl carbonate, propyl carbonate, butyl carbonate, methyl pyruvate, ethyl pyruvate, propyl pyruvate, butyl pyruvate, methyl acetoacetate, ethyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, and propyl-3-methoxypropionate. Furthermore, a surfactant or the like may be added to these developers.

Subsequently, the resist underlayer film is etched using the formed resist pattern as a mask. The etching may be dry etching or wet etching, but is preferably dry etching.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Next, the contents of the present invention will be specifically described with reference to Examples, but the present invention is not limited thereto.

The weight-average molecular weight of each polymer illustrated in following Synthesis Examples 1 to 9 is a measurement result by gel permeation chromatography (hereinafter, abbreviated as GPC). In the measurement, a GPC apparatus manufactured by Tosoh Corporation was used, and measurement conditions and the like are as follows:
GPC column: Shodex KF803L, Shodex KF802, Shodex KF801 [registered trademark] (Showa Denko K.K.)
Column temperature: 40°C
Solvent: N,N-dimethylformamide (DMF)
Flow amount: 0.6 ml/min
Standard sample: Polystyrene (manufactured by Tosoh Corporation)

### <Synthesis Example 1>

To 56.00 g of propylene glycol monomethyl ether in a reaction vessel, 8.00 g of monoallyl diglycidyl isocyanuric acid (manufactured by SHIKOKU KASEI HOLDINGS CORPORATION), 5.45 g of diethylbarbituric acid (manufactured by Tokyo Chemical Industry Co., Ltd.) and 0.48 g of tetrabutylphosphonium bromide (manufactured by HOKKO CHEMICAL INDUSTRY CO., LTD.) were added and dissolved. After the reaction vessel was purged with nitrogen, the reaction was carried out by heating at reflux for 10 hours to obtain a solution containing polymer 1. The polymer solution does not cause cloudiness or the like even when cooled to room temperature, and has good solubility in propylene glycol monomethyl ether. As a result of GPC analysis, the polymer in the obtained solution had a weight average molecular weight of 10,000 in terms of standard polystyrene. The polymer obtained in the present Synthesis Example has structural units represented by following formulas (1a) and (1b) shown below.

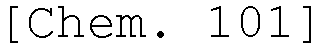

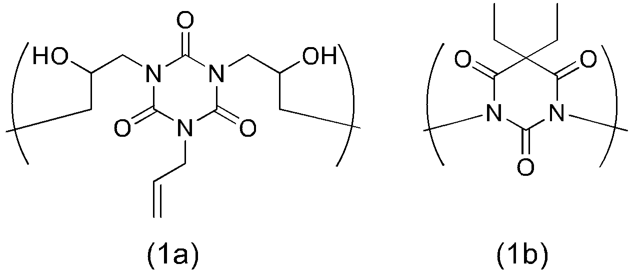

### <Synthesis Example 2>

To 51.70 g of propylene glycol monomethyl ether in a reaction vessel, 7.00 g of Denacol Ex711 (manufactured by Nagase ChemteX Corporation), 5.61 g of pyromellitic dianhydride (manufactured by Tokyo Chemical Industry Co., Ltd.) and 0.31 g of tetrabutylphosphonium bromide (manufactured by HOKKO CHEMICAL INDUSTRY CO., LTD.) were added and dissolved. After the reaction vessel was purged with nitrogen, the reaction was carried out by heating at 100°C for 24 hours to obtain a solution containing polymer 2. The polymer solution does not cause cloudiness or the like even when cooled to room temperature, and has good solubility in propylene glycol monomethyl ether. As a result of GPC analysis, the polymer in the obtained solution had a weight average molecular weight of 12,000 in terms of standard polystyrene. The polymer obtained in the present synthesis example has structural units represented by the following formulas (1c) and (1d).

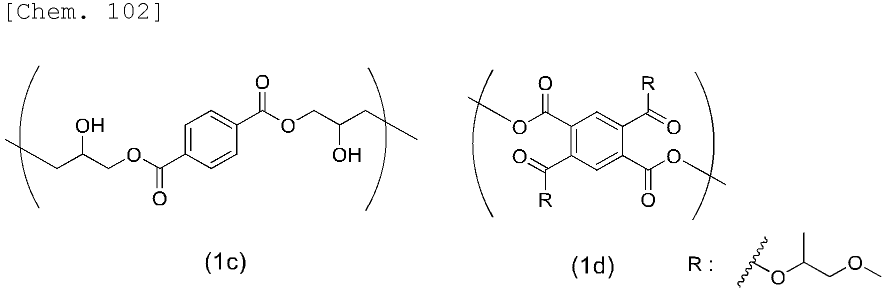

### <Synthesis Example 3>

To 32.81 g of propylene glycol monomethyl ether in a reaction vessel, 7.00 g of Denacol Ex201 (manufactured by Nagase ChemteX Corporation), 6.86 g of pyromellitic dianhydride (manufactured by Tokyo Chemical Industry Co., Ltd.) and 0.20 g of tetrabutylphosphonium bromide (manufactured by Tokyo Chemical Industry Co., Ltd.) were added and dissolved. After the reaction vessel was purged with nitrogen, the reaction was carried out by heating at 130°C for 24 hours to obtain a solution containing polymer 3. The polymer solution does not cause cloudiness or the like even when cooled to room temperature, and has good solubility in propylene glycol monomethyl ether. As a result of GPC analysis, the polymer in the obtained solution had a weight average molecular weight of 19,000 in terms of standard polystyrene. The polymer obtained in the present synthesis example has structural units represented by the following formulas (1e) and (1d).

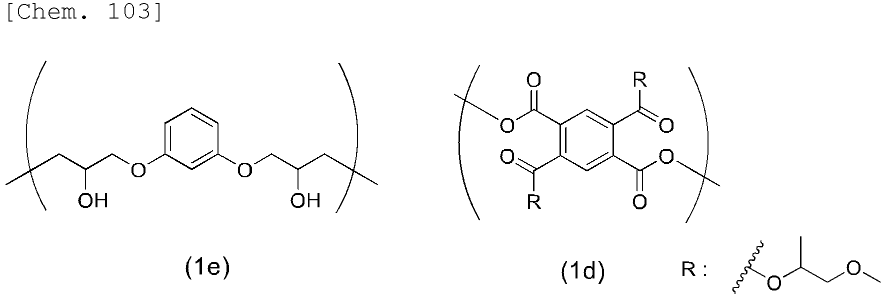

### <Synthesis Example 4>

To 49.11 g of propylene glycol monomethyl ether in a reaction vessel, 7.00 g of Denacol Ex711 (manufactured by Nagase ChemteX Corporation), 4.97 g of 1,2,3,4-cyclobutanetetracarboxylic dianhydride (manufactured by Tokyo Chemical Industry Co., Ltd.) and 0.31 g of tetrabutylphosphonium bromide (manufactured by HOKKO CHEMICAL INDUSTRY CO., LTD.) were added and dissolved. After the reaction vessel was purged with nitrogen, the reaction was carried out by heating at 100°C for 24 hours to obtain a solution containing polymer 4. The polymer solution does not cause cloudiness or the like even when cooled to room temperature, and has good solubility in propylene glycol monomethyl ether. As a result of GPC analysis, the polymer in the obtained solution had a weight average molecular weight of 16,000 in terms of standard polystyrene. The polymer obtained in the present synthesis example has structural units represented by the following formulas (1c) and (1f).

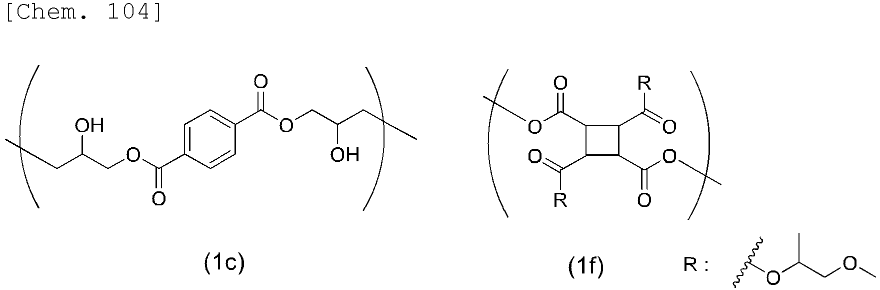

### <Synthesis Example 5>

To 55.71 g of propylene glycol monomethyl ether in a reaction vessel, 7.00 g of Denacol Ex201 (manufactured by Nagase ChemteX Corporation), 6.17 g of 1,2,3,4-cyclobutanetetracarboxylic dianhydride (manufactured by Tokyo Chemical Industry Co., Ltd.) and 0.76 g of tetrabutylphosphonium bromide (manufactured by Tokyo Chemical Industry Co., Ltd.) were added and dissolved. After the reaction vessel was purged with nitrogen, the reaction was carried out by heating at 100°C for 24 hours to obtain a solution containing polymer 5. The polymer solution does not cause cloudiness or the like even when cooled to room temperature, and has good solubility in propylene glycol monomethyl ether. As a result of GPC analysis, the polymer in the obtained solution had a weight average molecular weight of 31,000 in terms of standard polystyrene. The polymer obtained in the present synthesis example has structural units represented by the following formulas (1e) and (1f).

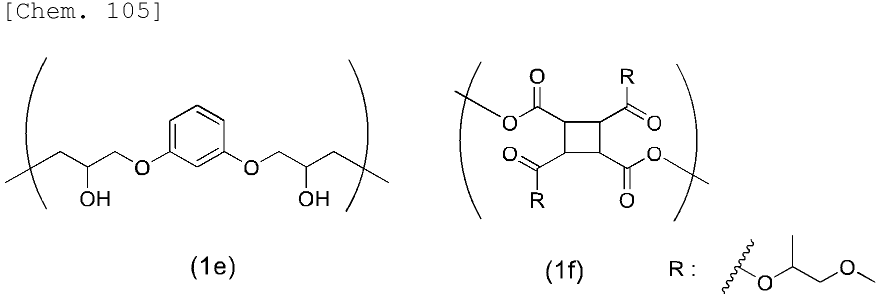

### <Synthesis Example 6>

To 16.77 g of propylene glycol monomethyl ether and 2.58 g of propylene glycol monomethyl ether acetate in a reaction vessel, 20.00 g of polyglycidyl methacrylate (manufactured by Maruzen Petrochemical Co., Ltd.), 4.88 g of sorbic acid (manufactured by Tokyo Chemical Industry Co., Ltd.), 0.46 g of tetrabutylphosphonium bromide (manufactured by Tokyo Chemical Industry Co., Ltd.) and 0.02 g of hydroquinone (manufactured by Tokyo Chemical Industry Co., Ltd.) were added and dissolved. After the reaction vessel was purged with nitrogen, the reaction was carried out by heating at 100°C for 24 hours to obtain a solution containing polymer 6. The polymer solution does not become cloudy even when cooled to room temperature, and has good solubility in a mixed solvent of propylene glycol monomethyl ether/propylene glycol monomethyl ether acetate. As a result of GPC analysis, the polymer in the obtained solution had a weight average molecular weight of 25,000 in terms of standard polystyrene. The polymer prepared in this Synthesis Example has a structural unit represented by the following formula (1g):

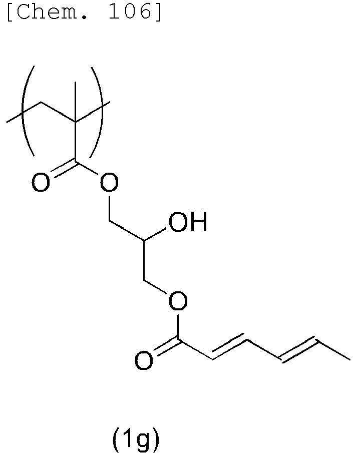

### <Synthesis Example 7>

To 15.07 g of propylene glycol monomethyl ether and 0.88 g of propylene glycol monomethyl ether acetate in a reaction vessel, 20.00 g of polyglycidyl methacrylate (manufactured by Maruzen Petrochemical Co., Ltd.), 3.75 g of methacrylic acid (manufactured by Tokyo Chemical Industry Co., Ltd.), 0.46 g of tetrabutylphosphonium bromide (manufactured by Tokyo Chemical Industry Co., Ltd.) and 0.02 g of hydroquinone (manufactured by Tokyo Chemical Industry Co., Ltd.) were added and dissolved. After the reaction vessel was purged with nitrogen, the reaction was carried out by heating at 100°C for 24 hours to obtain a solution containing polymer 7. The polymer solution does not become cloudy even when cooled to room temperature, and has good solubility in a mixed solvent of propylene glycol monomethyl ether/propylene glycol monomethyl ether acetate. As a result of GPC analysis, the polymer in the obtained solution had a weight average molecular weight of 21,000 in terms of standard polystyrene. The polymer prepared in this Synthesis Example has a structural unit represented by the following formula (1h):

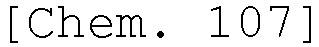

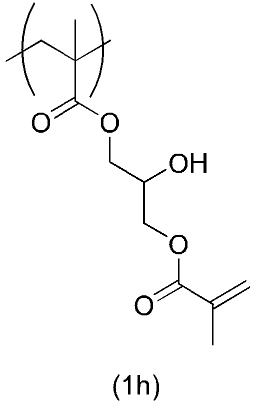

### <Synthesis Example 8>

To 14.36 g of propylene glycol monomethyl ether and 0.17 g of propylene glycol monomethyl ether acetate in a reaction vessel, 20.00 g of polyglycidyl methacrylate (manufactured by Maruzen Petrochemical Co., Ltd.), 3.28 g of acrylic acid (manufactured by Tokyo Chemical Industry Co., Ltd.), 0.46 g of tetrabutylphosphonium bromide (manufactured by Tokyo Chemical Industry Co., Ltd.) and 0.02 g of hydroquinone (manufactured by Tokyo Chemical Industry Co., Ltd.) were added and dissolved. After the reaction vessel was purged with nitrogen, the reaction was carried out by heating at 100°C for 24 hours to obtain a solution containing polymer 8. The polymer solution does not become cloudy even when cooled to room temperature, and has good solubility in a mixed solvent of propylene glycol monomethyl ether/propylene glycol monomethyl ether acetate. As a result of GPC analysis, the polymer in the obtained solution had a weight average molecular weight of 21,000 in terms of standard polystyrene. The polymer prepared in this Synthesis Example has a structural unit represented by the following formula (1i):

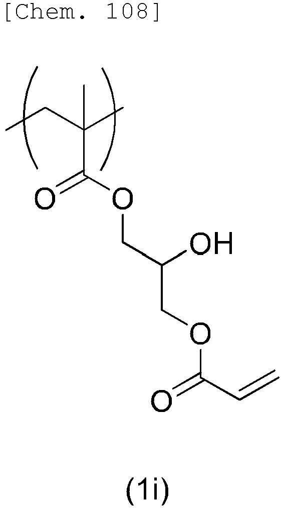

### <Synthesis Example 9>

To 14.93 g of propylene glycol monomethyl ether and 0.74 g of propylene glycol monomethyl ether acetate in a reaction vessel, 20.00 g of polyglycidyl methacrylate (manufactured by Maruzen Petrochemical Co., Ltd.), 3.66 g of tetrolic acid (manufactured by Tokyo Chemical Industry Co., Ltd.), 0.46 g of tetrabutylphosphonium bromide (manufactured by Tokyo Chemical Industry Co., Ltd.) and 0.02 g of hydroquinone (manufactured by Tokyo Chemical Industry Co., Ltd.) were added and dissolved. After the reaction vessel was purged with nitrogen, the reaction was carried out by heating at 100°C for 24 hours to obtain a solution containing polymer 9. The polymer solution does not become cloudy even when cooled to room temperature, and has good solubility in a mixed solvent of propylene glycol monomethyl ether/propylene glycol monomethyl ether acetate. As a result of GPC analysis, the polymer in the obtained solution had a weight average molecular weight of 21,000 in terms of standard polystyrene. The polymer prepared in this Synthesis Example has a structural unit represented by the following formula (1j):

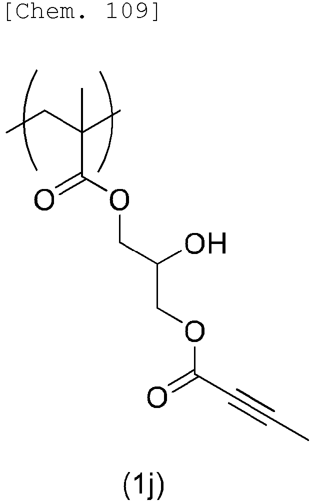

### [Preparation of resist underlayer film-forming composition]

### (Examples and Comparative Examples)

The polymers obtained in the above Synthesis Examples 1 to 9, a crosslinking agent, a curing catalyst and a solvent were mixed in the proportions shown in Table 1, and the mixture was filtered through a fluororesin filter having a pore size of 0.1 µm, thereby preparing the resist underlayer film-forming compositions of Examples 1 to 7 and Comparative Examples 1 to 3, respectively.

Abbreviations in Table 1 are as follows.
PL-LI: tetramethoxymethylglycoluril
PGME-PL: Imidazo[4,5-d]imidazole-2,5(1H,3H)-dione, tetrahydro-1,3,4,6-tetrakis[(2-methoxy-1-methylethoxy)methyl]-(the following structural formula) 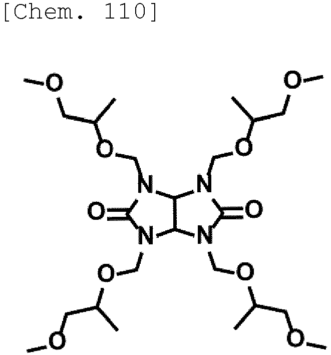
Py-PSA: pyridinium p-hydroxybenzenesulfonic acid
PGMEA: propylene glycol monomethyl ether acetate
PGME: propylene glycol monomethyl ether

**[Table 1]**

| | First component | Second component | Crosslinking agent | Curing catalyst | Solvent | |
|---|---|---|---|---|---|---|
| Example 1 | Polymer 2 | Polymer 6 | PGME-PL | Py-PSA | PGME | PGMEA |
| (parts by mass) | 0.077 | 0.077 | 0.042 | 0.004 | 90 | 10 |
| Example 2 | Polymer 2 | Polymer 7 | PGME-PL | Py-PSA | PGME | PGMEA |
| (parts by mass) | 0.077 | 0.077 | 0.042 | 0.004 | 90 | 10 |
| Example 3 | Polymer 2 | Polymer 9 | PGME-PL | Py-PSA | PGME | PGMEA |
| (parts by mass) | 0.077 | 0.077 | 0.042 | 0.004 | 90 | 10 |
| Example 4 | Polymer 3 | Polymer 6 | PGME-PL | Py-PSA | PGME | PGMEA |
| (parts by mass) | 0.077 | 0.077 | 0.042 | 0.004 | 90 | 10 |
| Example 5 | Polymer 3 | Polymer 7 | PGME-PL | Py-PSA | PGME | PGMEA |
| (parts by mass) | 0.077 | 0.077 | 0.042 | 0.004 | 90 | 10 |
| Example 6 | Polymer 3 | Polymer 8 | PGME-PL | Py-PSA | PGME | PGMEA |
| (parts by mass) | 0.077 | 0.077 | 0.042 | 0.004 | 90 | 10 |
| Example 7 | Polymer 3 | Polymer 9 | PGME-PL | Py-PSA | PGME | PGMEA |
| (parts by mass) | 0.077 | 0.077 | 0.042 | 0.004 | 90 | 10 |
| Comparative Example 1 | Polymer 1 | - | PL-LI | Py-PSA | PGME | PGMEA |
| (parts by mass) | 0.149 | - | 0.037 | 0.004 | 70 | 30 |
| Comparative Example 2 | Polymer 2 | - | PGME-PL | Py-PSA | PGME | PGMEA |
| (parts by mass) | 0.154 | - | 0.042 | 0.004 | 90 | 10 |
| Comparative Example 3 | Polymer 3 | - | PGME-PL | Py-PSA | PGME | PGMEA |
| (parts by mass) | 0.154 | - | 0.042 | 0.004 | 90 | 10 |

### [Elution Test of Photoresist Solvent]

The resist underlayer film-forming compositions of Examples 1 to 7 and Comparative Examples 1 to 3 were each applied onto a silicon wafer, which is a semiconductor substrate, by a spinner. The silicon wafer was placed on a hot plate and baked at 205°C for 1 minute to form a resist underlayer film (film thickness: 5 nm). These resist underlayer films were immersed in a mixed solution of propylene glycol monomethyl ether/propylene glycol monomethyl ether acetate = 70/30 (volume ratio), which is a solvent used for the photoresist, and a case where the film thickness change was less than 5 Å was evaluated as "good", and a case where the film thickness change was 5 Å or more was evaluated as "poor", and the results are shown in Table 2.

**[Table 2]**

| | Elution test |
|---|---|
| Example 1 | Good |
| Example 2 | Good |
| Example 3 | Good |
| Example 4 | Good |
| Example 5 | Good |
| Example 6 | Good |
| Example 7 | Good |
| Comparative Example 1 | Good |
| Comparative Example 2 | Good |
| Comparative Example 3 | Good |

### [Test of resist pattern formation by electron beam lithography system]

Each of the resist underlayer film-forming compositions of Examples 1 to 7 and Comparative Examples 1 to 3 was applied onto a silicon wafer using a spinner. The silicon wafer was baked on a hot plate at 205°C for 60 seconds to obtain a resist underlayer film having a film thickness of 5 nm. A positive resist solution for EUV was applied onto the resist underlayer film by spin coating, followed by heating to 130°C for 60 seconds to form an EUV resist film. The resist film was irradiated with EB under predetermined conditions using an electron beam lithography system (ELS-G130). After irradiation, bake (PEB) was performed at 90°C for 60 seconds and cooled to room temperature on a cooling plate, and paddle development was performed for 30 seconds using a 2.38% aqueous tetramethylammonium hydroxide solution (trade name NMD-3 manufactured by TOKYO OHKA KOGYO CO., LTD.) as a photoresist developer. A resist pattern having a line size of 16 nm to 28 nm was formed. A scanning electron microscope (CG4100 manufactured by Hitachi High-Technologies Corporation) was used to measure the length of the resist pattern.

With respect to the photoresist pattern thus obtained, whether or not a 22 nm line-and-space (L/S) could be formed was evaluated.

22nmL/S pattern formation was confirmed. In addition, the amount of charge with which the 22 nm line/44 nm pitch (line-and-space (L/S = 1/1) was formed is defined as the optimal irradiation energy, and the irradiation energy (µC/cm²) at that time is shown in Table 3.

As for the minimum CD size, the limit CD size at which no pattern collapse occurred is shown in Table 3. In Examples 1 to 7, an improvement in the minimum CD size was confirmed as compared with Comparative Examples 1 to 3.

**[Table 3]**

| | Irradiation energy (uC/cm²) | Minimum CD size (nm) |
|---|---|---|
| Example 1 | 454 | 17.4 |
| Example 2 | 460 | 17.6 |
| Example 3 | 495 | 17.3 |
| Example 4 | 481 | 17.9 |
| Example 5 | 482 | 17.7 |
| Example 6 | 489 | 17.4 |
| Example 7 | 488 | 17.5 |
| Comparative Example 1 | 491 | 19.4 |
| Comparative Example 2 | 463 | 18.5 |
| Comparative Example 3 | 484 | 18.4 |

## Claims

1. A resist underlayer film-forming composition, comprising: a polymer (A) having a partial structure represented by the following formula (A); a polymer (B) having a polymerizable multiple bond; and a solvent (C): 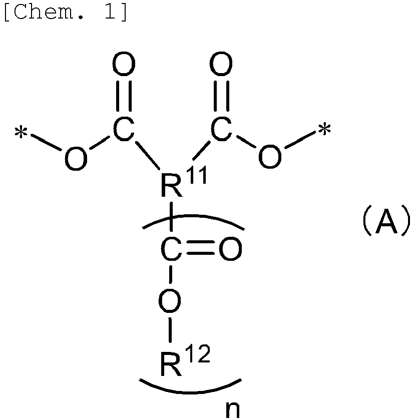 wherein in formula (A), R¹¹ represents an (n+2)-valent group having at least one of an aromatic hydrocarbon ring and an aliphatic hydrocarbon ring, R¹² represents a hydrogen atom, or an alkyl group having 1 to 13 carbon atoms which may be substituted with at least one group selected from the group consisting of an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms, and an alkoxysulfonyl group having 1 to 13 carbon atoms, n represents 1 or 2, when n is 2, the two R¹² may be the same or different, and * represents a bonding site.

2. The resist underlayer film-forming composition according to claim 1, wherein the polymer (B) is a polymer (B-1) having a structural unit represented by the following formula (B-1) or a polymer (B-2) having a structural unit represented by the following formula (B-2): 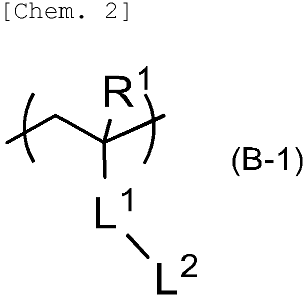
wherein in formula (B-1), R¹ represents a hydrogen atom or an alkyl group having 1 to 10 carbon atoms, L¹ represents a single bond or a linking group, and L² represents a monovalent group having the polymerizable multiple bond, 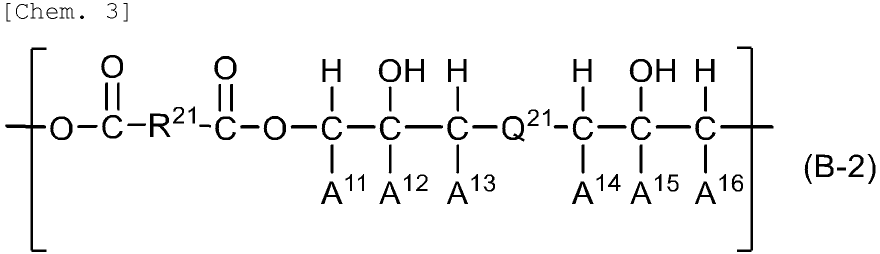
wherein in formula (B-2), A¹¹, A¹², A¹³, A¹⁴, A¹⁵ and A¹⁶ each independently represent a hydrogen atom, a methyl group or an ethyl group, Q²¹ is a divalent organic group, and R²¹ represents a divalent group having the polymerizable multiple bond.

3. The resist underlayer film-forming composition according to claim 2, wherein L¹-L² in the structural unit represented by the formula (B-1) has a structure represented by the following formula (1a), (1b) or (1c): 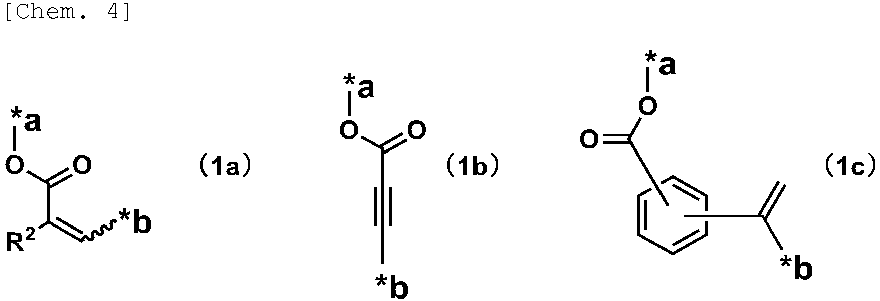 wherein in formulas (1a) to (1c), R² represents a hydrogen atom or an alkyl group having 1 to 10 carbon atoms, *a and *b represent a bonding site, *a is a main chain side of the polymer (B-1), and *b is a terminal side of a side chain of the polymer (B-1).

4. The resist underlayer film-forming composition according to claim 1, wherein the polymer (A) has a structural unit represented by the following formula (A-11): 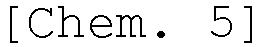 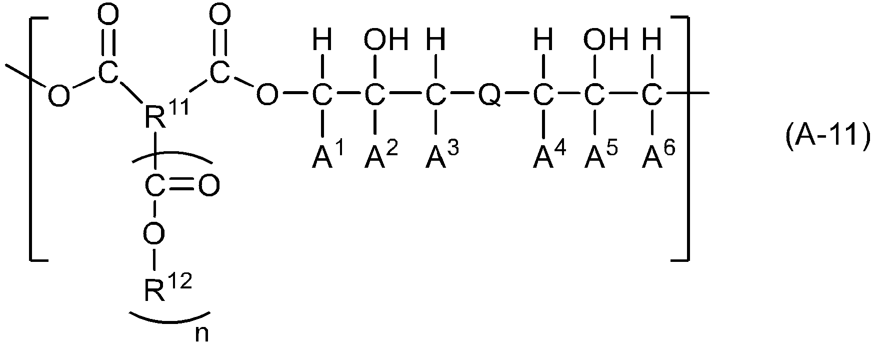 wherein in formula (A-11), A¹, A², A³, A⁴, A⁵, and A⁶ each independently represent a hydrogen atom, a methyl group or an ethyl group, Q represents a divalent organic group, R¹¹ represents an (n+2)-valent organic group having at least one of an aromatic hydrocarbon ring and an aliphatic hydrocarbon ring, R¹² represents a hydrogen atom, or an alkyl group having 1 to 13 carbon atoms which may be substituted with at least one group selected from the group consisting of an alkoxy group having 1 to 13 carbon atoms, an alkylcarbonyloxy group having 2 to 13 carbon atoms, an alkoxycarbonyl group having 2 to 13 carbon atoms, an alkylthio group having 1 to 13 carbon atoms, a nitro group, an alkylsulfonyloxy group having 1 to 13 carbon atoms and an alkoxysulfonyl group having 1 to 13 carbon atoms, n represents 1 or 2, and when n is 2, the two R¹² may be the same or different.

5. The resist underlayer film-forming composition according to claim 4, wherein Q in the formula (A-11) is represented by any one of the following formulas (A-21) and (A-22): 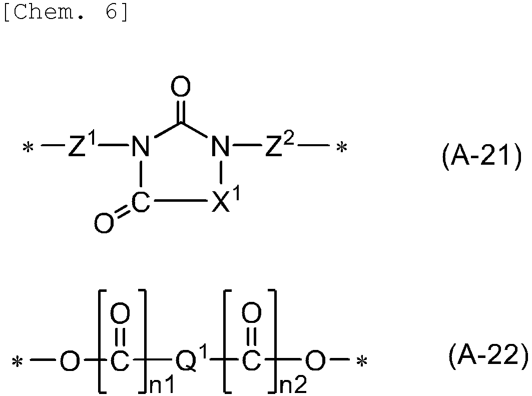
wherein in formula (A-21), X¹ represents a divalent group represented by the following formula (A-21-1), the following formula (A-21-2) or the following formula (A-21-3), Z¹ and Z² each independently represent a single bond or a divalent group represented by the following formula (A-21-4), and * represents a bonding site;
wherein in formula (A-22), Q¹ represents a divalent group having an aromatic hydrocarbon ring or an aliphatic hydrocarbon ring, n1 and n2 each independently represent 0 or 1, and * represents a bonding site, 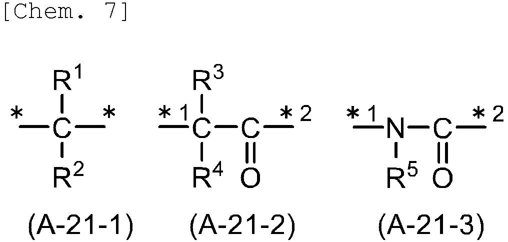
wherein in formulas (A-21-1) to (A-21-3), R¹ to R⁵ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group and an alkylthio group having 1 to 6 carbon atoms, R¹ and R² may be bonded to each other to form a ring having 3 to 6 carbon atoms, R³ and R⁴ may be bonded to each other to form a ring having 3 to 6 carbon atoms, * represents a bonding site, *1 represents a bonding site bonded to a carbon atom, and *2 represents a bonding site bonded to a nitrogen atom, 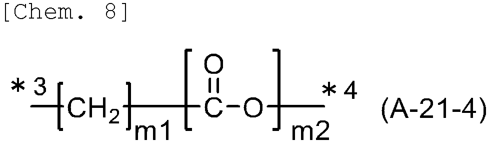
wherein in formula (A-21-4), m1 is an integer of 1 to 4, m2 is 0 or 1, *3 represents a bonding site bonded to a nitrogen atom, and *4 represents a bonding site bonded to a carbon atom.

6. The resist underlayer film-forming composition according to claim 5, wherein Q¹ in the formula (A-22) is represented by any one of the following formulas (A-22-1) to (A-22-4): 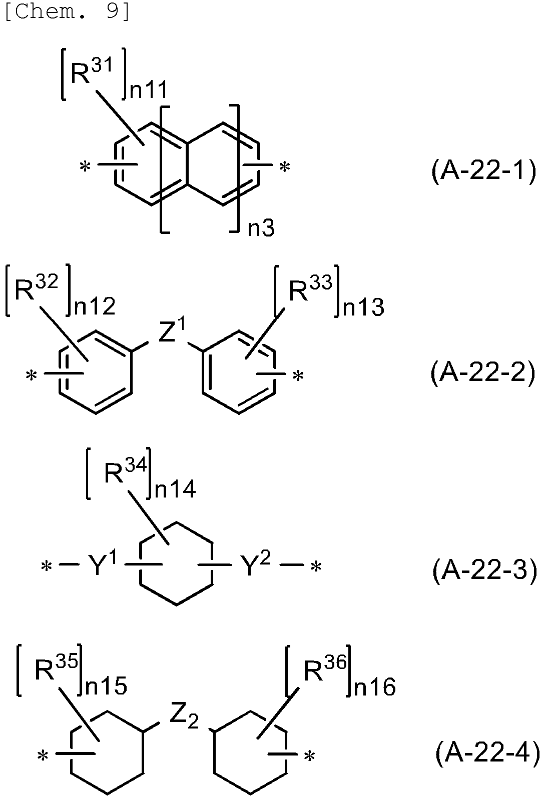
wherein in formulas (A-22-1) to (A-22-4), R³¹ to R³⁶ each independently represent a halogen atom, a hydroxy group, an alkyl group having 1 to 6 carbon atoms, an alkenyl group having 2 to 6 carbon atoms, an alkynyl group having 2 to 6 carbon atoms, an alkoxy group having 1 to 6 carbon atoms, an alkenyloxy group having 2 to 6 carbon atoms, an alkynyloxy group having 2 to 6 carbon atoms, an acyl group having 2 to 6 carbon atoms, an aryloxy group having 6 to 12 carbon atoms, an arylcarbonyl group having 7 to 13 carbon atoms or an aralkyl group having 7 to 13 carbon atoms, and * represents a bonding site,
wherein in formula (A-22-1), n3 represents 0 or 1, when n3 is 0, n11 represents an integer of 0 to 4, when n3 is 1, n11 represents an integer of 0 to 6, and when R³¹ is 2 or more, the two or more R³¹ may be the same or different,
wherein in formula (A-22-2), Z¹ represents a single bond, an oxygen atom, a sulfur atom, a carbonyl group, a sulfonyl group or an alkylene group having 1 to 6 carbon atoms, n12 and n13 each independently represent an integer of 0 to 4, when R³² is 2 or more, the two or more R³² may be the same or different, and when R³³ is 2 or more, the two or more R³³ may be the same or different,
wherein in formula (A-22-3), Y¹ and Y² each independently represent a single bond or an alkylene group having 1 to 6 carbon atoms, n14 represents an integer of 0 to 4, and when R³⁴ is 2 or more, the two or more R³⁴ may be the same or different, and
wherein in formula (A-22-4), Z² represents a single bond, an oxygen atom, a sulfur atom, a carbonyl group, a sulfonyl group or an alkylene group having 1 to 6 carbon atoms, n15 and n16 each independently represent an integer of 0 to 4, when R³⁵ is 2 or more, the two or more R³⁵ may be the same or different, and when R³⁶ is 2 or more, the two or more R³⁶ may be the same or different.

7. The resist underlayer film-forming composition according to claim 1, wherein a mass ratio between the polymer (A) and the polymer (B) (polymer (A) : polymer (B)) is 20 : 80 to 80 : 20.

8. The resist underlayer film-forming composition according to claim 1, wherein the solvent (C) contains at least one kind selected from a group consisting of an alkylene glycol monoalkyl ether and a monocarboxylic acid ester of an alkylene glycol monoalkyl ether.

9. The resist underlayer film-forming composition according to claim 1, further comprising a crosslinking agent (D).

10. The resist underlayer film-forming composition according to claim 9, wherein the crosslinking agent (D) is at least one kind selected from a group consisting of an aminoplast crosslinking agent and a phenoplast crosslinking agent.

11. The resist underlayer film-forming composition according to claim 1, further comprising a curing catalyst (E).

12. The resist underlayer film-forming composition according to claim 1, which is used in EUV lithography.

13. The resist underlayer film-forming composition according to claim 1, wherein the composition is used for forming an underlayer film of a metal-containing resist.

14. A resist underlayer film, which is a cured product of the resist underlayer film-forming composition according to any one of claims 1 to 13.

15. A laminate comprising:
a semiconductor substrate; and
the resist underlayer film according to claim 14.

16. A method for producing a semiconductor element, comprising:
a step of forming a resist underlayer film on a semiconductor substrate using the resist underlayer film-forming composition according to any one of claims 1 to 13; and
a step of forming a resist film on the resist underlayer film.

17. A pattern forming method comprising:
a step of forming a resist underlayer film on a semiconductor substrate using the resist underlayer film-forming composition according to any one of claims 1 to 13;
a step of forming a resist film on the resist underlayer film;
a step of irradiating the resist film with light or an electron beam, and then developing the resist film to obtain a resist pattern; and
a step of etching the resist underlayer film using the resist pattern as a mask.
